# EUROPEAN PATENT SPECIFICATION

(11) **EP 3 489 249 B1**
(45) Date of publication and mention of the grant of the patent: **09.06.2021**
(21) Application number: 18205634.1
(22) Date of filing: 12.11.2018
(51) Int. Cl.: C07F 15/00, C09K 11/06, H01L 51/00

(54) **ORGANOMETALLIC COMPOUND AND ORGANIC LIGHT-EMITTING DEVICE INCLUDING THE SAME**
ORGANOMETALLISCHE VERBINDUNG UND ORGANISCHE LICHTEMITTIERENDE VORRICHTUNG DAMIT
COMPOSÉ ORGANOMÉTALLIQUE ET DISPOSITIF ÉLECTROLUMINESCENT ORGANIQUE L'INCLUANT

(30) Priority: 23.11.2017 KR 20170157499; 06.11.2018 KR 20180135417
(43) Date of publication of application: 29.05.2019
(73) Proprietor: Samsung Electronics Co., Ltd., Gyeonggi-do 16677 (KR); Samsung SDI Co., Ltd., Gyeonggi-do (KR)
(72) Inventor: KWON, Eunsuk, 16678 Gyeonggi-do (KR); KIM, Wook, 16678 Gyeonggi-do (KR); MIN, Minsik, 16678 Gyeonggi-do (KR); PARK, Sangho, 16678 Gyeonggi-do (KR); BAE, Hyejin, 16678 Gyeonggi-do (KR); SON, Jhunmo, 16678 Gyeonggi-do (KR); LEE, Hasup, 16678 Gyeonggi-do (KR); JUNG, Yongsik, 16678 Gyeonggi-do (KR)
(74) Representative: Elkington and Fife LLP

(56) References cited:
- US-A1- 2014 158 992
- GUSEV ALEXEY N ET AL: "Structural and photophysical studies on ternary Sm(III), Nd(III), Yb(III), Er(III) complexes containing pyridyltriazole ligands", POLYHEDRON, vol. 47, no. 1, 2012, pages 37-45, XP028951963, ISSN: 0277-5387, DOI: 10.1016/J.POLY.2012.08.034
- ALEXEY N GUSEV ET AL: "New Zn complexes based on 1,2,4-triazoles: Synthesis, structure and luminescence", INORGANICA CHIMICA ACTA, ELSEVIER BV, NL, vol. 376, no. 1, 11 July 2011 (2011-07-11) , pages 509-514, XP028292937, ISSN: 0020-1693, DOI: 10.1016/J.ICA.2011.07.009 [retrieved on 2011-07-23]
- ABRAMOV PAVEL A ET AL: "Emission tuning in Re(I) complexes: Expanding heterocyclic ligands and/or introduction of perfluorinated ligands", POLYHEDRON, vol. 137, 5 September 2017 (2017-09-05), pages 231-237, XP085208753, ISSN: 0277-5387, DOI: 10.1016/J.POLY.2017.08.046
- GUSEV A N ET AL: "Adducts of lanthanide acetylacetonates with 5-phenyl-2-(2-pyridyl)-7,8-benzo-6,5-dihyd ro-1,3,6-triazaindolizine: structure and photoluminescence", RUSSIAN CHEMICAL BULLETIN, SPRINGER NEW YORK LLC, US, vol. 63, no. 7, 7 March 2015 (2015-03-07), pages 1493-1497, XP035464630, ISSN: 1066-5285, DOI: 10.1007/S11172-014-0625-4 [retrieved on 2015-03-07]
- ALEXEY N GUSEV ET AL: "Structural and photophysical studies of europium complexes containing triazole ligands", INORGANICA CHIMICA ACTA, ELSEVIER BV, NL, vol. 387, 10 February 2012 (2012-02-10), pages 321-326, XP028418069, ISSN: 0020-1693, DOI: 10.1016/J.ICA.2012.02.016 [retrieved on 2012-02-23]
- DATABASE WPI Week 200934 Thomson Scientific, London, GB; AN 2009-J24211 XP002789059, & JP 2009 102533 A (KONICA MINOLTA HOLDINGS INC) 14 May 2009 (2009-05-14)
- RICCARDO F. CARINA ET AL: "Molecular Tricorns: Self-Assembly of Trinuclear Palladium(II) Complexes", INORGANIC CHEMISTRY, vol. 40, no. 8, 1 April 2001 (2001-04-01), pages 1826-1832, XP55754803, Easton , US ISSN: 0020-1669, DOI: 10.1021/ic0009526
- SHIN-YA TAKIZAWA ET AL: "Phosphorescent Iridium Complexes Based on 2-Phenylimidazo[1,2- a ]pyridine Ligands: Tuning of Emission Color toward the Blue Region and Application to Polymer Light-Emitting Devices", INORGANIC CHEMISTRY, vol. 46, no. 10, 1 May 2007 (2007-05-01), pages 4308-4319, XP55754825, Easton , US ISSN: 0020-1669, DOI: 10.1021/ic0624322

## Description

### FIELD OF THE INVENTION

One or more embodiments relate to an organometallic compound and an organic light-emitting device including the same.

### BACKGROUND OF THE INVENTION

Organic light-emitting devices are self-emission devices that produce full-color images, and also have wide viewing angles, high contrast ratios, short response times, and excellent characteristics in terms of brightness, driving voltage, and response speed, compared to devices in the art.

In an example, an organic light-emitting device includes an anode, a cathode, and an organic layer between the anode and the cathode, wherein the organic layer includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light Inorganic chemistry 2007,46,4308-4319 discloses light emitting compounds which differ in that there is a carbon instead of a nitrogen meta to the coordinating nitrogen.

### SUMMARY OF THE INVENTION

Aspects of the present disclosure provide a novel organometallic compound and an organic light-emitting device including the same.

Additional aspects will be set forth in part in the description which follows and, in part, will be apparent from the description, or may be learned by practice of the presented embodiments.

An aspect provides an organometallic compound represented by Formula 1:

<Formula 1> M₁₁(L₁₁)ₙ₁₁(L₁₂)ₙ₁₂.

In Formula 1,
M₁₁ may be a transition metal,
L₁₁ may be selected from a group represented by Formula 1A,
n11 may be selected from 1, 2, 3, and 4, wherein, when n11 is 2 or more, 2 or more L₁₁(s) are the same or different from each other,
L₁₂ may be selected from a one-coordinate ligand, a two-coordinate ligand, and a three-coordinate ligand,
n12 may be selected from 0, 1, 2, 3, and 4, wherein, when n12 is 2 or more, 2 or more L₁₂(s) are the same or different from each other,
L₁₁ and L₁₂ may be different from each other,

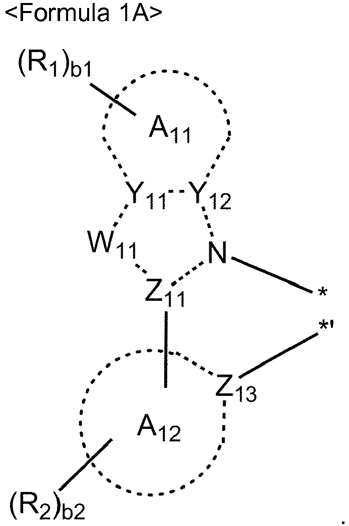

In Formula 1A,
A₁₁ may be a C₁-C₃₀ heterocyclic group,
A₁₂ may be a C₅-C₃₀ carbocyclic group or a C₁-C₃₀ heterocyclic group,
W₁₁ may be selected from N and N(R₁₁),
Y₁₁ and Y₁₂ may each independently be selected from N and C, wherein at least one selected from Y₁₁ and Y₁₂ is N,
Z₁₁ and Z₁₃ may be each C,
R₁, R₂, and R₁₁ may each independently be selected from hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and - P(=O)(Q₈)(Q₉),
two or more selected from R₁, R₂, and R₁₁ may optionally be linked to each other to form a ring,
two, three, or four selected from a plurality of neighboring R₁, R₂, and R₁₁ may optionally be linked to form a four-coordinate ligand, a six-coordinate ligand, or an eight-coordinate ligand,
Q₁ to Q₉ may each independently be selected from hydrogen, deuterium, -F, - CI, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₁-C₆₀ alkyl group substituted with at least one selected from deuterium, a C₁-C₆₀ alkyl group, and a C₆-C₆₀ aryl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from deuterium, a C₁-C₆₀ alkyl group, and a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, and
the following compound may be excluded from the organometallic compound represented by Formula 1:

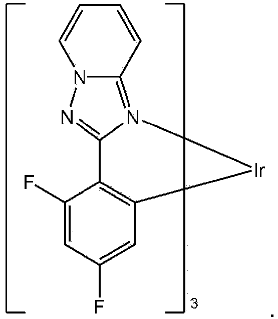

Another aspect provides an organic light-emitting device including: a first electrode; a second electrode; an organic layer between the first electrode and the second electrode and including an emission layer,
wherein the organic layer includes the organometallic compound described above.

The organometallic compound may act as a dopant in the emission layer.

### BRIEF DESCRIPTION OF THE DRAWINGS

These and/or other aspects will become apparent and more readily appreciated from the following description of the embodiments, taken in conjunction with the accompanying drawings in which:
FIG. 1 is a schematic view of an organic light-emitting device according to an embodiment; and
FIG. 2 is a graph showing a photoluminescence spectrum of Compound 5.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

An organometallic compound according to an embodiment is represented by Formula 1:

<Formula 1> M₁₁(L₁₁)ₙ₁₁(L₁₂)ₙ₁₂.

In Formula 1, M₁₁ may be a transition metal.

For example, in Formula 1, M₁₁ may be selected from platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), and thulium (Tm), but embodiments of the present disclosure are not limited thereto.

In one embodiment, in Formula 1, M₁₁ may be selected from Ir, Os, and Pt, but embodiments of the present disclosure are not limited thereto.

In one embodiment, in Formula 1, M₁₁ may be Ir, but embodiments of the present disclosure are not limited thereto.

In Formula 1, L₁₁ may be selected from a group represented by Formula 1A:

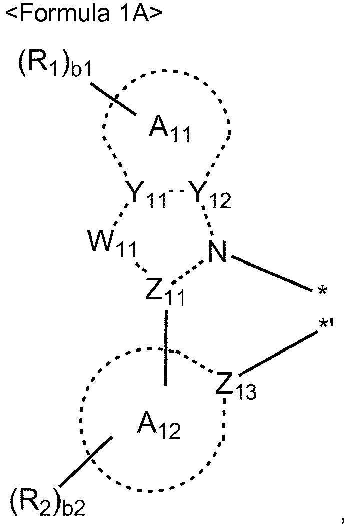

The description of Formula 1A may be the same as described herein.

In Formula 1A, A₁₁ may be C₁-C₃₀ heterocyclic group, A₁₂ may be C₅-C₃₀ carbocyclic group or C₁-C₃₀ heterocyclic group.

For example, in Formula 1A, A₁₁ may be selected from a pyridine group, a pyrimidine group, a pyrazine group, a pyridazine group, a triazine group,, a quinoline group, an isoquinoline group, a benzoquinoline group, a benzoisoquinoline group, a phthalazine group, a naphthyridine group, a quinoxaline group, a benzoquinoxaline group, a quinazoline group and a benzoquinazoline group.

For example, in Formula 1A, A₁₂ may be selected from a benzene group, a naphthalene group, a fluorene group, a carbazole group, a dibenzofuran group, a dibenzothiophene group, a pyridine group, a pyrimidine group, a pyrazine group, a pyridazine group, a triazine group,, a quinoline group, an isoquinoline group, a benzoquinoline group, a benzoisoquinoline group, a phthalazine group, a naphthyridine group, a quinoxaline group, a benzoquinoxaline group, a quinazoline group and a benzoquinazoline group.

In Formula 1A, a bond between Z₁₁ and N, a bond between Z₁₁ and W₁₁, a bond between W₁₁ and Y₁₁, a bond between Y₁₁ and Y₁₂, and a bond between N and Y₁₂ may each independently be a single bond or a double bond.

In Formula 1A, W₁₁ may be selected from N and N(R₁₁),and R₁₁ may be the same as described herein.

For example, in Formula 1A, W₁₁ may be N, but embodiments of the present disclosure are not limited thereto.

In this case, in Formula 1A, a bond between Z₁₁ and W₁₁ may be a double bond; or a bond between Y₁₁ and W₁₁ may be a double bond, but embodiments of the present disclosure are not limited thereto.

In Formula 1A, Y₁₁ and Y₁₂ may each independently be selected from N and C, wherein at least one selected from Y₁₁ and Y₁₂ may be N.

For example, in Formula 1A, Y₁₁ may be N, and Y₁₂ may be C; Y₁₁ may be C, and Y₁₂ may be N; or Y₁₁ may be N, and Y₁₂ may be N, but embodiments of the present disclosure are not limited thereto.

In one embodiment, in Formula 1A, Y₁₁ may be N, and Y₁₂ may be C; Y₁₁ may be C, and Y₁₂ may be N, but embodiments of the present disclosure are not limited thereto. In this case, a bond between Y₁₁ and Y₁₂ may be a double bond, but embodiments of the present disclosure are not limited thereto.

In Formula 1A, Z₁₁ and Z₁₃ may each independently be C.

For example, in Formula 1A, two bonds selected from a bond between Z₁₁ and N, a bond between Z₁₁ and W₁₁, a bond between W₁₁ and Y₁₁, a bond between Y₁₁ and Y₁₂, and a bond between N and Y₁₂ may each be a double bond, and the others thereof may each be a single bond, but embodiments of the present disclosure are not limited thereto.

In one embodiment, in Formula 1A, a moiety represented by 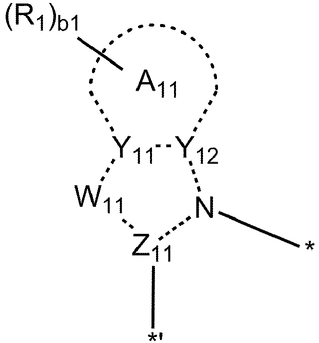 may be represented by Formula 1A-1, and a moiety represented by 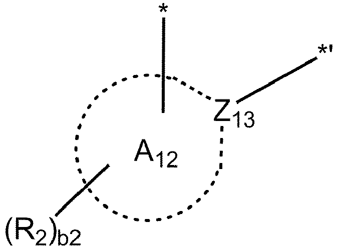 may be represented by Formula 1A-2, but embodiments of the present disclosure are not limited thereto:

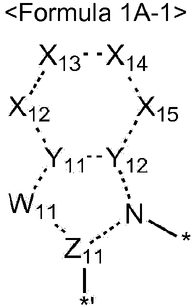

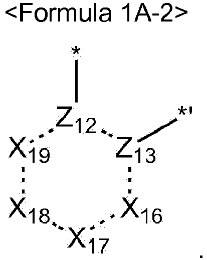

In Formulae 1A-1 and 1A-2,
Y₁₁, Y₁₂, W₁₁, Z₁₁ and Z₁₃ may each independently be the same as defined in Formula 1A;
X₁₂ may be selected from N, N(R₁₂ₐ), O, S, C(R₁₂ₐ), and C(R₁₂ₐ)(R_{12b}), X₁₃ may be selected from N, N(R₁₃ₐ), O, S, C(R₁₃ₐ), and C(R₁₃ₐ)(R_{13b}), X₁₄ may be selected from N, N(R₁₄ₐ), O, S, C(R₁₄ₐ), and C(R₁₄ₐ)(R_{14b}), X₁₅ may be selected from N, N(R₁₅ₐ), O, S, C(R₁₅ₐ), and C(R₁₅ₐ)(R_{15b}), X₁₆ may be selected from N, N(R₁₆ₐ), O, S, C(R₁₆ₐ), and C(R₁₆ₐ)(R_{16b}), X₁₇ may be selected from N, N(R₁₇ₐ), O, S, C(R₁₇ₐ), and C(R₁₇ₐ)(R_{17b}), X₁₈ may be selected from N, N(R₁₈ₐ), O, S, C(R₁₈ₐ), and C(R₁₈ₐ)(R_{18b}), and X₁₉ may be selected from N, N(R₁₉ₐ), O, S, C(R₁₉ₐ), and C(R₁₉ₐ)(R_{19b}),
R₁₂ₐ, R_{12b}, R₁₃ₐ, R_{13b}, R₁₄ₐ, R_{14b}, R₁₅ₐ, R_{15b}, R₁₆ₐ, R_{16b}, R₁₇ₐ, R_{17b}, R₁₈ₐ, R_{18b}, R₁₉ₐ, and R_{19b} may each independently be defined the same as R₁ in Formula 1A,
in Formulae 1A-1, * may be a binding site to M₁₁ of Formula 1, and *' may be a binding site to a neighboring atom, and
in Formulae 1A-2, *' may be a binding site to M₁₁ of Formula 1, and * may be a binding site to a neighboring atom.

In Formulae 1A-1 and 1A-2, a bond between Y₁₂ and X₁₅, a bond between X₁₅ and X₁₄, a bond between X₁₃ and X₁₄, a bond between X₁₂ and X₁₃, a bond between Y₁₁ and X₁₂, a bond between Z₁₂ and Z₁₃, a bond between Z₁₃ and X₁₆, a bond between X₁₆ and X₁₇, a bond between X₁₇ and X₁₈, a bond between X₁₈ and X₁₉, and a bond between X₁₉ and Z₁₂ may each independently be a single bond or a double bond.

In one embodiment, in Formulae 1A-1 and 1A-2, X₁₂ may be selected from N and C(R₁₂ₐ), X₁₃ may be selected from N and C(R₁₃ₐ), X₁₄ may be selected from N and C(R₁₄ₐ), X₁₅ may be selected from N and C(R₁₅ₐ), X₁₆ may be selected from N and C(R₁₆ₐ), X₁₇ may be selected from N and C(R₁₇ₐ), X₁₈ may be selected from N and C(R₁₈ₐ), and X₁₉ may be selected from N and C(R₁₉ₐ), but embodiments of the present disclosure are not limited thereto.

In one embodiment, in Formula 1A-1, X₁₂ may be C(R₁₂ₐ), X₁₃ may be C(R₁₃ₐ), X₁₄ may be C(R₁₄ₐ), and X₁₅ may be C(R₁₅ₐ), but embodiments of the present disclosure are not limited thereto.

In one embodiment, in Formula 1A-1, at least one selected from X₁₂ to X₁₅ may be selected from O and S, but embodiments of the present disclosure are not limited thereto.

In one embodiment, in Formula 1A-2, X₁₆ may be N, X₁₇ may be C(R₁₇ₐ), X₁₈ may be C(R₁₅ₐ), and X₁₉ may be C(R₁₉ₐ); X₁₆ may be C(R₁₆ₐ), X₁₇ may be N, X₁₈ may be C(R₁₈ₐ), and X₁₉ may be C(R₁₉ₐ); X₁₆ may be C(R₁₆ₐ), X₁₇ may be C(R₁₇ₐ), X₁₈ may be N, and X₁₉ may be C(R₁₉ₐ); X₁₆ may be C(R₁₆ₐ), X₁₇ may be C(R₁₇ₐ), X₁₈ may be C(R₁₈ₐ), and X₁₉ may be N; or X₁₆ may be C(R₁₆ₐ), X₁₇ may be C(R₁₇ₐ), X₁₈ may be C(R₁₈ₐ), and X₁₉ may be C(R₁₉ₐ), but embodiments of the present disclosure are not limited thereto.

In one embodiment, in Formula 1A-1, three bonds selected from a bond between Y₁₁ and Y₁₂, a bond between Y₁₂ and X₁₅, a bond between X₁₅ and X₁₄, a bond between X₁₃ and X₁₄, a bond between X₁₂ and X₁₃, and a bond between Y₁₁ and X₁₂ may each be a double bond, and the others thereof may each be a single bond, but embodiments of the present disclosure are not limited thereto.

In one embodiment, in Formula 1A-2, three bonds selected from a bond between Z₁₂ and Z₁₃, a bond between Z₁₃ and X₁₆, a bond between X₁₆ and X₁₇, a bond between X₁₇ and X₁₈, a bond between X₁₈ and X₁₉, and a bond between X₁₉ and Z₁₂ may each be a double bond, and the others thereof may each be a single bond, but embodiments of the present disclosure are not limited thereto.

In one embodiment, in Formula 1A, a moiety represented by 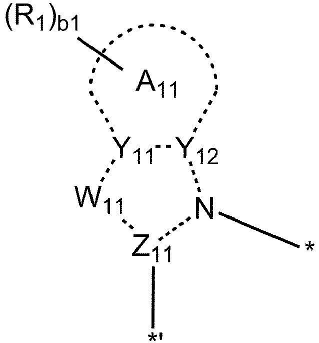 may be represented by one selected from Formulae 2-1 to 2-15, but embodiments of the present disclosure are not limited thereto:

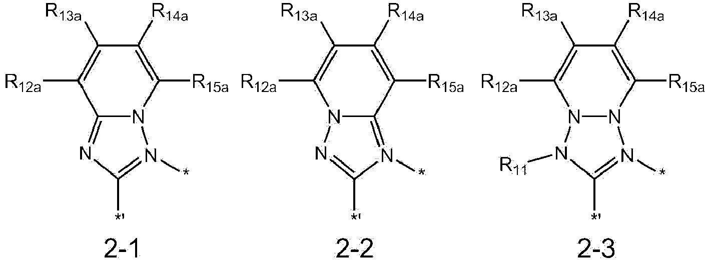

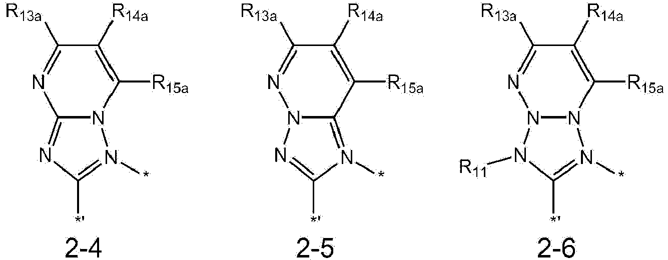

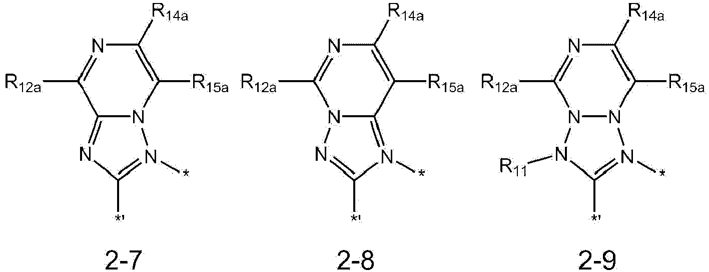

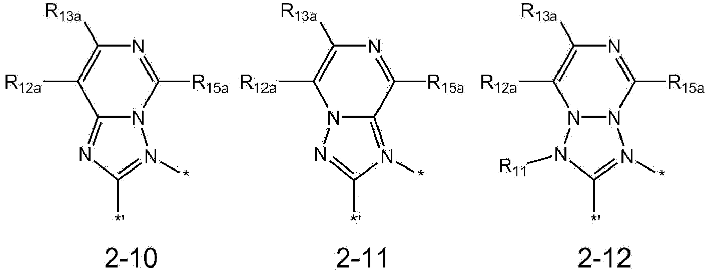

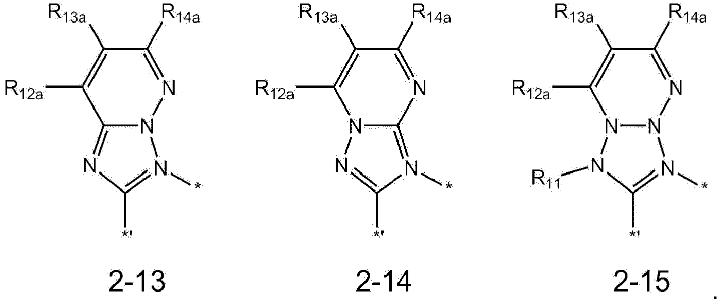

In Formulae 2-1 to 2-15,
R₁₁ may be the same as described in Formula 1,
R₁₂ₐ, R₁₃ₐ, R₁₄ₐ, and R₁₅ₐ may each independently be defined the same as R₁ in Formula 1A; and
* and *' each indicate a binding site to a neighboring atom.

In one or more embodiments, in Formula 1A, a moiety represented by 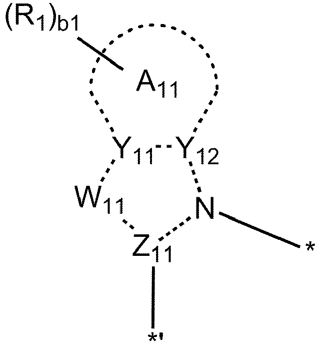 may be represented by one selected from Formulae 2-1 and 2-2, but embodiments of the present disclosure are not limited thereto.

In one or more embodiments, in Formula 1A, a moiety represented by 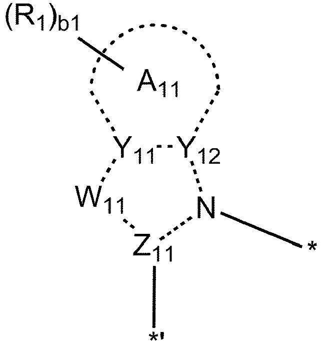 may be represented by Formula 2-1, but embodiments of the present disclosure are not limited thereto.

In one embodiment, in Formula 1A, a moiety represented by 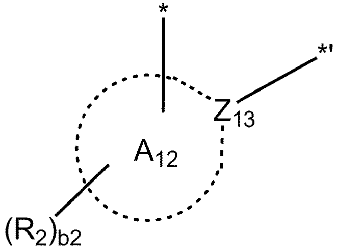 may be represented by one selected from Formulae 3-1 to 3-8, but embodiments of the present disclosure are not limited thereto:

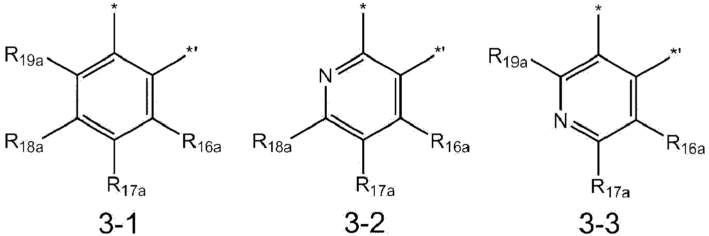

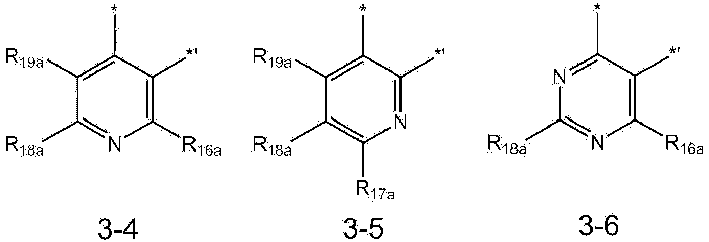

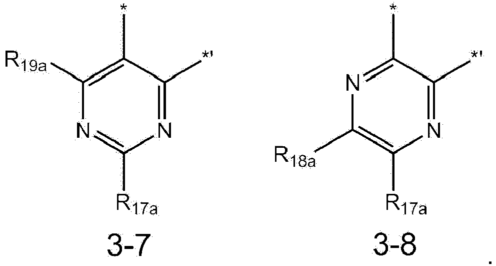

In Formulae 3-1 to 3-8,
R₁₆ₐ, R₁₇ₐ, R₁₈ₐ, and R₁₉ₐ may each independently be the same as R₂ described in Formula 1, and
* and * each indicate a binding site to a neighboring atom.

In one or more embodiments, in Formula 1A, a moiety represented by 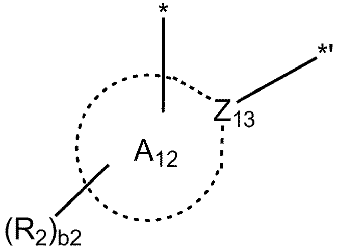 may be represented by one selected from Formulae 3-1 to 3-5, but embodiments of the present disclosure are not limited thereto.

In one or more embodiments, in Formula 1A, a moiety represented by 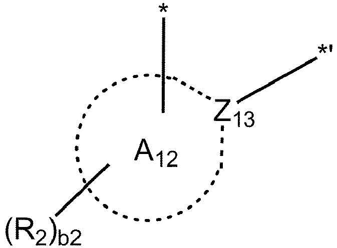 may be represented by Formula 3-1, but embodiments of the present disclosure are not limited thereto.

In Formula 1A, R₁, R₂, and R₁₁ may each independently be selected from hydrogen, deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), - B(Q₆)(Q₇), and -P(=O)(Q₈)(Q₉),
two or more selected from R₁, R₂, and R₁₁ may optionally be linked to each other to form a ring, and
Q₁ to Q₉ may each independently be selected from hydrogen, deuterium, -F, - CI, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₁-C₆₀ alkyl group substituted with at least one selected from deuterium, a C₁-C₆₀ alkyl group, and a C₆-C₆₀ aryl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from deuterium, a C₁-C₆₀ alkyl group, and a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

For example, in Formula 1A, R₁, R₂, and R₁₁ may each independently be selected from:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -CI, -Br, -I, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclopentyl group substituted with deuterium, a cyclohexyl group, a cyclohexyl group substituted with deuterium, a cycloheptyl group, a cycloheptyl group substituted with deuterium, a cycloctyl group, a cycloctyl group substituted with deuterium, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cycloctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cycloctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclopentyl group substituted with deuterium, a cyclohexyl group, a cyclohexyl group substituted with deuterium, a cycloheptyl group, a cycloheptyl group substituted with deuterium, a cycloctyl group, a cycloctyl group substituted with deuterium, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group and -Si(Q₃₃)(Q₃₄)(Q₃₅); and
-N(Q₁)(Q₂), -Si(Q₃)(Q₄)(Q₅), -B(Q₆)(Q₇), and -P(=O)(Q₈)(Q₉), and
Q₁ to Q₉ and Q₃₃ to Q₃₅ may each independently be selected from:
   -CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group, but embodiments of the present disclosure are not limited thereto.

In one embodiment, in Formula 1A, R₁, R₂, and R₁₁ may each independently be selected from:
hydrogen, deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cycloctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a fluorenyl group, a carbazolyl group, a dibenzofuranyl group, a dibenzothiophenyl group, and a dibenzosilolyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cycloctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a fluorenyl group, a carbazolyl group, a dibenzofuranyl group, a dibenzothiophenyl group, and a dibenzosilolyl group, each substituted with at least one selected from deuterium, -F, -CD₃, -CD₂H, -CDH₂, -CF₃, -CF₂H, -CFH₂, a cyano group, a nitro group, a C₁-C₁₀ alkyl group, a C₁-C₁₀ alkoxy group, a cyclopentyl group, a cyclopentyl group substituted with deuterium, a cyclohexyl group, a cyclohexyl group substituted with deuterium, a cycloheptyl group, a cycloheptyl group substituted with deuterium, a cycloctyl group, a cycloctyl group substituted with deuterium, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a fluorenyl group, a carbazolyl group, a dibenzofuranyl group, a dibenzothiophenyl group, a dibenzosilolyl group, and - Si(Q33)(Q34)(Q35); and
-N(Q₁)(Q₂), -Si(Q₃)(Q₄)(Q₅), -B(Q₆)(Q₇), and -P(=O)(Q₈)(Q₉), and
Q₁ to Q₉ and Q₃₃ to Q₃₅ may each independently be selected from -CH₃, -CD₃, -CD₂H, -CDH₂, -CH₂CH₃, -CH₂CD₃, -CH₂CD₂H, -CH₂CDH₂, -CHDCH₃, -CHDCD₂H, - CHDCDH₂, -CHDCD₃, -CD₂CD₃, -CD₂CD₂H and -CD₂CDH₂; an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group,
but embodiments of the present disclosure are not limited thereto.

in one embodiment, in Formula 1A, R₁, R₂, and R₁₁ may each independently be selected from hydrogen, deuterium, -F, a cyano group, a nitro group, -SF₅, -CH₃, - CD₃, -CD₂H, -CDH₂, -CF₃, -CF₂H, -CFH₂, groups represented by Formulae 9-1 to 9-21, groups represented by Formulae 10-1 to 10-246, -N(Q₁)(Q₂), -Si(Q₃)(Q₄)(Q₅), - B(Q₆)(Q₇), and -P(=O)(Q₈)(Q₉), but embodiments of the present disclosure are not limited thereto: 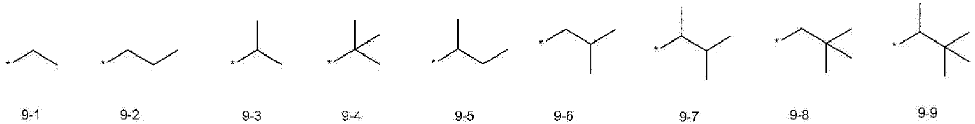 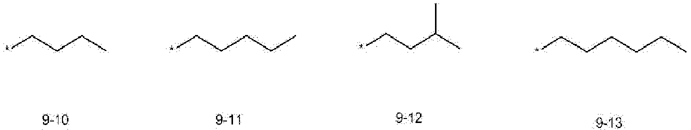 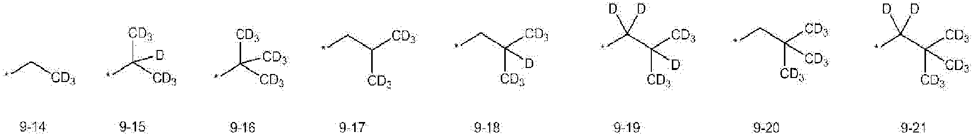 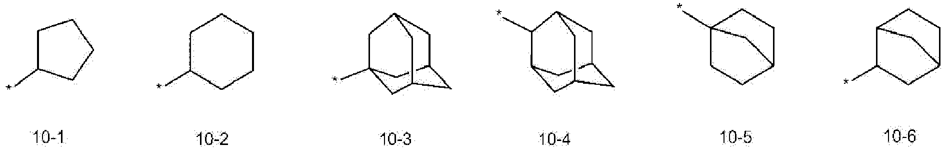 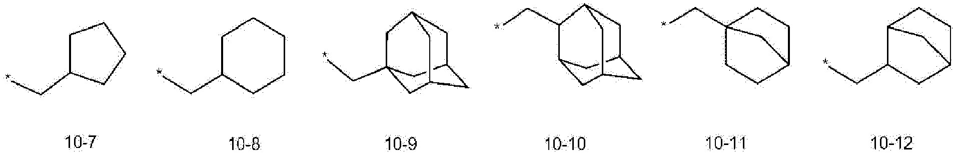 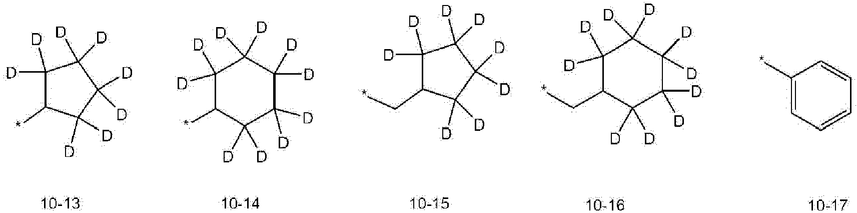 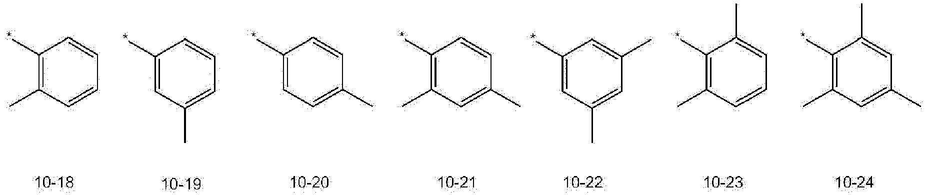 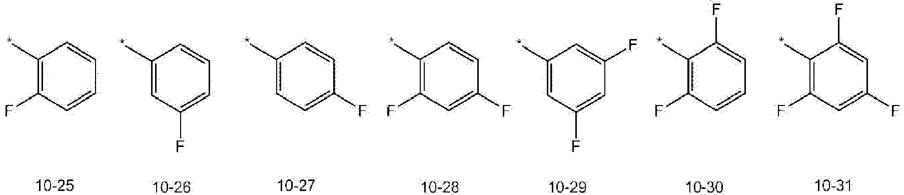 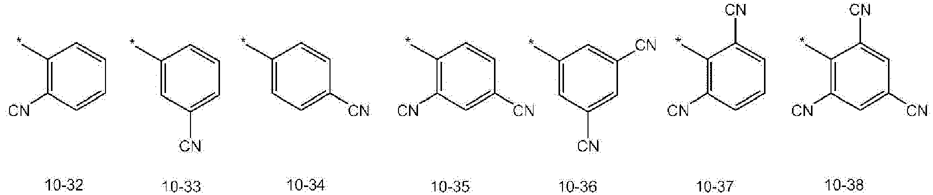 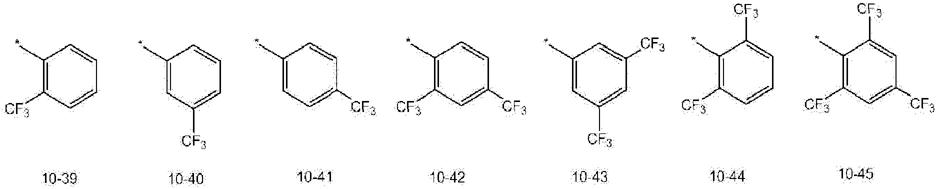 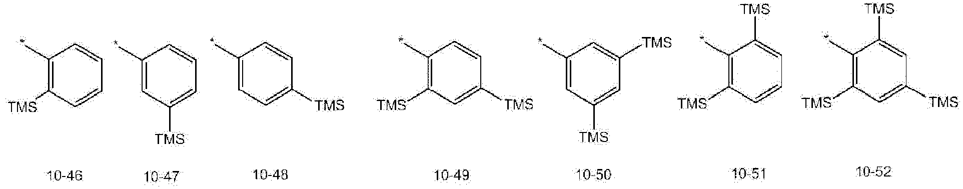 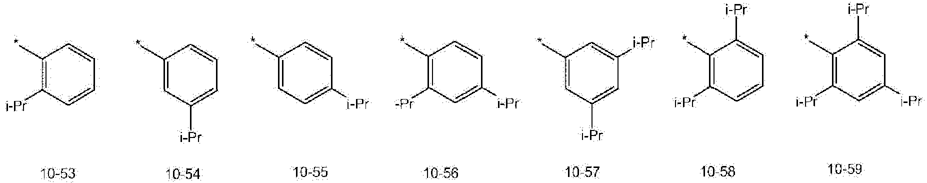 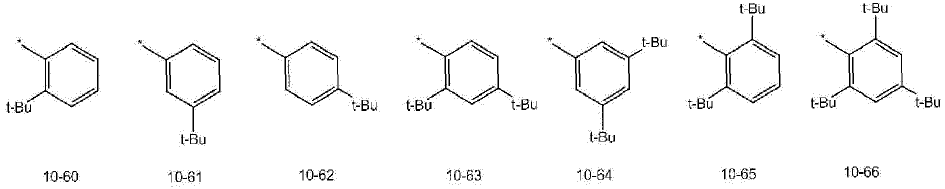 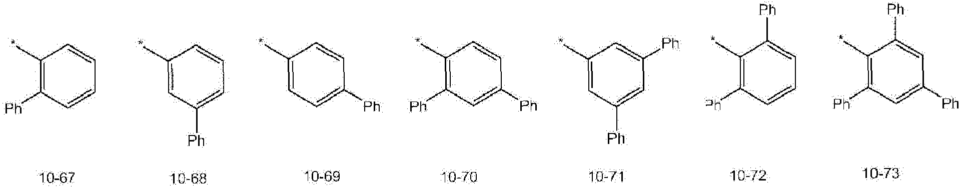 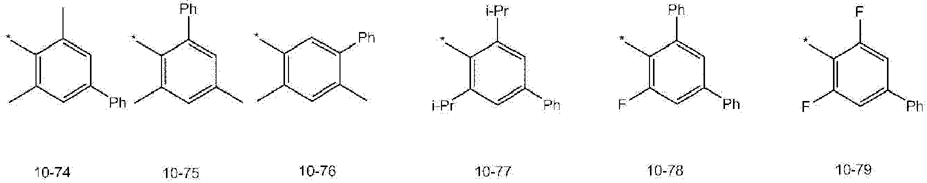 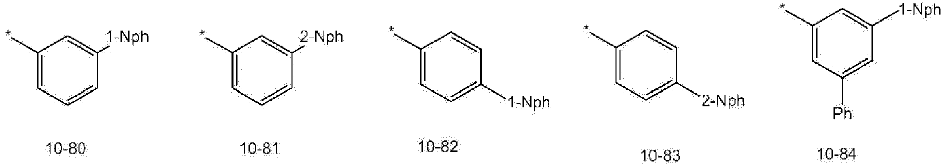 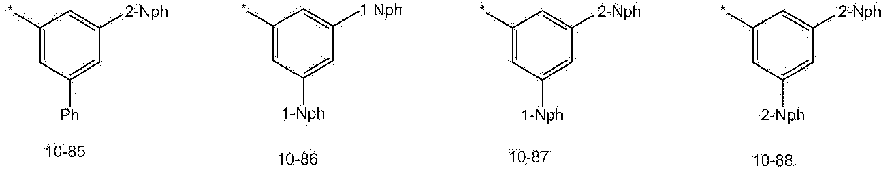 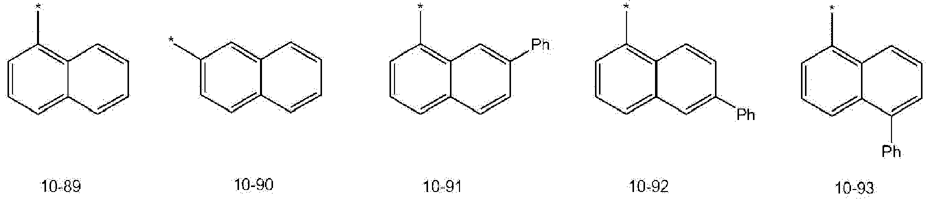 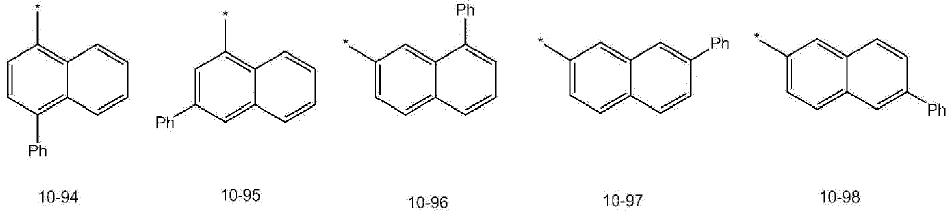 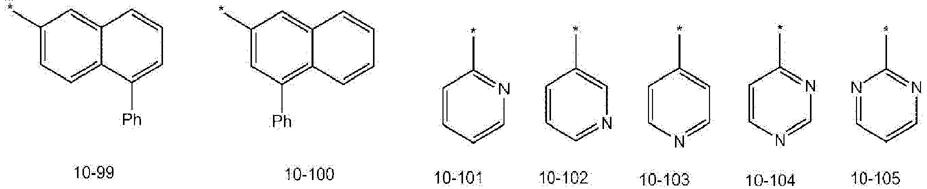 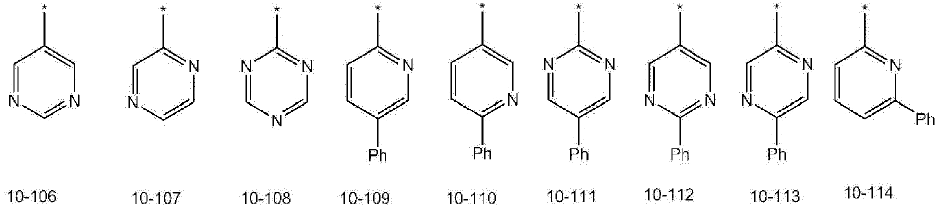 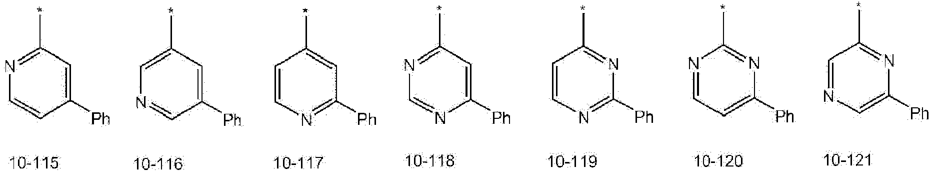 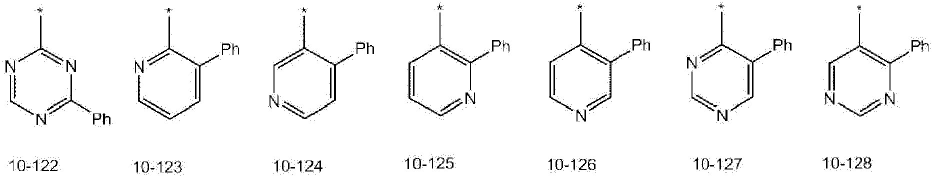 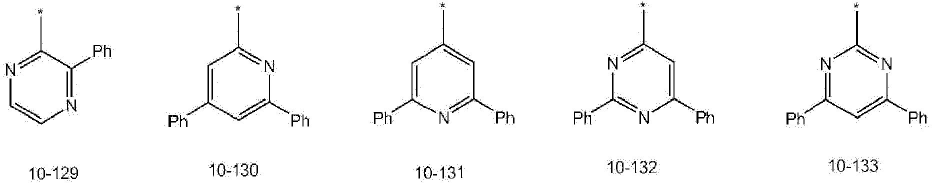 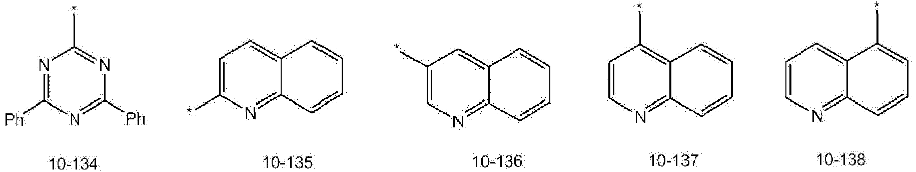 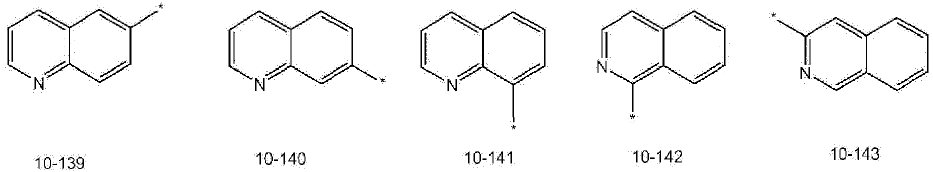 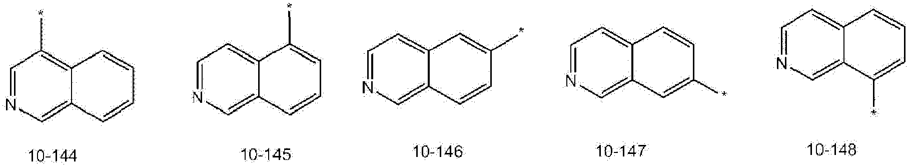 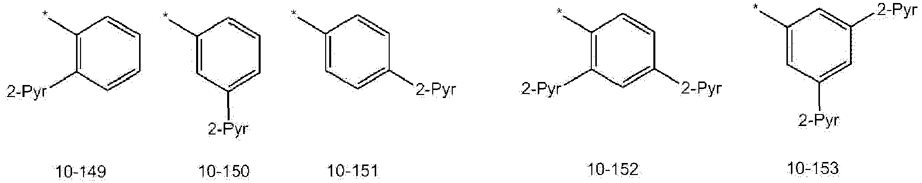 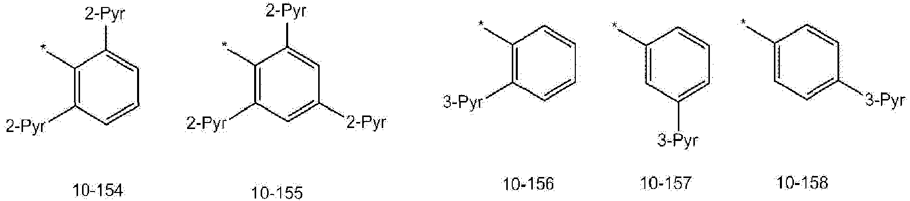 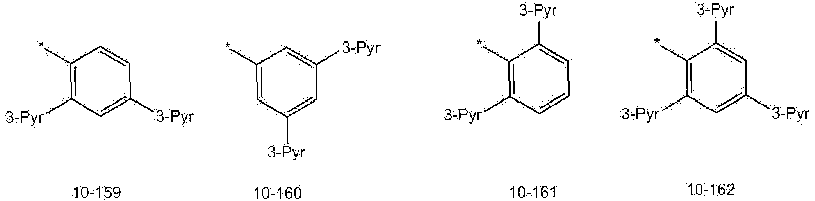 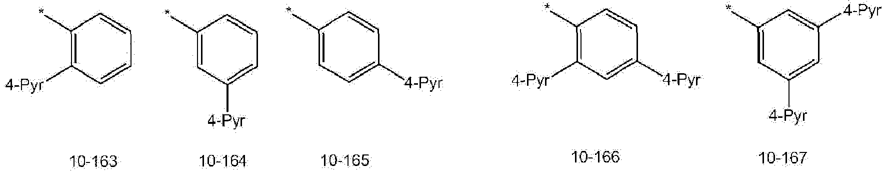 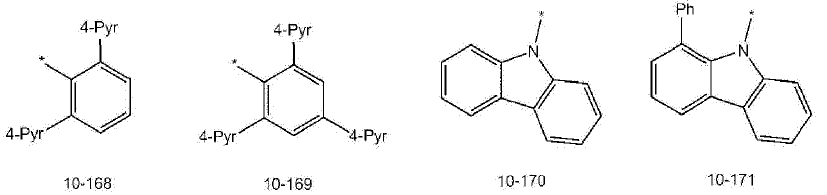 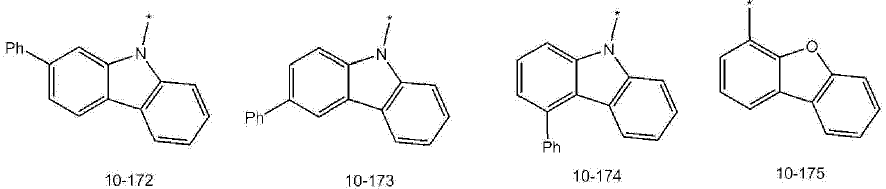 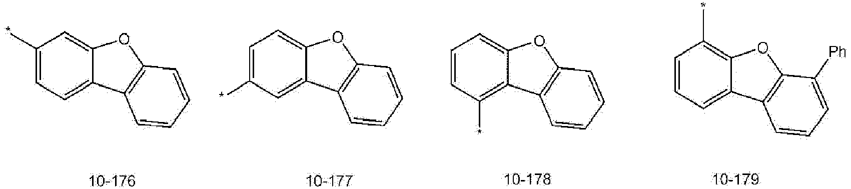 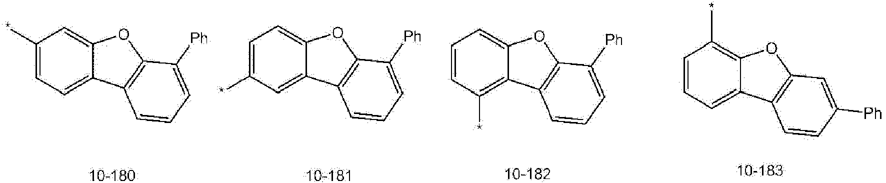 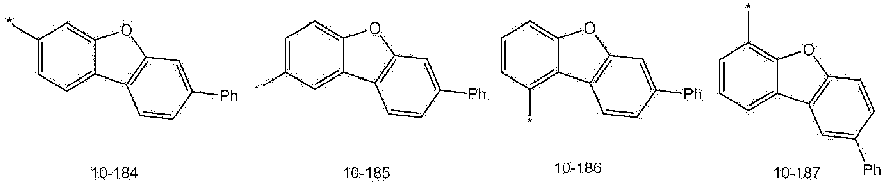 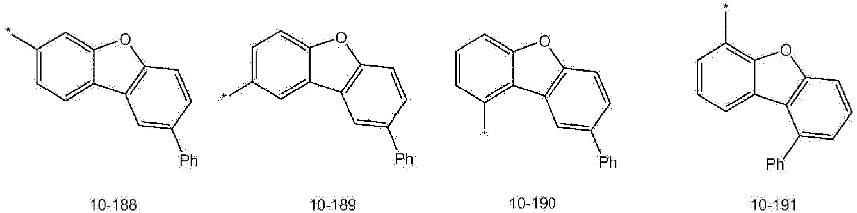 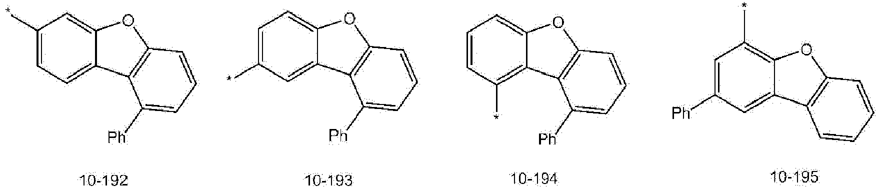 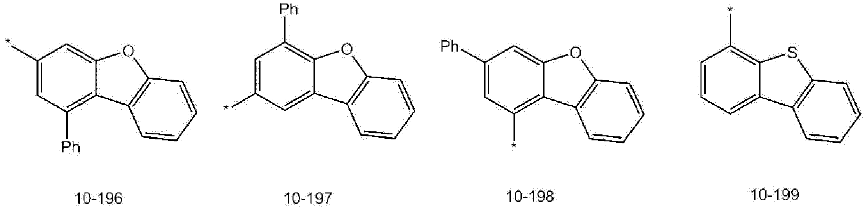 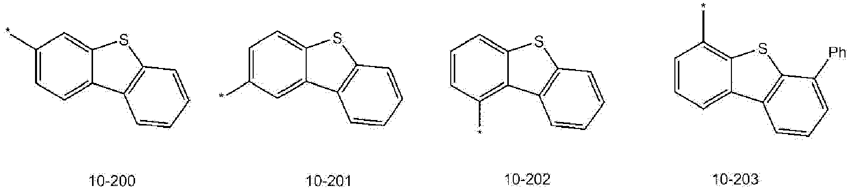 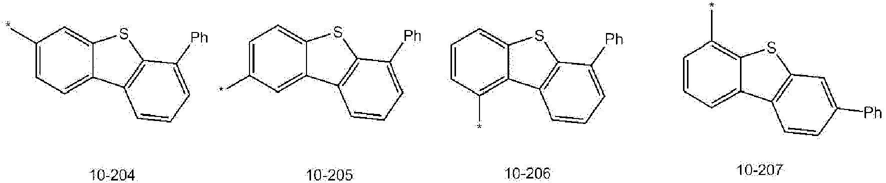 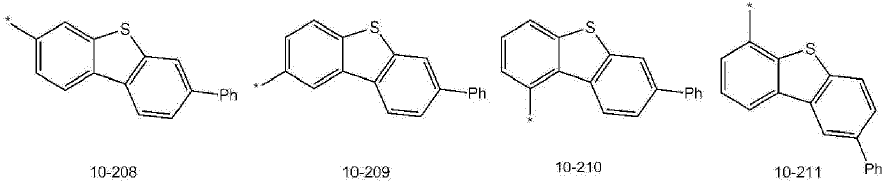 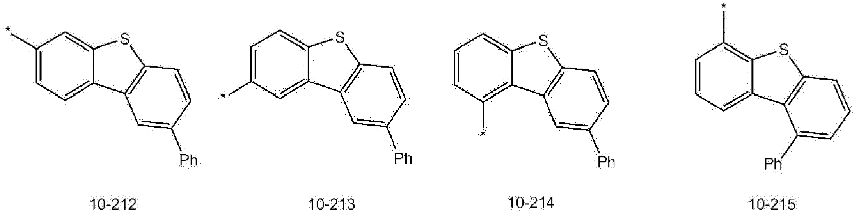 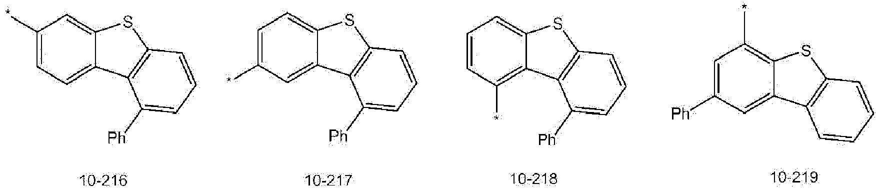 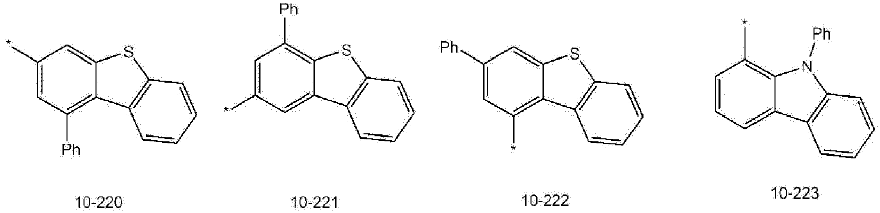 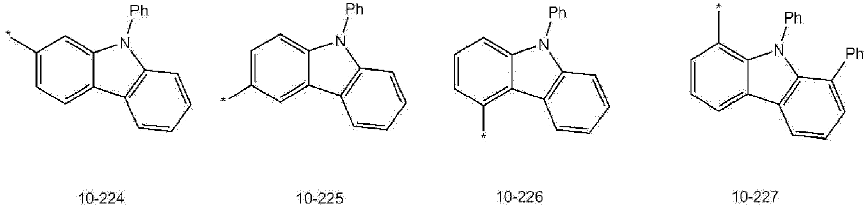 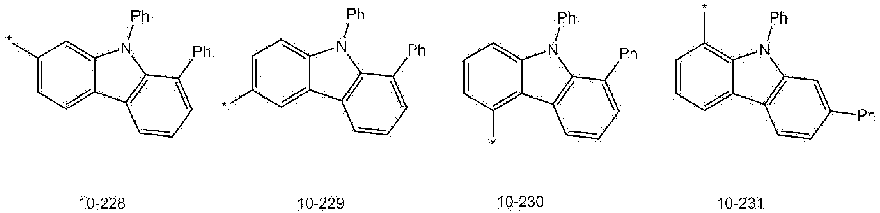 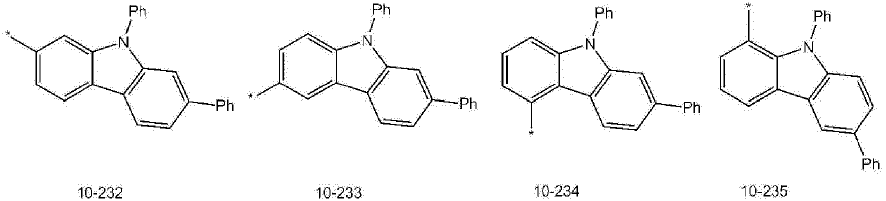 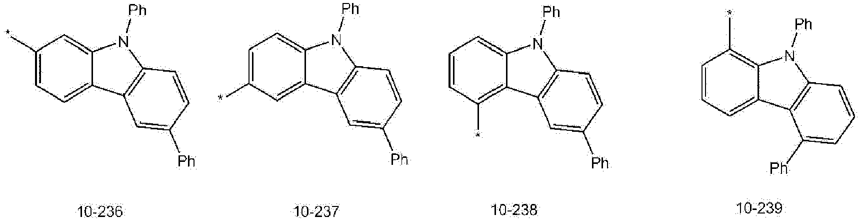 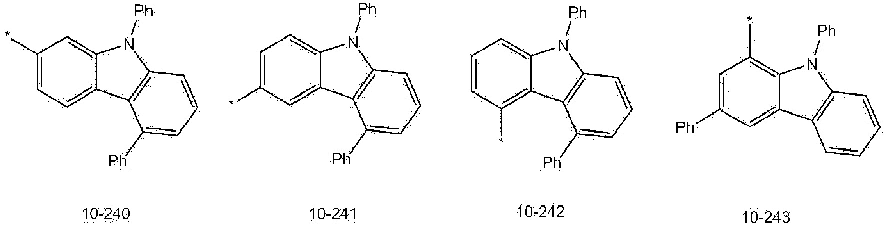 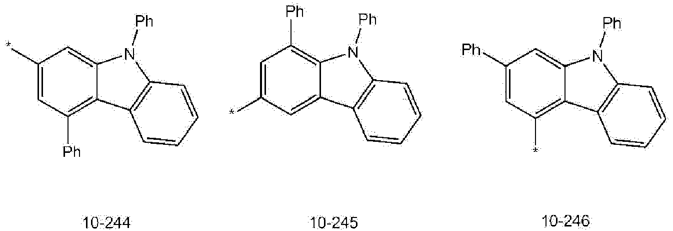 Q₁ to Q₉ may each independently be selected from:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group.

In Formulae 9-1 to 9-21 and 10-1 to 10-246,
* indicates a binding site to a neighboring atom,
i-Pr indicates an isopropyl group,
t-Bu indicates a t-butyl group,
Ph indicates a phenyl group,
1-Nph indicates a 1-naphthyl group,
2-Nph indicates a 2-naphthyl group,
2-Pyr indicates a 2-pyridyl group,
3-Pyr indicates a 3-pyridyl group,
4-Pyr indicates a 4-pyridyl group, and
TMS indicates a trimethylsilyl group.

In one embodiment, in Formula 1A, R₁, R₂, and R₁₁ may each independently be selected from hydrogen, deuterium, -F, a cyano group, a nitro group, -SF₅, -CH₃, - CF₃, groups represented by Formulae 9-1 to 9-13, and groups represented by Formulae 10-17 to 10-79, but embodiments of the present disclosure are not limited thereto:

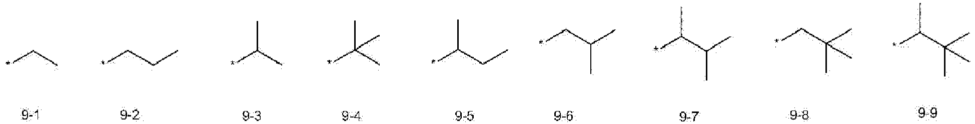

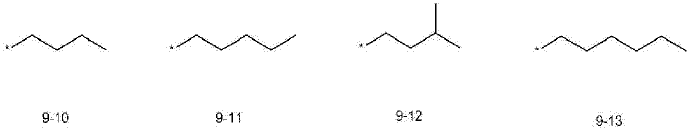

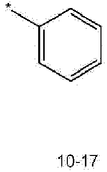

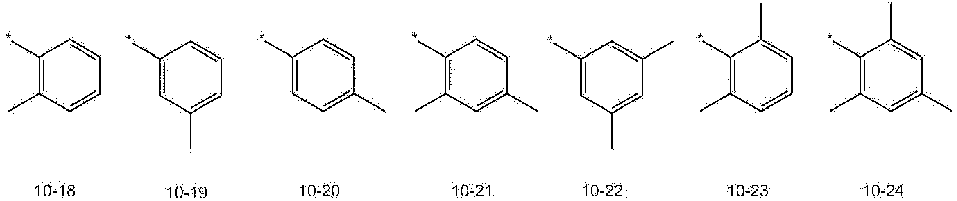

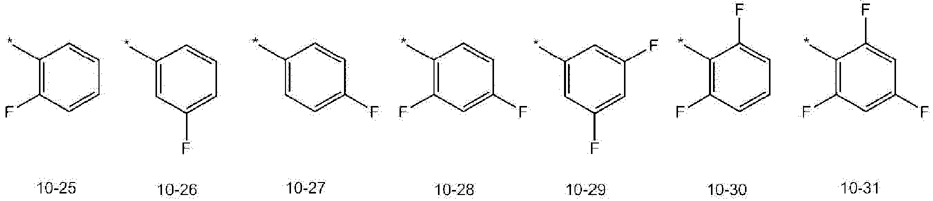

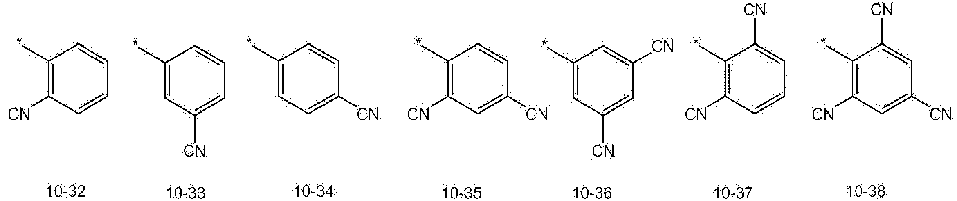

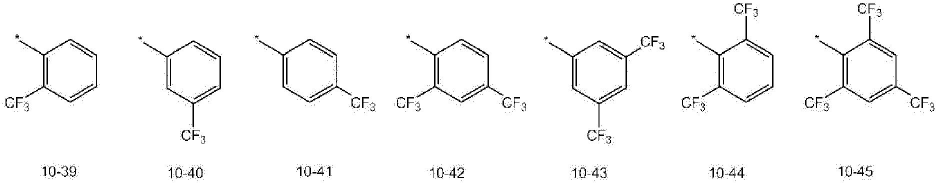

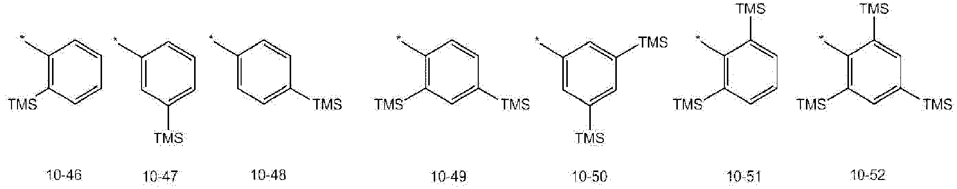

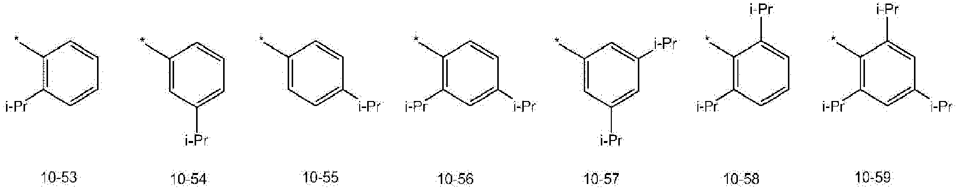

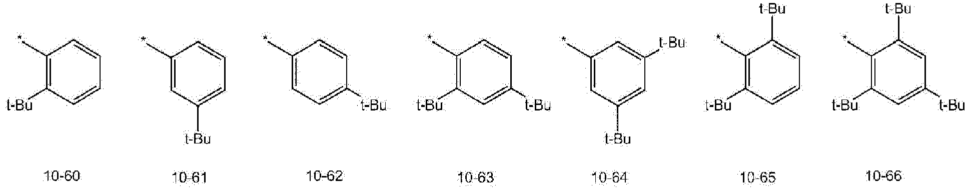

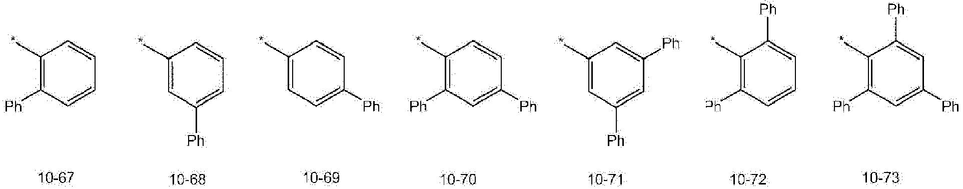

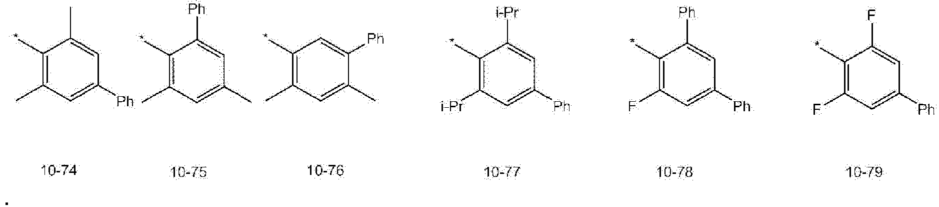

In Formulae 9-1 to 9-13 and 10-17 to 10-79,
* indicates a binding site to a neighboring atom,i-Pr indicates an isopropyl group, and t-Bu indicates a t-butyl group,
Ph indicates a phenyl group, and
TMS indicates a trimethylsilyl group.

In one embodiment, in Formula 1A, at least one selected from R₁, R₂, and R₁₁ may be selected from deuterium, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and - P(=O)(Q₈)(Q₉), but embodiments of the present disclosure are not limited thereto.

In Formula 1A, two, three, or four selected from a plurality of neighboring R₁, R₂, and R₁₁ may optionally be linked to form a four-coordinate, six-coordinate, or eight-coordinate ligand.

For example, in Formula 1A-1, two neighboring R₁₂ₐ(s) may optionally be linked to form a tetradentate ligand, but embodiments of the present disclosure are not limited thereto.

In one embodiment, in Formula 1A-1, two neighboring R₁₃ₐ(s) may optionally be linked to form a tetradentate ligand, but embodiments of the present disclosure are not limited thereto.

In one embodiment, in Formula 1A-1, two neighboring R₁₄ₐ(s) may optionally be linked to form a tetradentate ligand, but embodiments of the present disclosure are not limited thereto.

In one embodiment, in Formula 1A-1, two neighboring R₁₅ₐ(s) may optionally be linked to form a tetradentate ligand, but embodiments of the present disclosure are not limited thereto.

In one embodiment, in Formula 1A-2, two neighboring R₁₆ₐ(s) may optionally be linked to form a tetradentate ligand, but embodiments of the present disclosure are not limited thereto.

In one embodiment, in Formula 1A-2, two neighboring R₁₇ₐ(s) may optionally be linked to form a tetradentate ligand, but embodiments of the present disclosure are not limited thereto.

In one embodiment, in Formula 1A-2, two neighboring R₁₈ₐ(s) may optionally be linked to form a tetradentate ligand, but embodiments of the present disclosure are not limited thereto.

In one embodiment, in Formula 1A-2, two neighboring R₁₉ₐ(s) may optionally be linked to form a tetradentate ligand, but embodiments of the present disclosure are not limited thereto.

For example, in Formula 1A-1, three neighboring R₁₂ₐ(s) may optionally be linked to form a tetradentate ligand, but embodiments of the present disclosure are not limited thereto.

In one embodiment, in Formula 1A-1, three neighboring R₁₃ₐ(s) may optionally be linked to form a tetradentate ligand, but embodiments of the present disclosure are not limited thereto.

In one embodiment, in Formula 1A-1, three neighboring R₁₄ₐ(s) may optionally be linked to form a tetradentate ligand, but embodiments of the present disclosure are not limited thereto.

In one embodiment, in Formula 1A-1, three neighboring R₁₅ₐ(s) may optionally be linked to form a tetradentate ligand, but embodiments of the present disclosure are not limited thereto.

In one embodiment, in Formula 1A-2, three neighboring R₁₆ₐ(s) may optionally be linked to form a tetradentate ligand, but embodiments of the present disclosure are not limited thereto.

In one embodiment, in Formula 1A-2, three neighboring R₁₇ₐ(s) may optionally be linked to form a tetradentate ligand, but embodiments of the present disclosure are not limited thereto.

In one embodiment, in Formula 1A-2, three neighboring R₁₈ₐ(s) may optionally be linked to form a tetradentate ligand, but embodiments of the present disclosure are not limited thereto.

In one embodiment, in Formula 1A-2, three neighboring R₁₉ₐ(s) may optionally be linked to form a tetradentate ligand, but embodiments of the present disclosure are not limited thereto.

In Formula 1, n11 may be selected from 1, 2, 3, and 4, wherein, when n11 is 2 or more, 2 or more L₁₁(s) are the same or different from each other.

For example, In Formula 1, n11 may be selected from 1, 2 and 3, but embodiments of the present disclosure are not limited thereto.

In Formula 1, L₁₂ may be selected from a one-coordinate ligand, a two-coordinate ligand, and a three-coordinate ligand.

For example, in Formula 1, L₁₂ may be selected from one-coordinate ligands, for example, I⁻, Br⁻, Cl⁻, sulfide, nitrate, azide, hydroxide, cyanate, isocyanate, thiocyanate, water, acetonitrile, pyridine, ammonia, carbon monoxide, P(Ph)₃, P(Ph)₂CH₃, PPh(CH₃)₂, and P(CH₃)₃, but embodiments of the present disclosure are not limited thereto.

In one embodiment, in Formula 1, L₁₂ may be selected from two-coordinate ligands, for example, oxalate, acetylacetonate, picolinic acid, 1,2-bis(diphenylphosphino)ethane, 1,1-bis(diphenylphosphino)methane, glycinate, and ethylenediamine, but embodiments of the present disclosure are not limited thereto.

In one embodiment, in Formula 1, L₁₂ may be a ligand represented by one selected from Formulae 7-1 to 7-11, but embodiments of the present disclosure are not limited thereto:

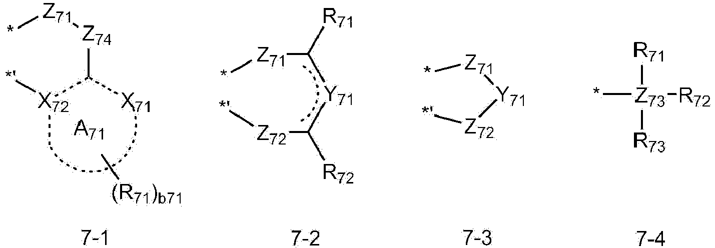

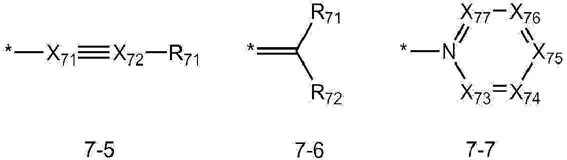

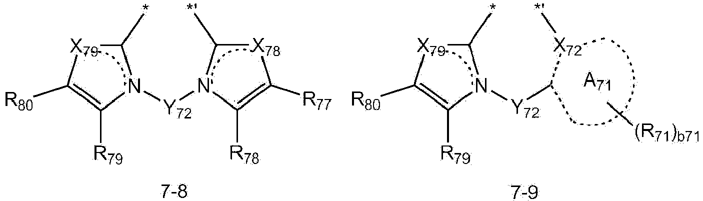

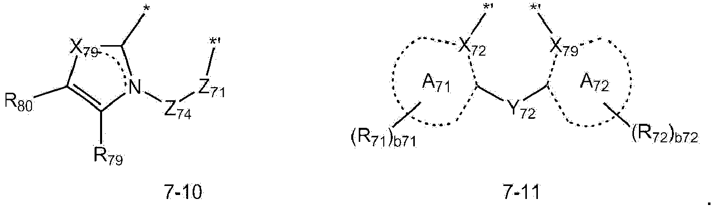

In Formulae 7-1 to 7-11,
A₇₁ and A₇₂ may each independently be selected from a C₅-C₂₀ carbocyclic group and a C₁-C₂₀ heterocyclic group,
X₇₁ and X₇₂ may each independently be selected from C and N,
X₇₃ may be N or C(Q73); X₇₄ may be N or C(Q74); X₇₅ may be N or C(Q₇₅); X₇₆ may be N or C(Q76); and X₇₇ may be N or C(Q₇₇),
X₇₈ may be O, S, or N(Q78); and X₇₉ may be O, S, or N(Q79),
Y₇₁ and Y₇₂ may each independently be selected from a single bond, a double bond, a substituted or unsubstituted C₁-C₅ alkylene group, a substituted or unsubstituted C₂-C₅ alkenylene group, and a substituted or unsubstituted C₆-C₁₀ arylene group,
Z₇₁ and Z₇₂ may each independently be selected from N, O, N(R₇₅), P(R₇₅)(R₇₆), and As(R₇₅)(R₇₆),
Z₇₃ may be selected from P and As,
Z₇₄ may be selected from CO and CH₂,
R₇₁ to R₈₀ and Q₇₃ to Q₇₉ may each independently be selected from hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group; R₇₁ and R₇₂ may optionally be linked to each other to form a ring; R₇₇ and R₇₈ may optionally be linked to each other to form a ring; R₇₈ and R₇₉ may optionally be linked to each other to form a ring; and R₇₉ and R₈₀ may optionally be linked to each other to form a ring,
b71 and b72 may each independently be selected from 1, 2, and 3, and
* and *' each indicate a binding site to a neighboring atom.

For example, in Formula 7-1, A₇₁ may be selected from a benzene group, a naphthalene group, an imidazole group, a benzimidazole group, a pyridine group, a pyrimidine group, a triazine group, a quinoline group, and an isoquinoline group, but embodiments of the present disclosure are not limited thereto.

For example, in Formula 7-1, X₇₁ and X₇₂ may each independently be N, but embodiments of the present disclosure are not limited thereto.

For example, in Formula 7-7,
X₇₃ may be C(Q73),
X₇₄ may be C(Q74),
X₇₅ may be C(Q₇₅),
X₇₆ may be C(Q76), and
X₇₇ may be C(Q₇₇), but embodiments of the present disclosure are not limited thereto.

For example, in Formula 7-8,
X₇₈ may be N(Q78), and
X₇₉ may be N(Q₇₉), but embodiments of the present disclosure are not limited thereto.

For example, in Formulae 7-2, 7-3, and 7-8, Y₇₁ and Y₇₂ may each independently be selected from a substituted or unsubstituted methylene group and a substituted or unsubstituted phenylene group, but embodiments of the present disclosure are not limited thereto.

For example, in Formulae 7-1 and 7-2, Z₇₁ and Z₇₂ may each independently be O, but embodiments of the present disclosure are not limited thereto.

For example, in Formula 7-4, Z₇₃ may be P, but embodiments of the present disclosure are not limited thereto.

For example, in Formulae 7-1 to 7-11, R₇₁ to R₈₀ and Q₇₃ to Q₇₉ may each independently be selected from:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a pyridinyl group, and a pyrimidinyl group;
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group; and
a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group, each substituted with at least one selected from deuterium, -F, -CI, -Br, -I, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, and an imidazopyridinyl group, but embodiments of the present disclosure are not limited thereto.

In one or more embodiments, in Formula 1, L₁₂ may be a ligand represented by one selected from Formulae 5-1 to 5-116 and Formulae 8-1 to 8-43, but embodiments of the present disclosure are not limited thereto:

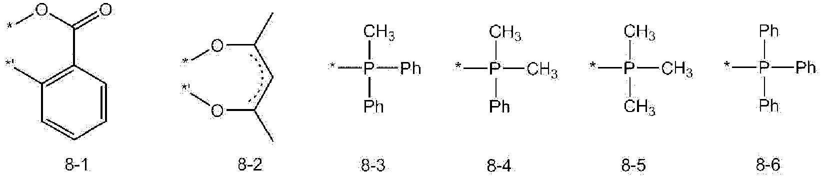

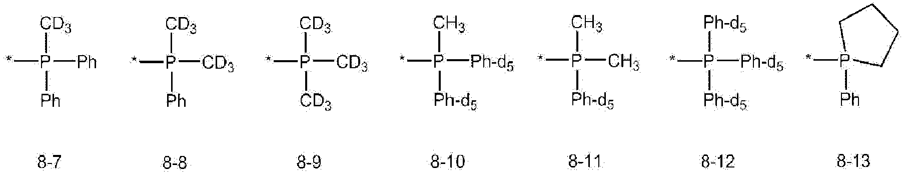

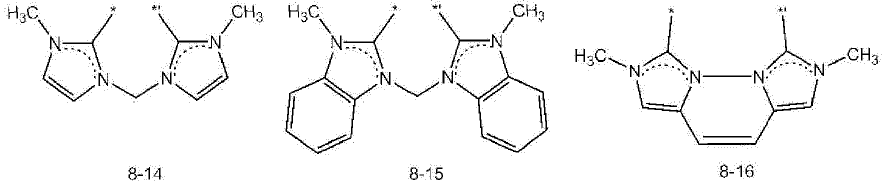

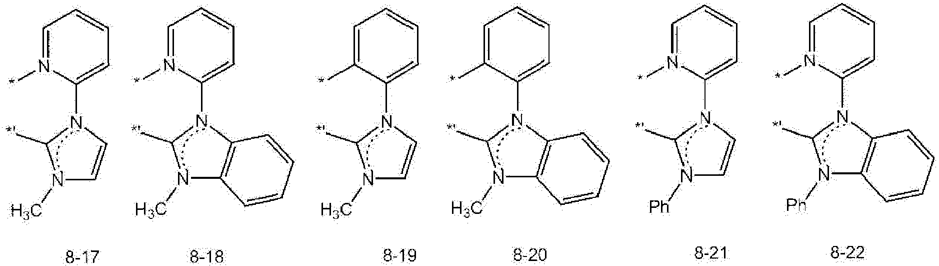

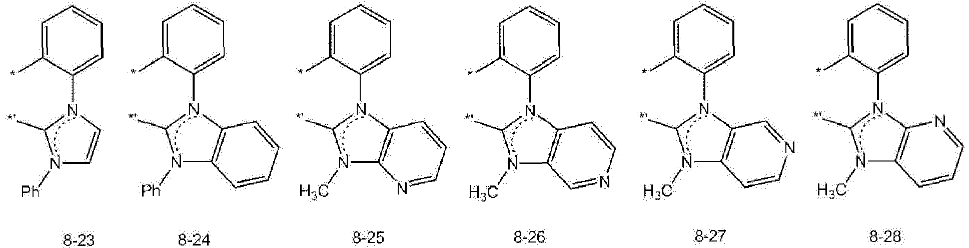

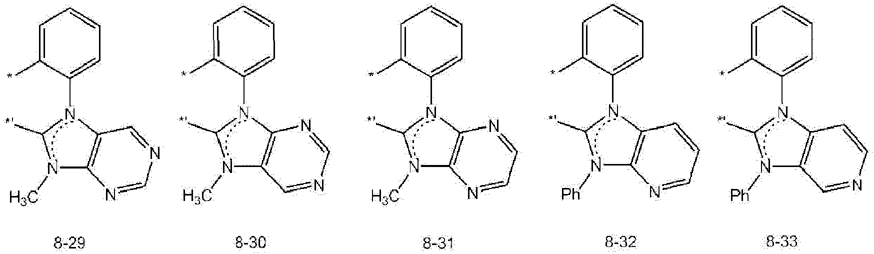

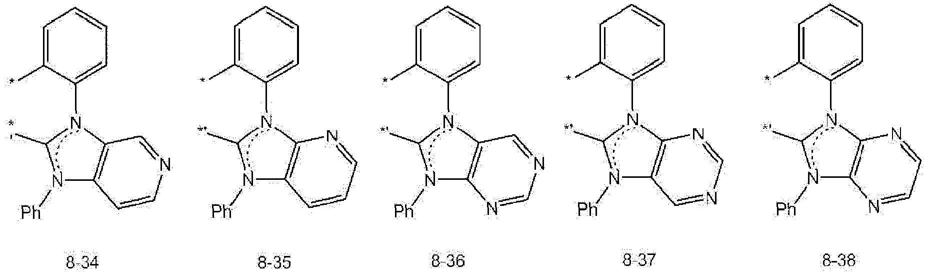

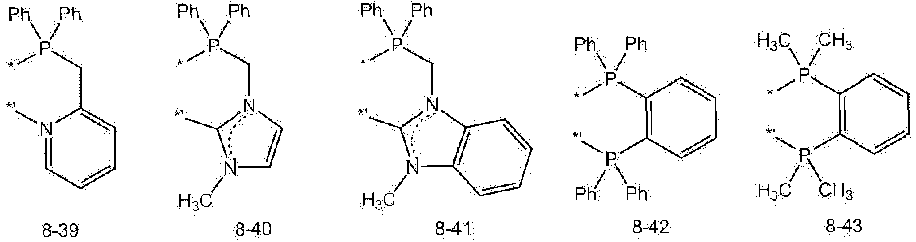

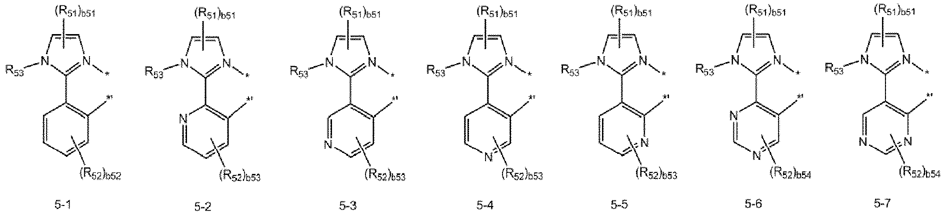

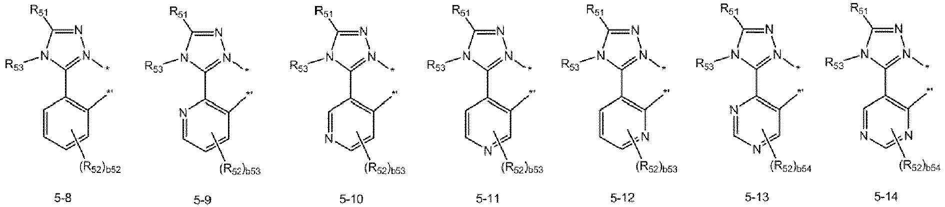

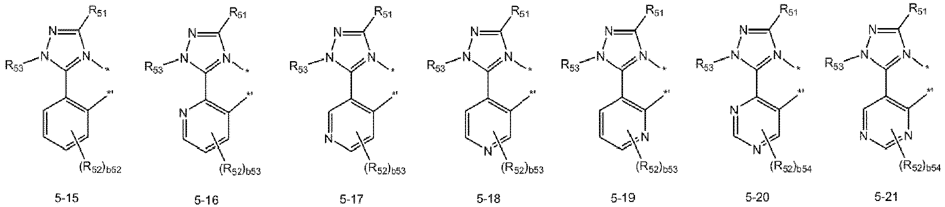

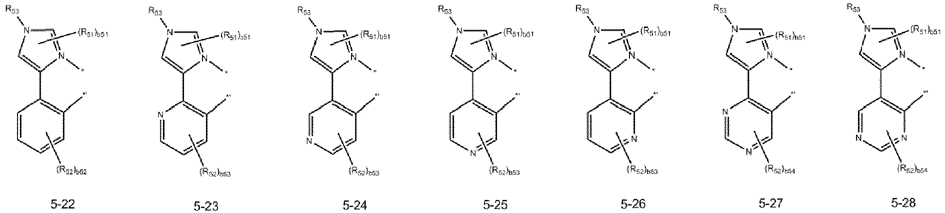

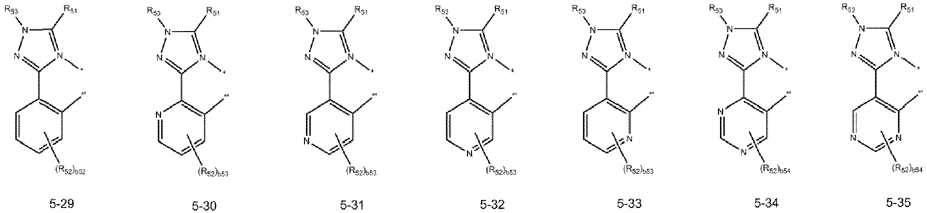

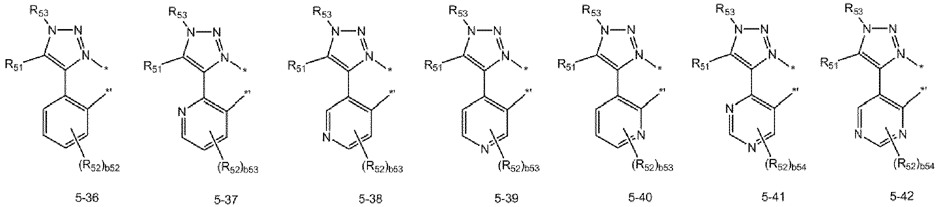

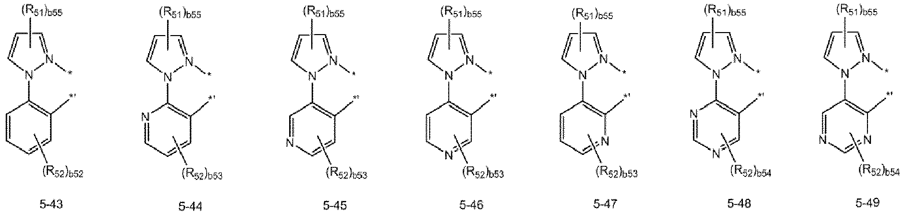

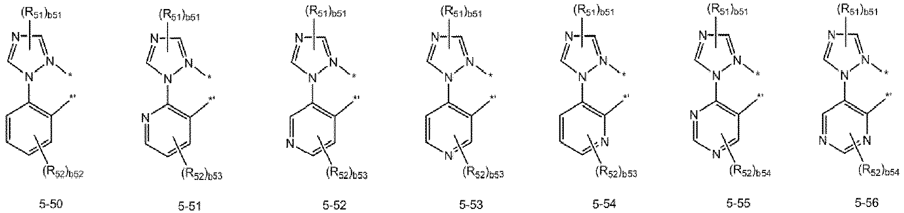

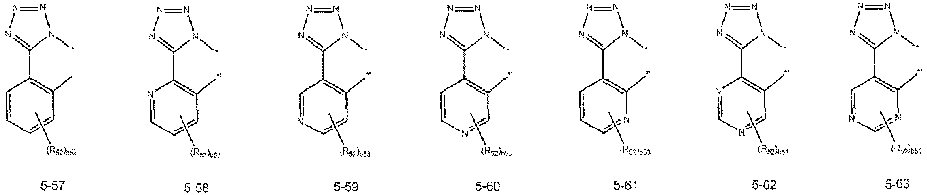

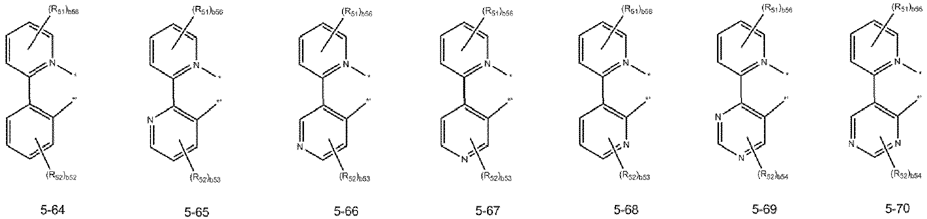

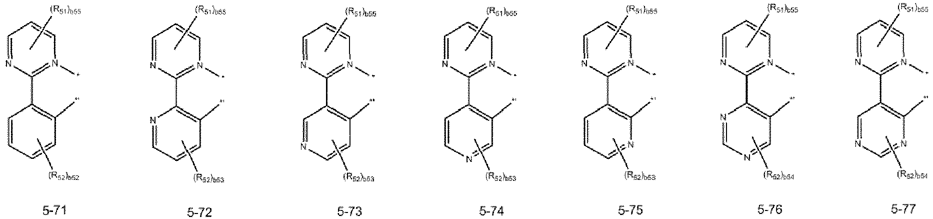

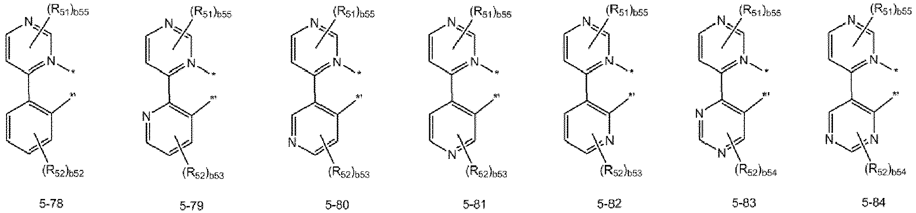

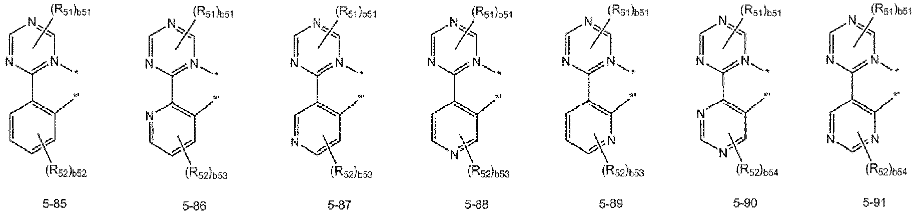

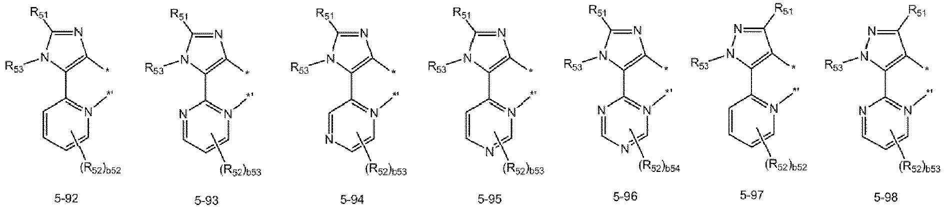

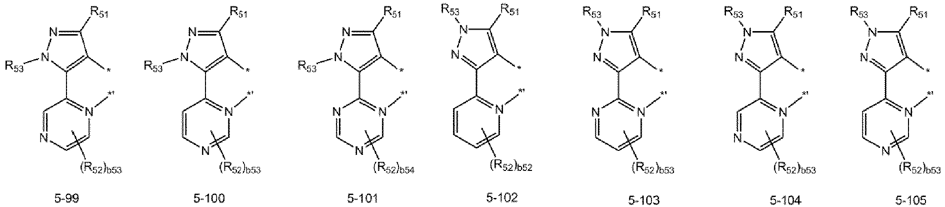

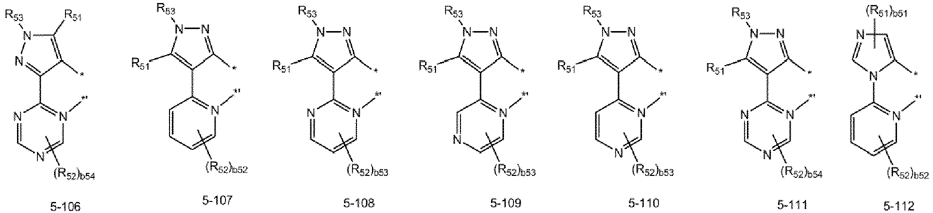

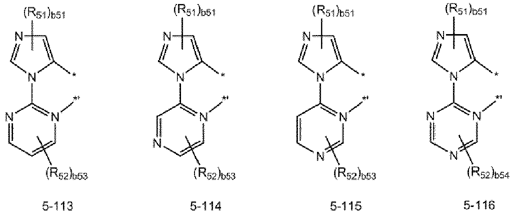

In Formulae 5-1 to 5-116 and 8-1 to 8-43,
R₅₁ to R₅₃ may each independently be selected from:
hydrogen, -F, a cyano group, a nitro group, a methyl group, an ethyl group, a propyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decanyl group, an isodecanyl group, a sec-decanyl group, a tert-decanyl group, a methoxy group, an ethoxy group, a propoxy group, a butoxy group, a pentoxy group, a phenyl group, a naphthyl group, a pyridinyl group, a pyrimidinyl group, a triazinyl group, a dibenzofuranyl group, and a dibenzothiophenyl group; and
a methyl group, an ethyl group, a propyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decanyl group, an isodecanyl group, a sec-decanyl group, a tert-decanyl group, a methoxy group, an ethoxy group, a propoxy group, a butoxy group, a pentoxy group, a phenyl group, a naphthyl group, a pyridinyl group, a pyrimidinyl group, a triazinyl group, a dibenzofuranyl group, and a dibenzothiophenyl group, each substituted with at least one selected from -F, a cyano group, and a nitro group,
b51 and b54 may each independently be selected from 1 and 2,
b53 and b55 may each independently be selected from 1, 2, and 3,
b52 may be selected from 1, 2, 3, and 4,
Ph indicates a phenyl group,
Ph-d5 indicates a phenyl group in which all hydrogen atoms are each independently substituted with deuterium, and
* and *' each independently indicates a binding site to a neighboring atom.

In Formula 1, n12 may be selected from 0, 1, 2, 3, and 4, wherein, when n12 is 2 or more, 2 or more L₁₂(s) are the same or different from each other.

For example, in Formula 1, n12 may be selected from 0, 1 and 2, but embodiments of the present disclosure are not limited thereto.

In one embodiment, in Formula 1, M₁₁ may be Ir, n11 may be selected from 2 and 3, and n12 may be selected from 0, 1, and 2, but embodiments of the present disclosure are not limited thereto.

In Formula 1, L₁₁ and L₁₂ may be different from each other.

In the organometallic compound represented by Formula 1, the following compound is excluded: 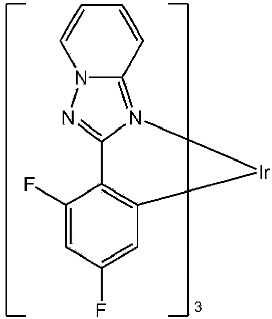 (hereinafter, referred to as Compound A).

In Compound A, since an -F substituent is decomposed at high temperature, stable device lifespan may not be implemented.

In one embodiment, the organometallic compound represented by Formula 1 may be represented by one selected from Formulae 1-1 and 1-2, but embodiments of the present disclosure are not limited thereto:

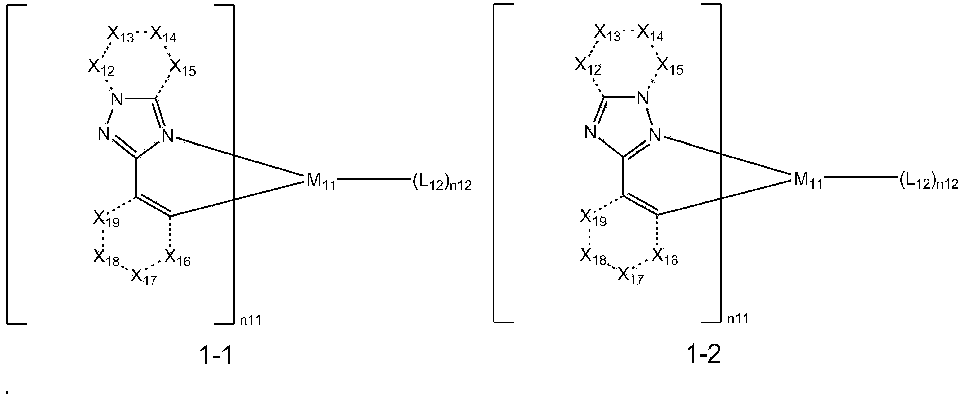

In Formulae 1-1 and 1-2,
M₁₁, n11, n12, and L₁₂ may each independently be the same as described in Formula 1,
X₁₂ may be selected from N, N(R₁₂ₐ), O, S, C(R₁₂ₐ), and C(R₁₂ₐ)(R_{12b}), X₁₃ may be selected from N, N(R₁₃ₐ), O, S, C(R₁₃ₐ), and C(R₁₃ₐ)(R_{13b}), X₁₄ may be selected from N, N(R₁₄ₐ), O, S, C(R₁₄ₐ), and C(R₁₄ₐ)(R_{14b}), X₁₅ may be selected from N, N(R₁₅ₐ), O, S, C(R₁₅ₐ), and C(R₁₅ₐ)(R_{15b}), X₁₆ may be selected from N, N(R₁₆ₐ), O, S, C(R₁₆ₐ), and C(R₁₆ₐ)(R_{16b}), X₁₇ may be selected from N, N(R₁₇ₐ), O, S, C(R₁₇ₐ), and C(R₁₇ₐ)(R_{17b}), X₁₈ may be selected from N, N(R₁₈ₐ), O, S, C(R₁₈ₐ), and C(R₁₈ₐ)(R_{18b}), and X₁₉ may be selected from N, N(R₁₉ₐ), O, S, C(R₁₉ₐ), and C(R₁₉ₐ)(R_{19b}), and
R₁₂ₐ, R_{12b}, R₁₃ₐ, R_{13b}, R₁₄ₐ, R_{14b}, R₁₅ₐ, R_{15b}, R₁₆ₐ, R_{16b}, R₁₇ₐ, R_{17b}, R₁₈ₐ, R_{18b}, R₁₉ₐ, and R_{19b} may each independently be the same as described in connection with R₁ in Formula 1A.

For example, in Formulae 1-1 and 1-2, X₁₂ may be selected from N and C(R₁₂ₐ), X₁₃ may be selected from N and C(R₁₃ₐ), X₁₄ may be selected from N and C(R₁₄ₐ), X₁₅ may be selected from N and C(R₁₅ₐ), X₁₆ may be selected from N and C(R₁₆ₐ), X₁₇ may be selected from N and C(R₁₇ₐ), X₁₈ may be selected from N and C(R₁₈ₐ), and X₁₉ may be selected from N and C(R₁₉ₐ), but embodiments of the present disclosure are not limited thereto. In this case, in Formula 1-1, a bond between N and X₁₂, a bond between X₁₃ and X₁₄, and a bond between X₁₅ and C may each be a single bond, and a bond between X₁₂ and X₁₃ and a bond between X₁₄ and X₁₅ may each be a double bond, but embodiments of the present disclosure are not limited thereto. In this case, in Formula 1-2, a bond between C and X₁₂, a bond between X₁₃ and X₁₄, and a bond between X₁₅ and N may each be a single bond, and a bond between X₁₂ and X₁₃ and a bond between X₁₄ and X₁₅ may each be a double bond, but embodiments of the present disclosure are not limited thereto. In one embodiment, in Formulae 1-1 and 1-2, X₁₂ may be C(R₁₂ₐ), X₁₃ may be C(R₁₃ₐ), X₁₄ may be C(R₁₄ₐ), and X₁₅ may be C(R₁₅ₐ), but embodiments of the present disclosure are not limited thereto. In this case, in Formula 1-1, a bond between N and X₁₂, a bond between X₁₃ and X₁₄, and a bond between X₁₅ and C may each be a single bond, and a bond between X₁₂ and X₁₃ and a bond between X₁₄ and X₁₅ may each be a double bond, but embodiments of the present disclosure are not limited thereto. In this case, in Formula 1-2, a bond between C and X₁₂, a bond between X₁₃ and X₁₄, and a bond between X₁₅ and N may each be a single bond, and a bond between X₁₂ and X₁₃ and a bond between X₁₄ and X₁₅ may each be a double bond, but embodiments of the present disclosure are not limited thereto. In one embodiment, in Formulae 1-1 and 1-2, at least one selected from X₁₂ to X₁₅ may be selected from O and S, but embodiments of the present disclosure are not limited thereto.

For example, in Formulae 1-1 and 1-2, X₁₆ may be N, X₁₇ may be C(R₁₇ₐ), X₁₈ may be C(R₁₈ₐ), and X₁₉ may be C(R₁₉ₐ); X₁₆ may be C(R₁₆ₐ), X₁₇ may be N, X₁₈ may be C(R₁₈ₐ), and X₁₉ may be C(R₁₉ₐ); X₁₆ may be C(R₁₆ₐ), X₁₇ may be C(R₁₇ₐ), X₁₈ may be N, and X₁₉ may be C(R₁₉ₐ); X₁₆ may be C(R₁₆ₐ), X₁₇ may be C(R₁₇ₐ), X₁₈ may be C(R₁₈ₐ), and X₁₉ may be N; or X₁₆ may be C(R₁₆ₐ), X₁₇ may be C(R₁₇ₐ), X₁₈ may be C(R₁₈ₐ), and X₁₉ may be C(R₁₉ₐ), but embodiments of the present disclosure are not limited thereto. In this case, in Formulae 1-1 and 1-2, a bond between X₁₆ and X₁₇ and a bond between X₁₈ and X₁₉ may each be a double bond, and a bond between C and X₁₆, a bond between C and X₁₉, and a bond between X₁₇ and X₁₈ may each be a single bond, but embodiments of the present disclosure are not limited thereto.

In one embodiment, the organometallic compound represented by Formula 1 may be represented by one selected from Formulae 1-11 and 1-12, but embodiments of the present disclosure are not limited thereto:

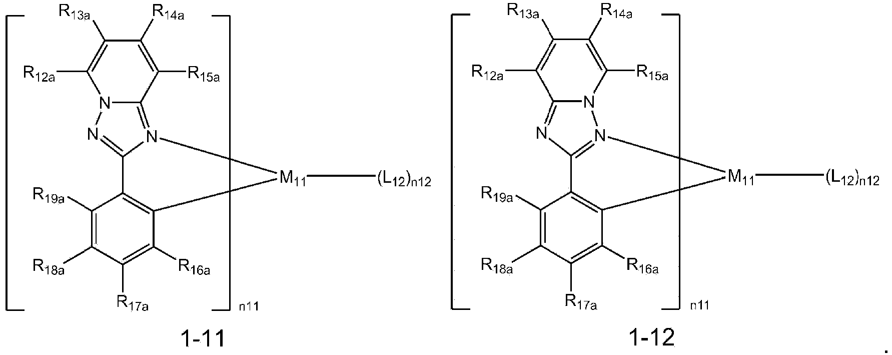

In Formulae 1-11 and 1-12,
M₁₁, n11, n12, and L₁₂ may each independently be the same as described in Formula 1, and
R₁₂ₐ, R₁₃ₐ, R₁₄ₐ, R₁₅ₐ, R₁₆ₐ, R₁₇ₐ, R₁₈ₐ, and R₁₉ₐ may each independently be defined the same as R₁ in Formula 1A.

The organometallic compound represented by Formula 1 may be selected from Compounds 1 to 16, but embodiments of the present disclosure are not limited thereto: 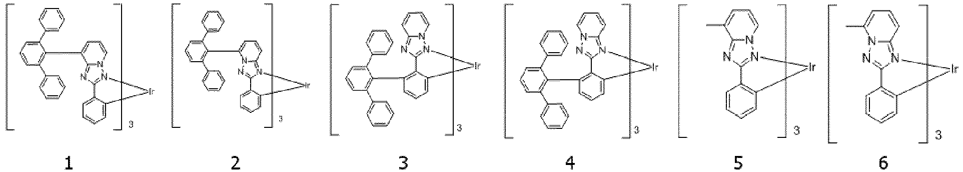 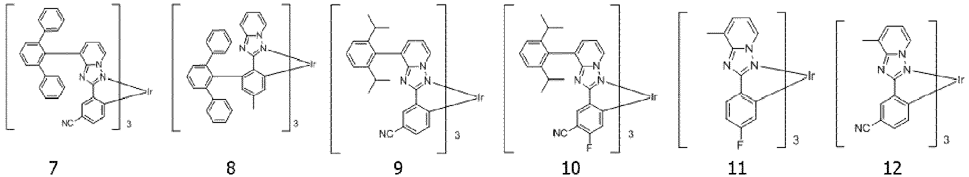 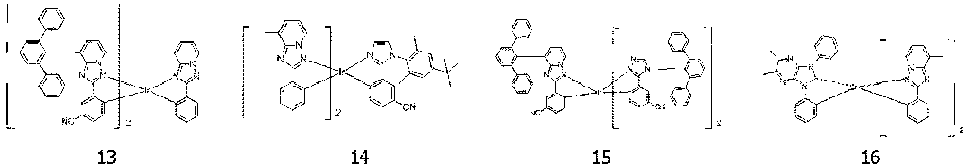 The organometallic compound represented by Formula 1 may have a maximum emission wavelength (actually measured value) of about 400 nm to 520 nm, for example, about 440 nm to about 480 nm. When the maximum emission wavelength is about 440 nm to about 480 nm, an organic light-emitting device that emits deep blue light may be provided.

Since the organometallic compound represented by Formula 1 essentially includes a 6-membered ring having Y₁₁, Y₁₂, and X₁₂ to X₁₅, a conjugated system increases as compared with a relatively unstable triazole 5-membered ring, thereby improving electrochemical stability. In addition, it is general that, when the conjugated system increases, a T₁ energy level is reduced. However, when a nitrogen atom (N) is introduced at a specific position, stability increases while a high T₁ energy level is maintained. Therefore, an organic light-emitting device including the organometallic compound represented by Formula 1 may improve a lifespan while maintaining a high T₁ energy level.

On the other hand, for example, when the organometallic compound represented by Formula 1 does not include the 6-membered ring having Y₁₁, Y₁₂, and X₁₂ to X₁₅ and includes the triazole 5-membered ring as a main ligand, a low T₁ energy level of not a blue range but a green range is exhibited. For example, when acetylacetonate (acac) having a weak bonding force is used as an auxiliary ligand, electrochemical and physical stability becomes poor.

In contrast, the organometallic compound represented by Formula 1 exhibits a high T₁ energy level of a blue range by introducing the nitrogen atom (N) as described above, and has an effect of increasing electrochemical and physical stability due to the increased conjugated system. Therefore, an organic light-emitting device including the organometallic compound represented by Formula 1 may increase a lifespan while maintaining a high T₁ energy level.

In addition, in the organometallic compound represented by Formula 1, since W₁₁ is selected from N and N(R₁₁),chemical and/or physical stability of the organometallic compound represented by Formula 1 may be improved. Therefore, the lifespan of the organic light-emitting device including the organometallic compound represented by Formula 1 may be improved.

In addition, when the organometallic compound represented by Formula 1 further includes an additional substituent in the 6-membered ring having Y₁₁, Y₁₂, and X₁₂ to X₁₅ and/or the 6-membered ring having Z₁₂, Z₁₃, and X₁₆ to X₁₉, blue light may be provided. When the organometallic compound represented by Formula 1 further includes the additional substituent, the organometallic compound may have a high triplet energy level due to a wider band gap, thereby providing deep blue light.

Therefore, the organometallic compound represented by Formula 1 may have a triplet energy level suitable for blue light and have improved chemical and/or physical stability. Therefore, the organic light-emitting device including the organometallic compound represented by Formula 1 may provide improved color purity and lifespan.

The HOMO energy level, LUMO energy level, and T1 energy level of some Compounds and Compounds A to C in the organometallic compound represented by Formula 1 were evaluated by using Gaussian 09 program accompanying a molecular structure optimization by a B3LYP-based density functional theory (DFT) (structurally optimized at a level of B3LYP, 6-31G(d,p)), and results thereof are shown in Table 1.

**[Table 1]**

| Compound No. | HOMO (eV) | LUMO (eV) | T₁(eV) |
|---|---|---|---|
| 1 | -4.89 | -1.36 | 2.76 |
| A | -5.30 | -1.68 | 2.69 |
| B | -4.36 | -0.76 | 2.65 |
| C | -4.49 | -1.16 | 2.44 |

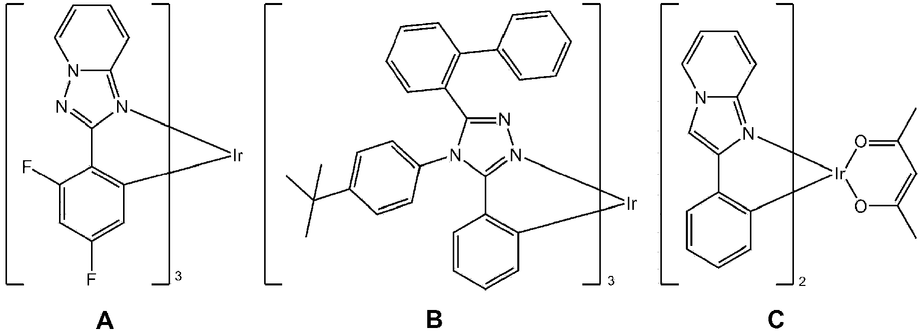

From Table 1, it is confirmed that the organometallic compound represented by Formula 1 has such electric characteristics that are suitable for use in an electric device, for example, for use as a dopant for an organic light-emitting device.

Synthesis methods of the organometallic compound represented by Formula 1 may be recognizable by one of ordinary skill in the art by referring to Synthesis Examples provided.

The organometallic compound represented by Formula 1 is suitable for use in an organic layer of an organic light-emitting device, for example, for use as a dopant in an emission layer of the organic layer. Thus, another aspect provides an organic light-emitting device that includes: a first electrode; a second electrode; and an organic layer that is disposed between the first electrode and the second electrode and includes an emission layer; and the organic layer includes at least one organometallic compound represented by Formula 1.

The organic light-emitting device may have, due to the inclusion of an organic layer including the organometallic compound represented by Formula 1, a low driving voltage, high efficiency, high power, high quantum efficiency, a long lifespan, a low roll-off ratio, and excellent color purity.

The organometallic compound of Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 is smaller than an amount of the host). In this regard, the dopant may emit blue light.

The expression "(an organic layer) includes at least one organometallic compound" used herein may include a case in which "(an organic layer) includes identical compounds represented by Formula 1" and a case in which "(an organic layer) includes two or more different organometallic compounds represented by Formula 1."

For example, the organic layer may include, as the organometallic compound, only Compound 1. In this regard, Compound 1 may exist in an emission layer of the organic light-emitting device. In one or more embodiments, the organic layer may include, as the organometallic compound, Compound 1 and Compound 2. In this regard, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one embodiment, in the organic light-emitting device, the first electrode is an anode, and the second electrode is a cathode, and the organic layer further includes a hole transport region between the first electrode and the emission layer and an electron transport region between the emission layer and the second electrode, and the hole transport region includes at least one selected from a hole injection layer, a hole transport layer, and an electron blocking layer, and the electron transport region includes at least one selected from a hole blocking layer, an electron transport layer, and an electron injection layer.

The term "organic layer" as used herein refers to a single layer and/or a plurality of layers between the first electrode and the second electrode of the organic light-emitting device. The "organic layer" may include, in addition to an organic compound, an organometallic compound including metal.

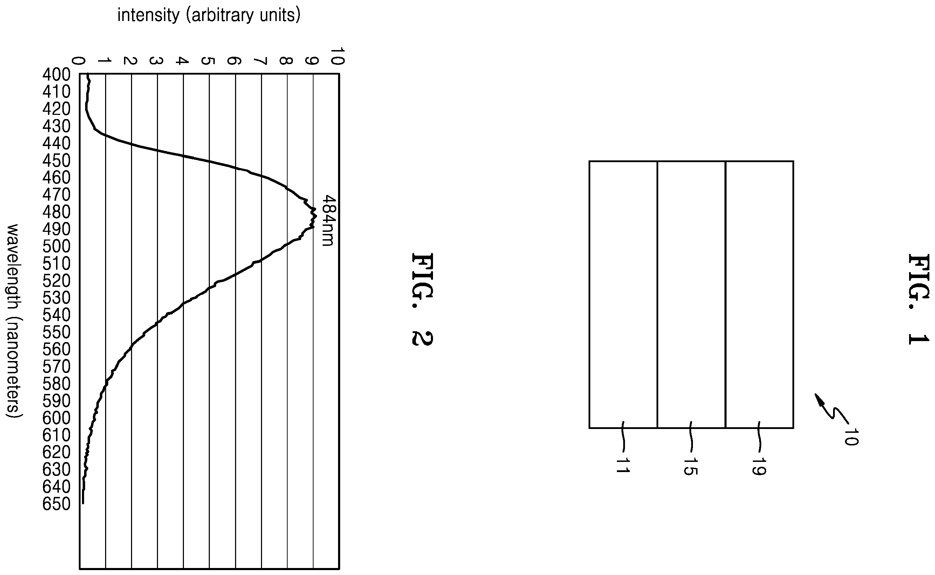

FIG. 1 is a schematic view of an organic light-emitting device 10 according to an embodiment. Hereinafter, the structure of an organic light-emitting device according to an embodiment and a method of manufacturing an organic light-emitting device according to an embodiment will be described in connection with FIG. 1. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

In one or more embodiments, the first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include at least one selected from a hole injection layer, a hole transport layer, an electron blocking layer, and a buffer layer.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 □ to about 500 □, a vacuum pressure of about 10⁻⁸ to about 10⁻³ torr, and a deposition rate of about 0.01 Å/sec to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80□ to about 200□. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonicacid (PANI/CSA), polyaniline/poly(4-styrenesulfonate) (PANI/PSS), a compound represented by Formula 201, and a compound represented by Formula 202:

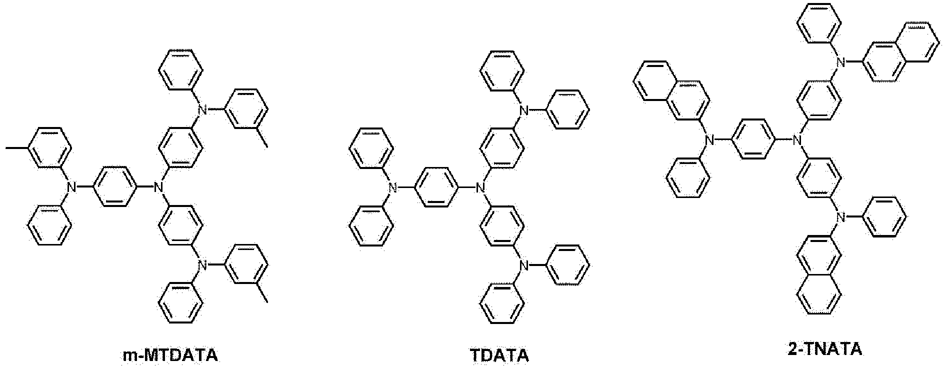

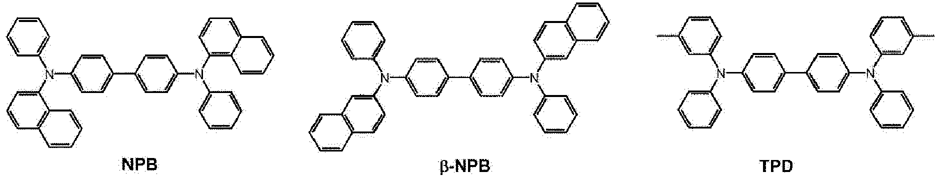

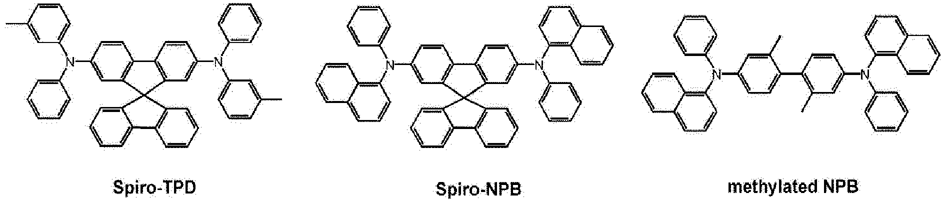

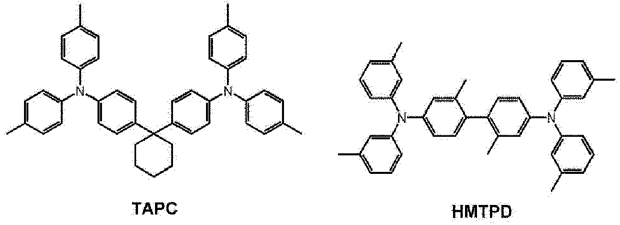

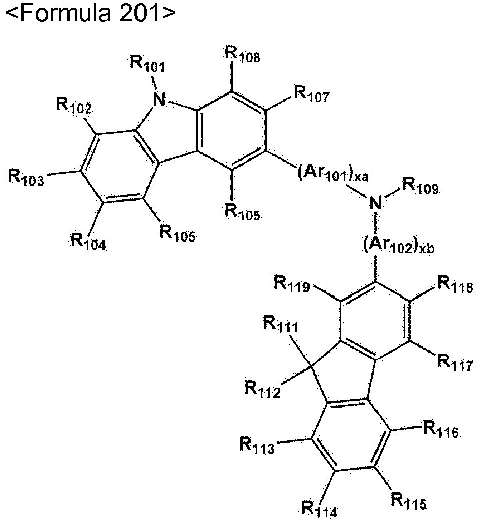

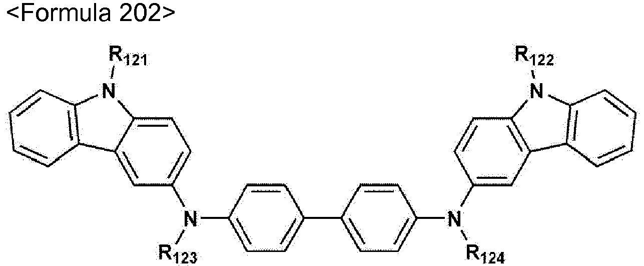

Ar₁₀₁ and Ar₁₀₂ in Formula 201 may each independently be selected from:
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, and a pentacenylene group; and
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, and a pentacenylene group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

In Formula 201, xa and xb may each independently be an integer from 0 to 5, or 0, 1 or 2. For example, xa may be 1 and xb may be 0, but xa and xb are not limited thereto.

In Formulae 201 and 202, R₁₀₁ to R₁₀₈, R₁₁₁ to R₁₁₉, and R₁₂₁ to R₁₂₄ may each independently be selected from:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, a hexyl group, and the like), and a C₁-C₁₀ alkoxy group (for example, a methoxy group, an ethoxy group, a propoxy group, a butoxy group, a pentoxy group, and the like);
a C₁-C₁₀ alkyl group and a C₁-C₁₀ alkoxy group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a phenyl group, a naphthyl group, an anthracenyl group, a fluorenyl group, or a pyrenyl group; or
a phenyl group, a naphthyl group, an anthracenyl group, a fluorenyl group, and a pyrenyl group, each substituted with at least one selected from deuterium, -F, - CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, and a C₁-C₁₀ alkoxy group, but embodiments of the present disclosure are not limited thereto.

In Formula 201, R₁₀₉ may be selected from:
a phenyl group, a naphthyl group, an anthracenyl group, and a pyridinyl group; and
a phenyl group, a naphthyl group, an anthracenyl group, and a pyridinyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, and a pyridinyl group.

In one embodiment, the compound represented by Formula 201 may be represented by Formula 201A, but embodiments of the present disclosure are not limited thereto:

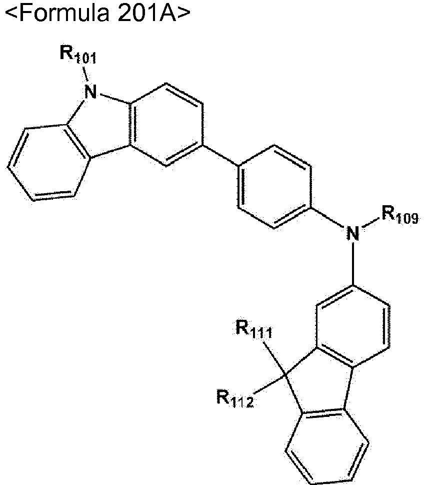

In Formula 201A, R₁₀₁, R₁₁₁, R₁₁₂, and R₁₀₉ may each independently be defined the same as described above.

For example, the compound represented by Formula 201, and the compound represented by Formula 202 may include compounds HT1 to HT20 illustrated, but are not limited thereto.

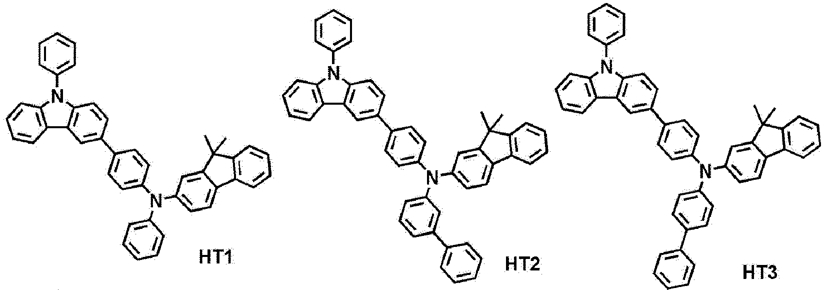

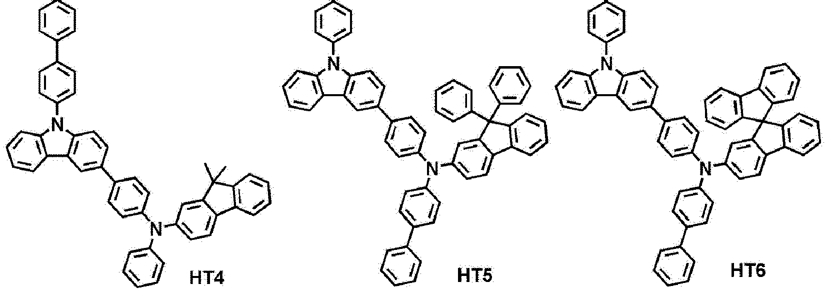

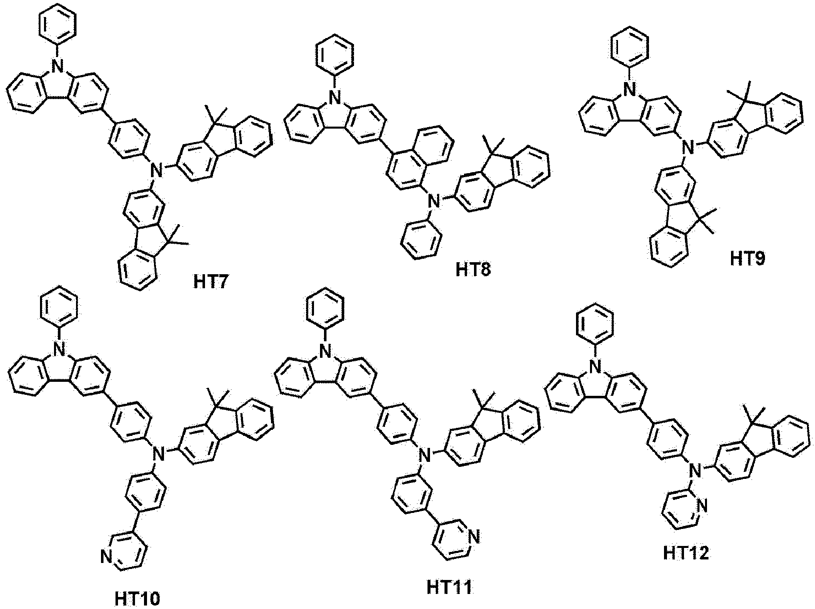

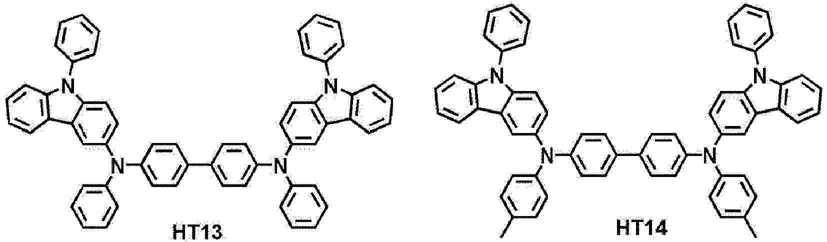

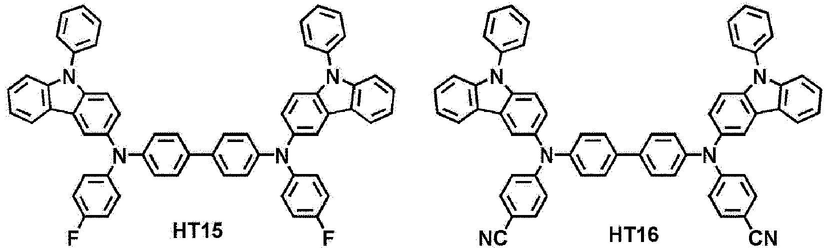

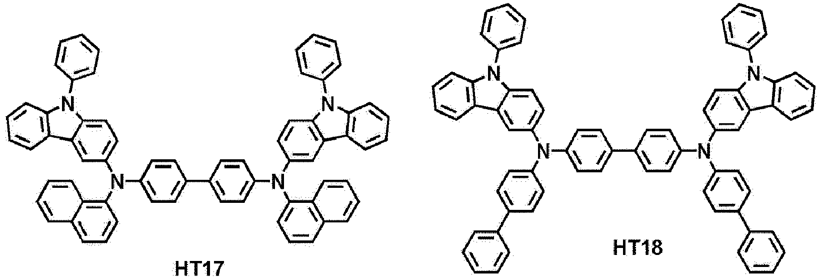

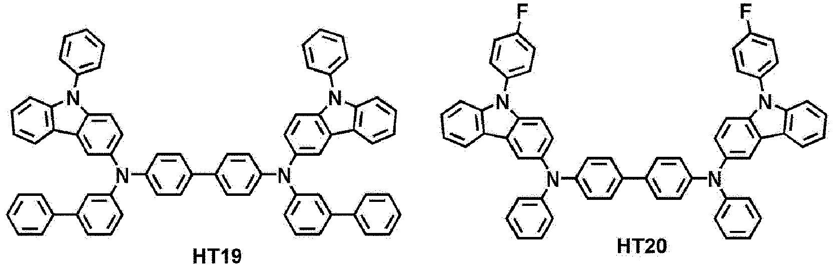

A thickness of the hole transport region may be in a range of about 100 Å to about 10,000 Å, for example, about 100 Å to about 1,000 Å. When the hole transport region includes both a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 or Compound HT-D2, but are not limited thereto.

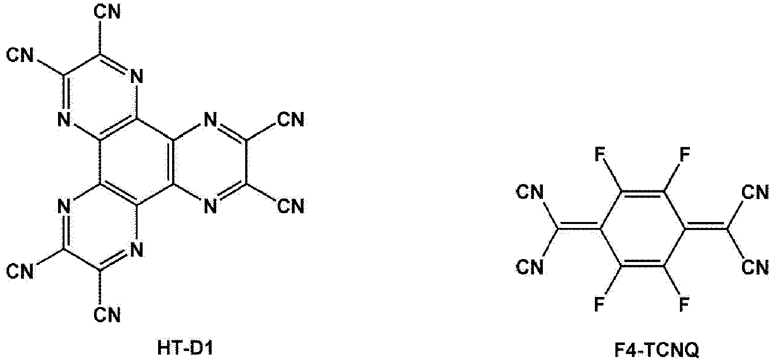

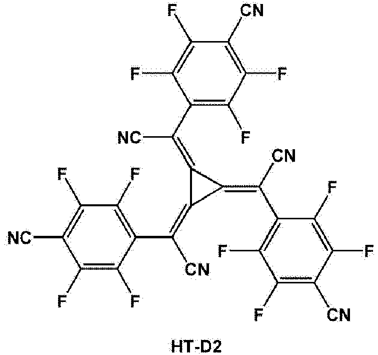

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later. The emission layer may include a host and a dopant, and the dopant may include the organometallic compound represented by Formula 1.

The host may include at least one selected from TPBi, TBADN, ADN (also referred to as "DNA"), CBP, CDBP, TCP, mCP, Compound H50, to Compound H52:

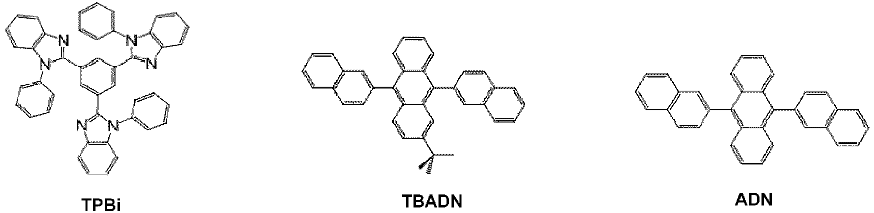

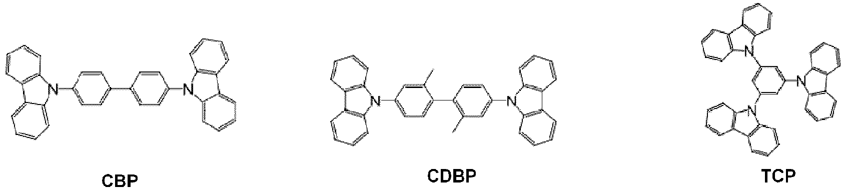

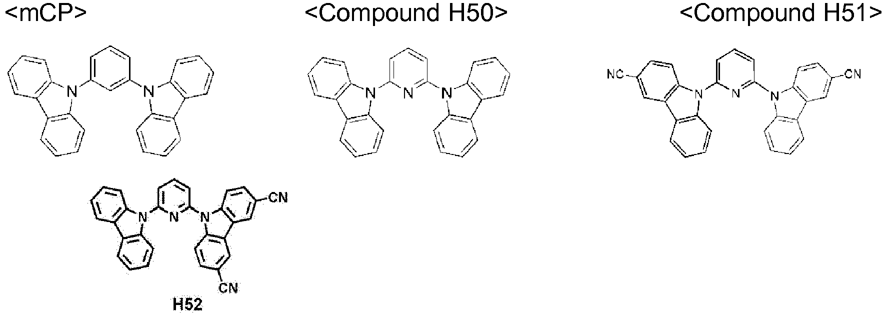

In one or more embodiments, the host may further include a compound represented by Formula 301.

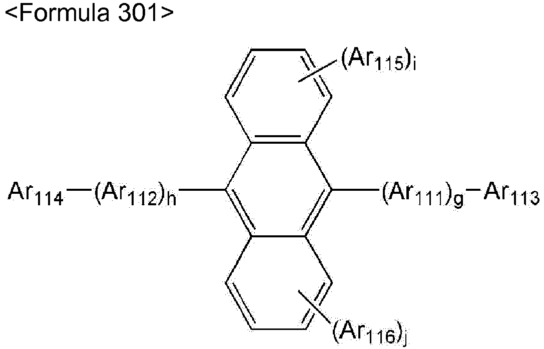

Ar₁₁₁ and Ar₁₁₂ in Formula 301 may each independently be selected from:
a phenylene group, a naphthylene group, a phenanthrenylene group, and a pyrenylene group; and
a phenylene group, a naphthylene group, a phenanthrenylene group, and a pyrenylene group, each substituted with at least one selected from a phenyl group, a naphthyl group, and an anthracenyl group.

Ar₁₁₃ to Ar₁₁₆ in Formula 301 may each independently be selected from:
a C₁-C₁₀ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.

In Formula 301, g, h, i, and j may each independently be an integer from 0 to 4, and may be, for example, 0, 1, or 2.

In Formula 301, Ar₁₁₃ and Ar₁₁₆ may each independently be selected from:
a C₁-C₁₀ alkyl group substituted with at least one selected from a phenyl group, a naphthyl group, and an anthracenyl group;
a phenyl group, a naphthyl group, an anthracenyl group, a pyrenyl, a phenanthrenyl group, and a fluorenyl group;
a phenyl group, a naphthyl group, an anthracenyl group, a pyrenyl group, a phenanthrenyl group, and a fluorenyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a phenyl group, a naphthyl group, an anthracenyl group, a pyrenyl group, a phenanthrenyl group, and a fluorenyl group; and 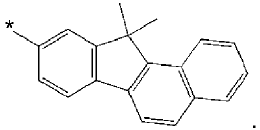 but embodiments of the present disclosure are not limited thereto.

In one or more embodiments, the host may include a compound represented by Formula 302:

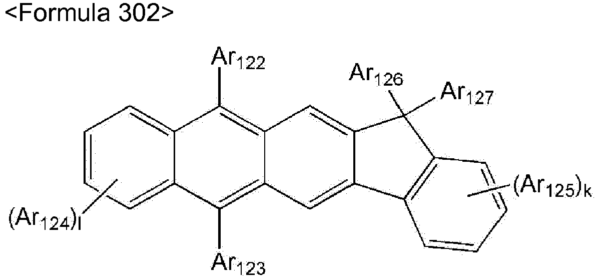

In Formula 302, Ar₁₂₂ to Ar₁₂₅ may each independently be defined the same as Ar₁₁₃ in Formula 301.

Iin Formula 302, Ar₁₂₆ and Ar₁₂₇ may each independently be a C₁-C₁₀ alkyl group (for example, a methyl group, an ethyl group, or a propyl group).

In Formula 302, k and I may each independently be an integer from 0 to 4. For example, k and I may be 0, 1, or 2.

The compound represented by Formula 301 and the compound represented by Formula 302 may include Compounds H1 to H42, but are not limited thereto.

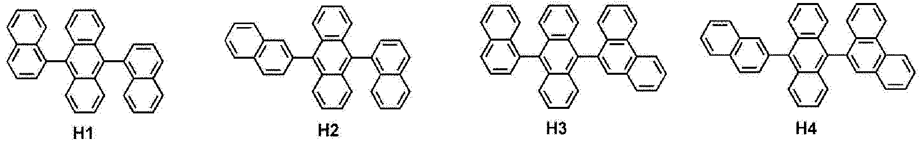

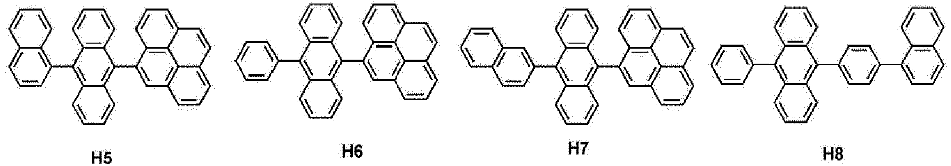

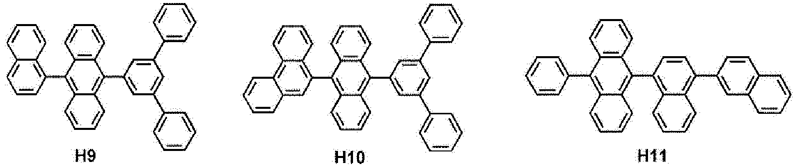

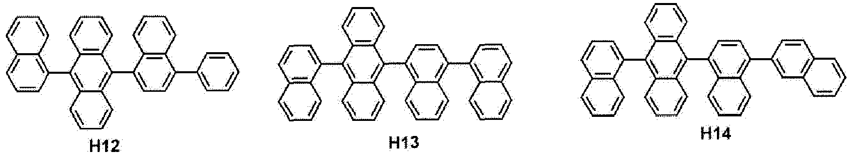

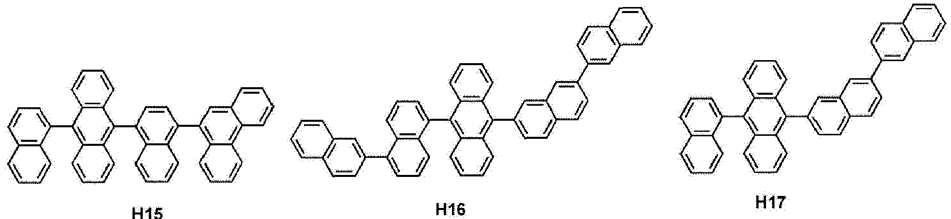

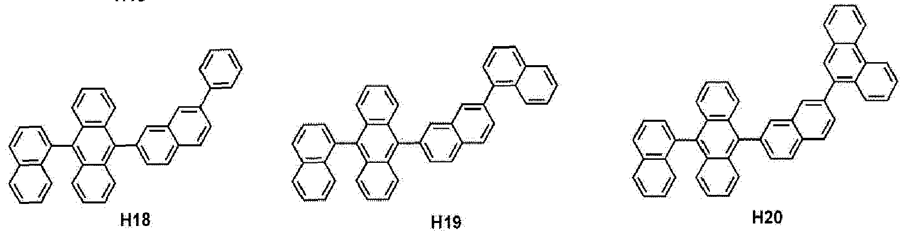

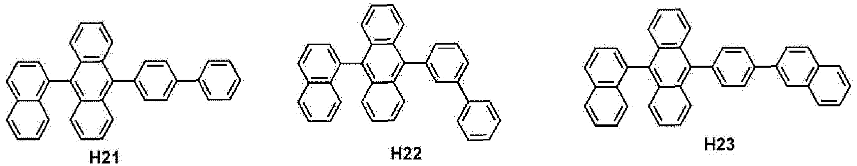

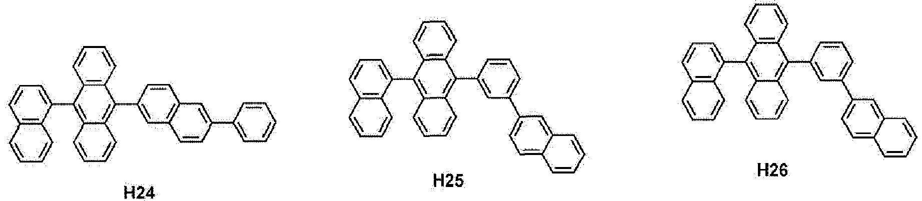

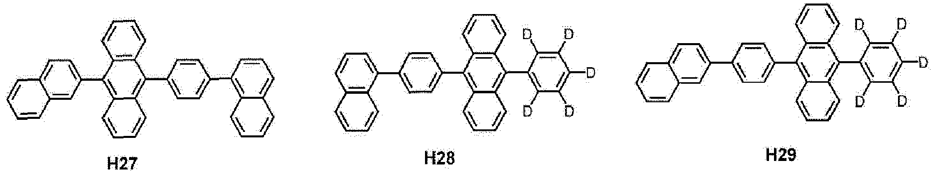

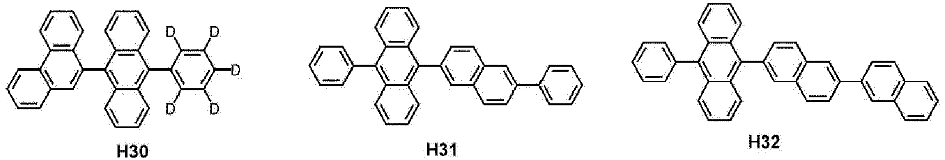

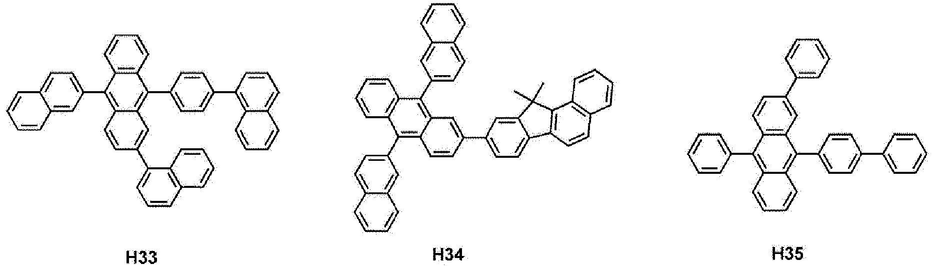

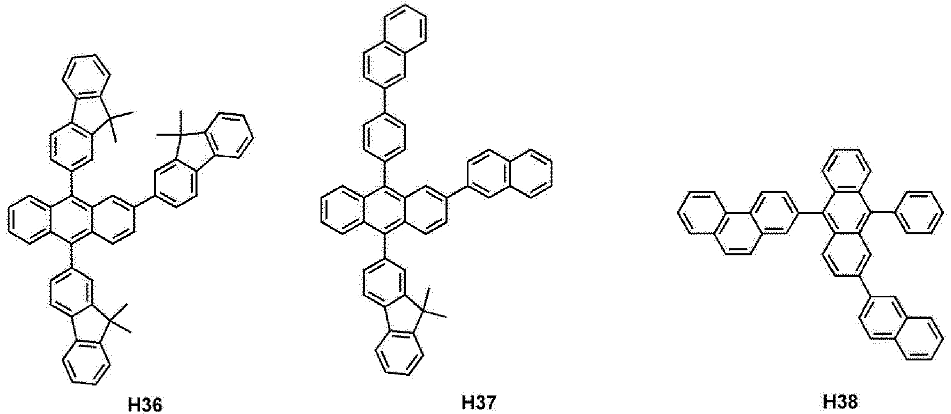

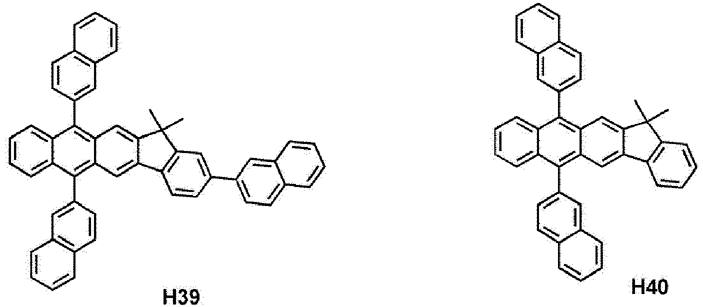

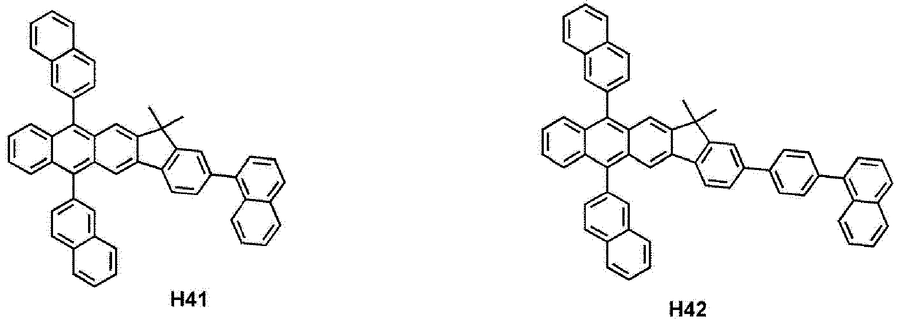

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and a dopant, an amount of the dopant may be typically in a range of about 0.01 parts by weight to about 15 parts by weight based on 100 parts by weight of the host, but embodiments of the present disclosure are not limited thereto.

The dopant may include at least one of organometallic compounds represented by Formula 1.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

Then, an electron transport region may be disposed on the emission layer.

The electron transport region may include at least one selected from a hole blocking layer, an electron transport layer, and an electron injection layer.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq but embodiments of the present disclosure are not limited thereto.

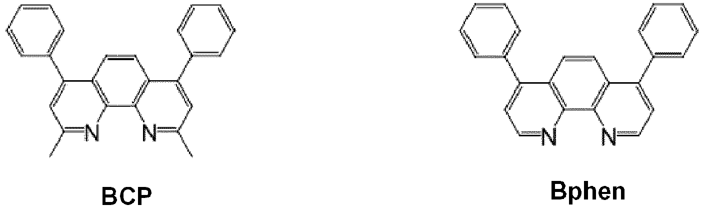

A thickness of the hole blocking layer may be in a range of about 20 Å to about 1,000 Å, for example, about 30 Å to about 300 Å. When the thickness of the hole blocking layer is within these ranges, the hole blocking layer may have excellent hole blocking characteristics without a substantial increase in driving voltage.

The electron transport layer may further include, in addition to the organometallic compound represented by Formula 1, at least one selected from BCP, Bphen, Alq₃, BAlq, TAZ, and NTAZ.

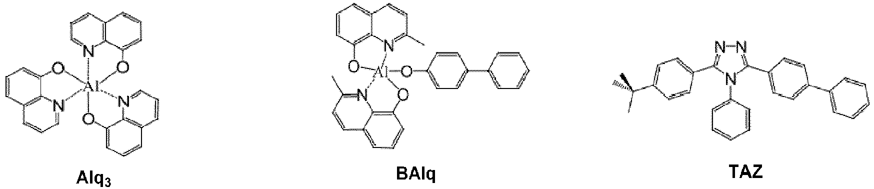

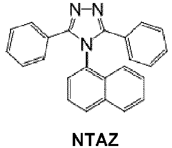

In one or more embodiments, the electron transport layer may include at least one of ET1 to ET25, but are not limited thereto:

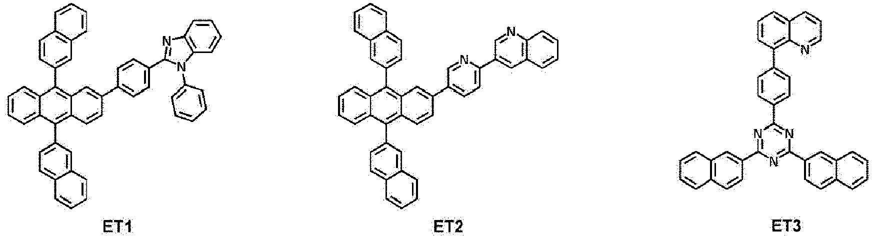

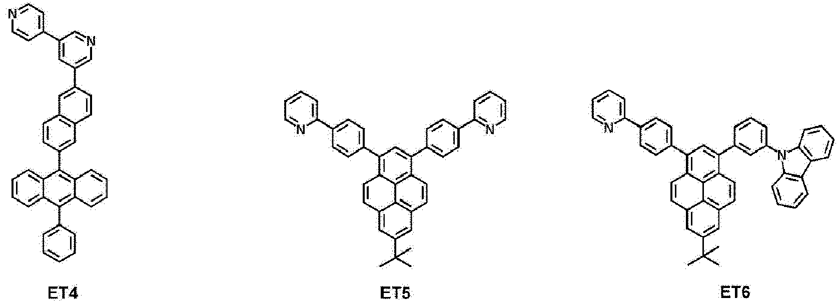

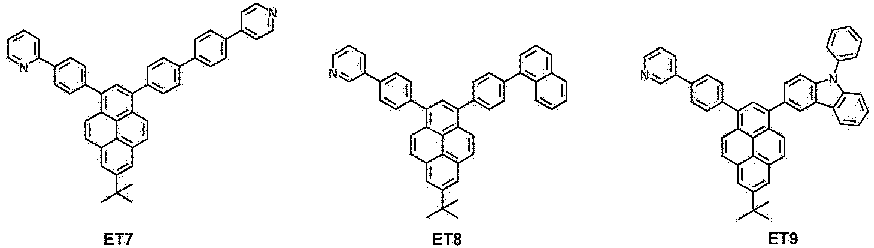

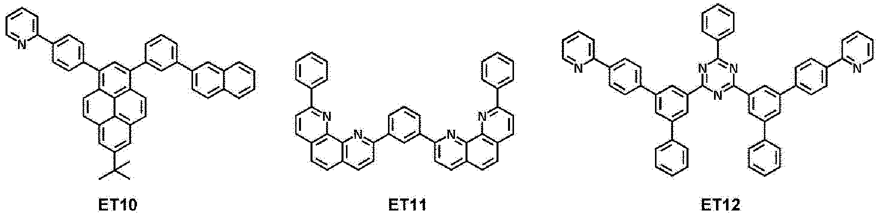

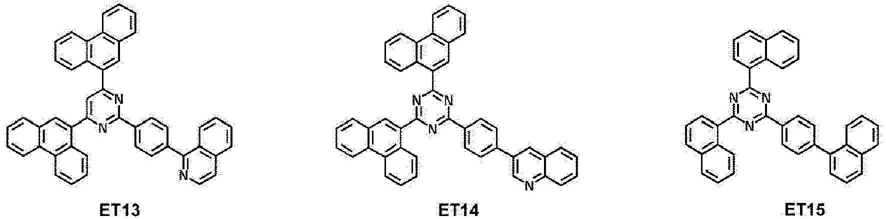

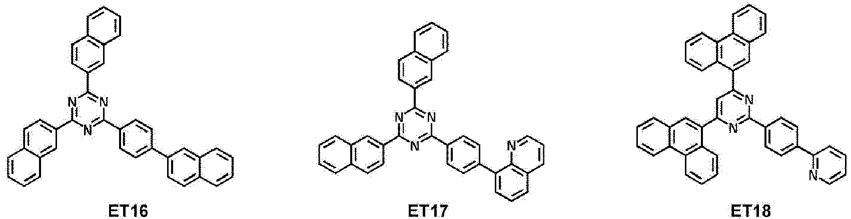

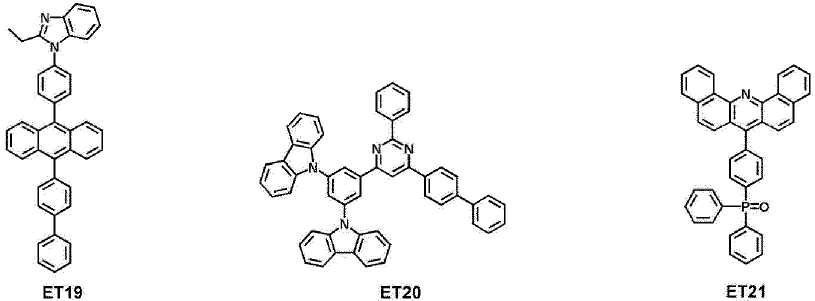

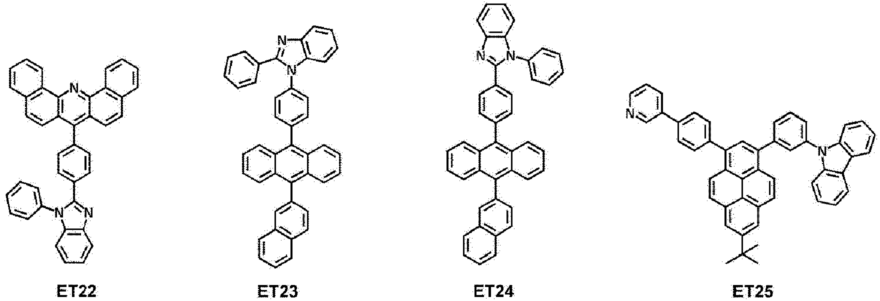

A thickness of the electron transport layer may be in a range of about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium quinolate, LiQ) or ET-D2.

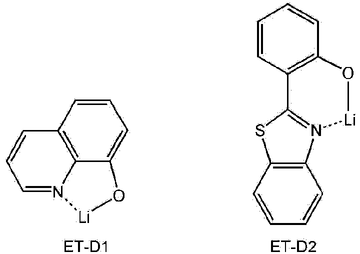

The electron transport region may include an electron injection layer (EIL) that promotes flow of electrons from the second electrode 19 thereinto.

The electron injection layer may include at least one selected from LiF, NaCl, CsF, Li₂O, and BaO.

A thickness of the electron injection layer may be in a range of about 1 Å to about 100 Å, for example, about 3 Å to about 90 Å. When the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be formed as the material for forming the second electrode 19. To manufacture a top-emission type light-emitting device, a transmissive electrode formed using ITO or IZO may be used as the second electrode 19.

Hereinbefore, the organic light-emitting device has been described with reference to FIG. 1, but embodiments of the present disclosure are not limited thereto.

The term "first-row transition metal of the Periodic Table of Elements" as used herein refers to an element of the Period 4 of the Periodic Table of Elements and belonging to a d-block, and examples thereof include scandium (Sc), titanium (Ti), vanadium (V), chromium (Cr), manganese (Mn), iron (Fe), cobalt (Co), nickel (Ni), copper (Cu), and zinc (Zn).

The term "second-row transition metal of the Periodic Table of Elements" as used herein refers to an element of the Period 5 of the Periodic Table of Elements and belonging to a d-block, and examples thereof include yttrium (Y), zirconium (Zr), niobium (Nb), molybdenum (Mo), technetium (Tc), ruthenium (Ru), rhodium (Rh), palladium (Pd), silver (Ag), and cadmium (Cd).

The term "third-row transition metal of the Periodic Table of Elements" as used herein refers to an element of the Period 6 and belonging to a d-block, and examples thereof include lanthanum (La), samarium (Sm), europium (Eu), terbium (Tb), thulium (Tm), ytterbium (Yb), lutetium (Lu), hafnium (Hf), tantalum (Ta), tungsten(W), rhenium (Re), osmium (Os), iridium (Ir), platinum (Pt), gold (Au), and mercury (Hg).

The term "C₁-C₆₀ alkyl group" as used herein refers to a linear or branched saturated aliphatic hydrocarbon monovalent group having 1 to 60 carbon atoms, and examples thereof include a methyl group, an ethyl group, a propyl group, an isobutyl group, a sec-butyl group, a tert-butyl group, a pentyl group, an isoamyl group, and a hexyl group. The term "C₁-C₆₀ alkylene group" as used herein refers to a divalent group having the same structure as the C₁-C₆₀ alkyl group.

The term "C₁-C₆₀ alkoxy group" as used herein refers to a monovalent group represented by -OA₁₀₁ (wherein A₁₀₁ is the C₁-C₆₀ alkyl group), and examples thereof include a methoxy group, an ethoxy group, and an isopropyloxy group.

The term "C₂-C₆₀ alkenyl group" as used herein refers to a hydrocarbon group having at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group having at least one carbon-carbon triple bond in the middle or at the terminus of the C₂-C₆₀ alkyl group, and examples thereof include an ethynyl group, and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group," used herein, refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, P, Si, and S as a ring-forming atom, 1 to 10 carbon atoms, and at least one carbon-carbon double bond in its ring. Examples of the C₁-C₁₀ heterocycloalkenyl group are a 2,3-dihydrofuranyl group, and a 2,3-dihydrothiophenyl group. The term "C₁-C₁₀ heterocycloalkenylene group," used herein, refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₁-C₆₀ heteroaryl group" as used herein refers to a monovalent group having a cyclic aromatic system that has at least one heteroatom selected from N, O, P, Si, and S as a ring-forming atom, in addition to 1 to 60 carbon atoms. The term "C₁-C₆₀ heteroarylene group" as used herein refers to a divalent group having a heterocyclic aromatic system that has at least one heteroatom selected from N, O, P, Si, and S as a ring-forming atom, in addition to 1 to 60 carbon atoms. Examples of the C₁-C₆₀ heteroaryl group are a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other.

A C₆-C₆₀ aryloxy group used herein indicates -OA₁₀₂ (wherein A₁₀₂ is the C₆-C₆₀ aryl group), and a C₆-C₆₀ arylthio group indicates -SA₁₀₃ (wherein A₁₀₃ is the C₆-C₆₀ aryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The term "C₅-C₃₀ carbocyclic group" as used herein refers to a monocyclic group or a polycyclic group, and, according to its chemical structure, a monovalent, divalent, trivalent, tetravalent, pentavalent, or hexavalent group.

The term "C₁-C₃₀ heterocyclic group" as used herein refers to a saturated or unsaturated cyclic group having at least one heteroatom selected from N, O, Si, P, and S other than 1 to 30 carbon atoms, as a ring-forming atom. The term "C₁-C₃₀ heterocyclic group" as used herein refers to a monocyclic group or a polycyclic group, and, according to its chemical structure, a monovalent, divalent, trivalent, tetravalent, pentavalent, or hexavalent group.

The term "5-membered aromatic heteroring" as used herein refers to an aromatic ring having, as a ring-forming atom, at least one heteroatom selected from N, O, P, Si, and S other than 3 to 5 carbon atoms.

The term "5-membered non-aromatic ring" as used herein refers to a saturated or unsaturated ring having, as a ring-forming atom, 3 to 5 carbon atoms.

The term "5-membered non-aromatic heteroring" as used herein refers to a saturated or unsaturated ring having at least one heteroatom selected from N, O, P, Si, and S other than 3 to 5 carbon atoms, as a ring-forming atom.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be selected from:
deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -B(Q₁₆)(Q₁₇), and -P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, - F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), -B(Q₂₆)(Q₂₇), and -P(=O)(Q₂₈)(Q₂₉); and
-N(Q₃₁)(Q₃₂), -Si(Q₃₃)(Q₃₄)(Q₃₅), -B(Q₃₆)(Q₃₇), and -P(=O)(Q₃₈)(Q₃₉), and
Q₁ to Q₉, Q₁₁ to Q₁₉, Q₂₁ to Q₂₉, and Q₃₁ to Q₃₉ may each independently be selected from hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from a C₁-C₆₀ alkyl group, and a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

Hereinafter, a compound and an organic light-emitting device according to embodiments are described in detail with reference to Synthesis Example and Examples. However, the organic light-emitting device is not limited thereto. The wording "'B' was used instead of'A' " used in describing Synthesis Examples means that a molar equivalent of 'A' was identical to a molar equivalent of 'B'.

### [Examples]

### Synthesis Example 1: Synthesis of Compound 5

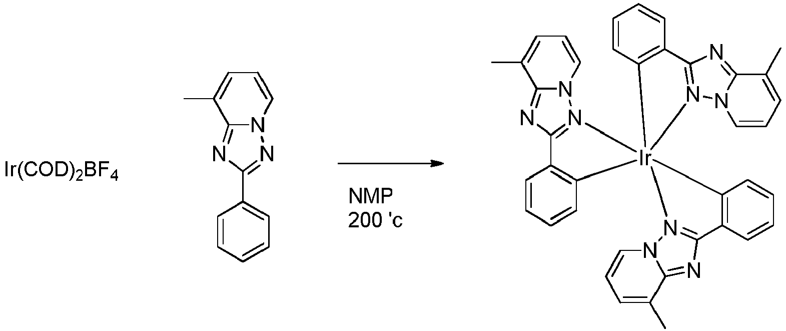

Ir(COD)₂BF₄ (5.32 mmol), a ligand (26.58 mmol), and N-methyl-2-pyrrolidone were added to a reaction container and refluxed for 12 hours in a nitrogen atmosphere. After the reaction was completed, the reaction product was cooled to room temperature and an organic layer was extracted therefrom by using dichloromethane and distilled water. The collected organic layer was washed twice by using distilled water and dried by using MgSO₄, and a solvent was removed therefrom. A crude product obtained therefrom was purified by silica gel column chromatography (eluent: dichloromethane and n-hexane) to obtain Compound 5 (0.32 mmol, yield: 6 %).
MALDI-TOF(m/z): 817.23 [M]⁺.

### Evaluation Example 1: Evaluation of HOMO, LUMO, and triplet (T₁) energy levels

A HOMO energy level a LUMO energy level, and T₁ energy level of Compound 5 were evaluated according to the methods of Table 2, and results thereof are shown in Table 3.

**[Table 2]**

| | |
|---|---|
| HOMO energy level evaluation method | A voltage-current (V-A) graph of each Compound was obtained by using a cyclic voltammetry (CV) (electrolyte: 0.1 M Bu₄NClO₄ / solvent: CH₂Cl₂ / electrode: 3-electrode system (work electrode: GC, reference electrode: Ag/AgCl, auxiliary electrode: Pt)), and a HOMO energy level of each Compound was calculated from reduction onset of the graph. |
| LUMO energy level evaluation method | Each compound was diluted at a concentration of 1x10⁻⁵ M in CHCl₃, and a UV absorption spectrum thereof was measured at room temperature by using a Shimadzu UV-350 spectrometer, and a LUMO energy level thereof was calculated by using an optical band gap (Eg) from an edge of the absorption spectrum. |
| T₁ energy level evaluation method | A mixture of toluene and each compound (each compound was dissolved in an amount of 1 mg in 3 mL of toluene) was loaded into a quartz cell, and then, the resultant quartz cell was loaded into liquid nitrogen (77 K). A photoluminescence (PL) spectrum thereof was measured by using a photoluminescence measurement device, and the obtained spectrum was compared with a PL spectrum measured at room temperature, and peaks observed only at low temperature were analyzed to calculate a T₁ energy level. |

**[Table 3]**

| Compound No. | HOMO (eV) | LUMO (eV) | T₁ (eV) |
|---|---|---|---|
| 5 | -5.38 | -2.54 | 2.58 |

Referring to Table 3, it is confirmed that Compound 5 has electric characteristics suitable for use as a material for an organic light-emitting device.

### Evaluation Example 2: Evaluation of PL spectrum

The PL spectrum of Compound 5 was evaluated so as to evaluate the light-emitting characteristics of each Compound. Compound 5 was diluted at a concentration of 10 mM in CHCl₃, and the PL spectrum thereof was measured at room temperature by using ISC PC1 Spectrofluorometer equipped with a xenon lamp. The maximum wavelength of the PL spectrum of Compound 5 is shown in Table 4 and FIG. 2.

**[Table 4]**

| Compound No. | λₘₐₓ (nm) |
|---|---|
| 5 | 484 |

Referring to Table 4, it is confirmed that Compound 5 has PL characteristics suitable for emission of deep blue light.

### Example 1

A glass substrate, on which a 1,500 Å ITO electrode (first electrode, anode) was formed, was washed with distilled water ultrasonic waves. When the washing with distilled water was completed, sonification washing was performed by using a solvent, such as isopropyl alcohol, acetone, or methanol. The result was dried and then transferred to a plasma washer, and the resultant substrate was washed with oxygen plasma for 5 minutes and then, transferred to a vacuum depositing device.

Compound HT3 and Compound HT-D1 were co-deposited on the ITO electrode of the glass substrate to form a hole injection layer having a thickness of 100 Å, Compound HT3 was deposited on the hole injection layer to form a hole transport layer having a thickness of 1,300 Å, and TAPC was deposited on the hole transport layer to form an electron blocking layer having a thickness of 100 Å, thereby forming a hole transport region.

Compound H52 (host) and Compound 5 (dopant, 7 wt%) were co-deposited on the hole transport region to form an emission layer having a thickness of 300 Å.

BCP was vacuum-deposited on the emission layer to form a hole blocking layer having a thickness of 250 Å, Compound ET3 and ET-D1 (LiQ) were co-deposited on the hole blocking layer to form an electron transport layer having a thickness of 300 Å, ET-D1 (LiQ) was deposited on the electron transport layer to form an electron injection layer having a thickness of 10 Å, and Al was deposited on the electron injection layer to form an Al second electrode (cathode) having a thickness of 1,200 Å, thereby completing the manufacture of an organic light-emitting device.

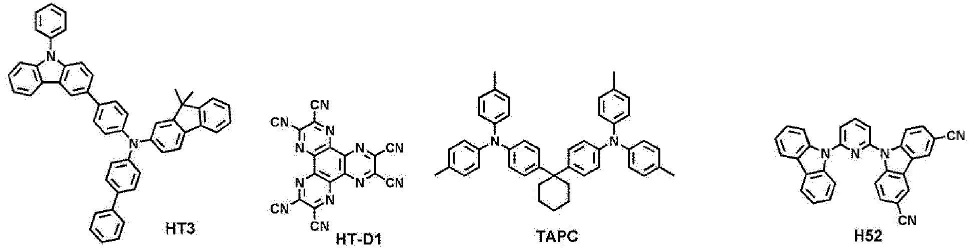

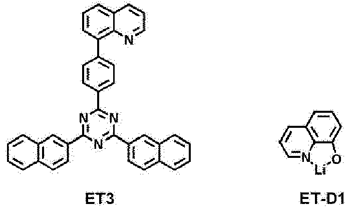

### Comparative Examples 1 to 3

Organic light-emitting devices were manufactured in the same manner as in Example 1, except that Compounds shown in Table 5 were each used instead of Compound 5 as a dopant in forming an emission layer.

### Evaluation Example 3: Evaluation of characteristics of organic light-emitting devices

The EL spectrum, change in current density according to a voltage, change in luminance according to a voltage, efficiency, conversion efficiency, external quantum efficiency, lifespan, and CIE color coordinates of the organic light-emitting devices manufactured according to Example 1 and Comparative Examples 1 to 3 were measured. A specific measuring method is as follows and results thereof are shown in Table 5.

### (1) Measurement of EL spectrum

The EL spectrum of the manufactured organic light-emitting device was measured at a luminance of 500 cd/m² by using a luminance meter (Minolta Cs-1000A).

### (2) Measurement of current density according to voltage

The current value flowing through a unit element in the manufactured organic light-emitting device was measured by using a current-voltage meter (Keithley 2400) while increasing a voltage from 0 V to 10 V, and the result was obtained by dividing the measured current value by an area.

### (3) Measurement of change in luminance according to voltage

The luminance of the manufactured organic light-emitting device was measured by using a luminance meter (Minolta Cs-1000A) while increasing a voltage from 0V to 10V.

### (4) Measure of conversion efficiency

The current efficiency (cd/A) of the same current density (10 mA/cm²) was calculated by using the luminance and the current density and the luminance measured in (2) and (3) and the voltage. Then, the conversion efficiency was calculated by dividing the current efficiency by the y value of the CIE color coordinates measured in (6).

### (5) Measurement of lifespan

The time taken until the luminance measured in (3) (initial luminance was set to 100 %) decreased to 80 % (T₈₀) was calculated.

### (6) Measurement of CIE color coordinates

The CIE color coordinates were obtained by measuring the EL spectrum of the manufactured organic light-emitting device when the luminance was 500 cd/m² by using a luminance meter (Minolta Cs-1000A).

**[Table 5]**

| No. | Dopant | Driving voltage (V) | Lumina nce (cd/m²) | Efficiency (cd/A) | EQE (%) | EL (nm) | T₈₀ (hr) | Color coordinates (x, y) |
|---|---|---|---|---|---|---|---|---|
| Example 1 | Compound 5 | 3.8 | 500 | 45.2 | 20 | 484 | 300 | 0.16 0.31 |
| Comparative Example 1 | Compound A | 4.5 | 500 | 14.1 | 6 | 480 | 1 | 0.150.30 |
| Comparative Example 2 | Compound B | 4.1 | 500 | 28.7 | 12 | 482 | 100 | 0.22 0.48 |
| Comparative Example 3 | Compound C | 5.6 | 500 | 30 | 14 | 520 | 150 | 0.42 0.57 |

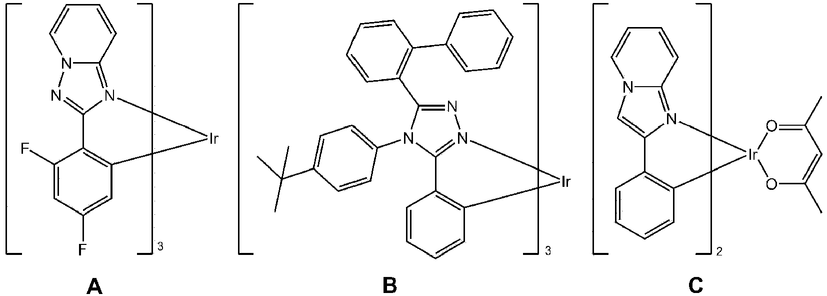

Referring to Table 5, it is confirmed that the organic light-emitting device of Example 1 has excellent efficiency, external quantum efficiency, and lifespan characteristics, as compared with the organic light-emitting devices of Comparative Examples 1 to 3, and also enables deep blue light to be emitted.

Since the organometallic compound has improved electric characteristics and/or thermal stability, an organic light-emitting device including the organometallic compound may have improved lifespan and color purity characteristics.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

1. An organometallic compound represented by Formula 1:
<Formula 1 > M₁₁(L₁₁)ₙ₁₁(L₁₂)ₙ₁₂,
wherein, in Formula 1,
M₁₁ is a transition metal,
L₁₁ is selected from a group represented by Formula 1A,
n11 is selected from 1, 2, 3, and 4, wherein, when n11 is 2 or more, 2 or more L₁₁(s) are the same or different from each other,
L₁₂ is selected from a one-coordinate ligand, a two-coordinate ligand, and a three-coordinate ligand,
n12 is selected from 0, 1, 2, 3, and 4, wherein, when n12 is 2 or more, 2 or more L₁₂(S) are the same or different from each other,
L₁₁ and L₁₂ are different from each other 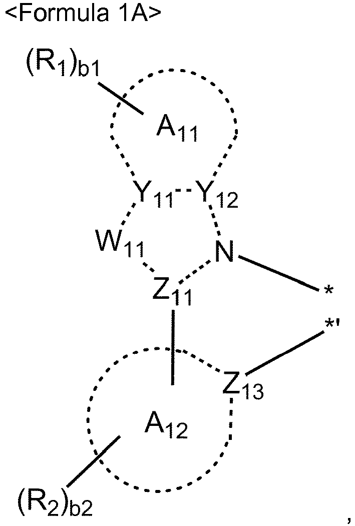
wherein, in Formula 1A,
A₁₁ is a C₁-C₃₀ heterocyclic group, A₁₂ is a C₅-C₃₀ carbocyclic group or a C₁-C₃₀ heterocyclic group,
W₁₁ is selected from N and N(R₁₁),
Y₁₁ and Y₁₂ are each independently selected from N and C, wherein at least one selected from Y₁₁ and Y₁₂ is N,
Z₁₁ and Z₁₃ are each C,
R₁, R₂, and R₁₁ are each independently selected from hydrogen, deuterium, - F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and - P(=O)(Q₈)(Q₉),
two or more selected from R₁, R₂, and R₁₁ are optionally linked to each other to form a ring,
two, three, or four selected from a plurality of neighboring R₁, R₂, and R₁₁ are optionally linked to each other to form a four-coordinate ligand, a six-coordinate ligand, or an eight-coordinate ligand,
Q₁ to Q₉ are each independently selected from hydrogen, deuterium, -F, -CI, - Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₁-C₆₀ alkyl group substituted with at least one selected from deuterium, a C₁-C₆₀ alkyl group, and a C₆-C₆₀ aryl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from deuterium, a C₁-C₆₀ alkyl group, and a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, and
the following compound is excluded from the organometallic compound represented by Formula 1:

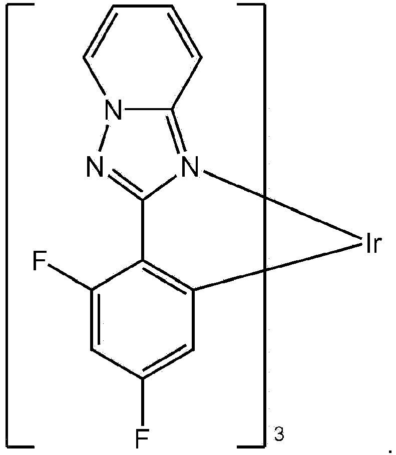

2. The organometallic compound of claim 1, wherein
M₁₁ is selected from platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), and thulium (Tm);
preferably wherein
M₁₁ is selected from Ir, Os, and Pt.

3. The organometallic compound of claims 1 or 2, wherein a moiety represented by 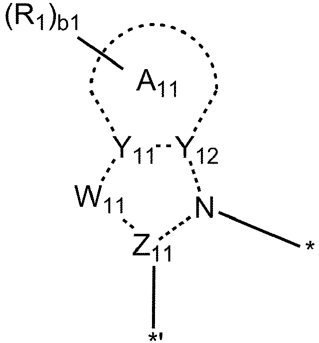 is represented by Formula 1A-1, and a moiety represented by 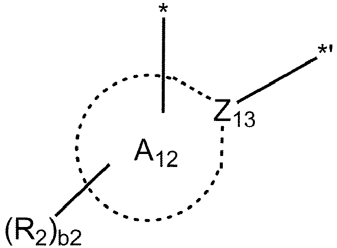 is represented by Formula 1A-2: 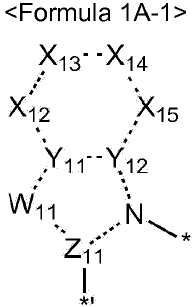 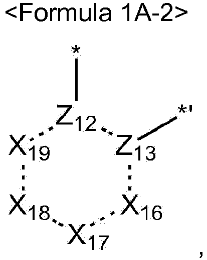 wherein, in Formulae 1A-1 and 1A-2,
Y₁₁, Y₁₂, W₁₁, Z₁₁, and Z₁₃ are each independently the same as described in Formula 1A;
X₁₂ is selected from N, N(R₁₂ₐ), O, S, C(R₁₂ₐ), and C(R₁₂ₐ)(R_{12b}), X₁₃ is selected from N, N(R₁₃ₐ), O, S, C(R₁₃ₐ), and C(R₁₃ₐ)(R_{13b}), X₁₄ is selected from N, N(R₁₄ₐ), O, S, C(R₁₄ₐ), and C(R₁₄ₐ)(R_{14b}), X₁₅ is selected from N, N(R₁₅ₐ), O, S, C(R₁₅ₐ), and C(R₁₅ₐ)(R_{15b}), X₁₆ is selected from N, N(R₁₆ₐ), O, S, C(R₁₆ₐ), and C(R₁₆ₐ)(R_{16b}), X₁₇ is selected from N, N(R₁₇ₐ), O, S, C(R₁₇ₐ), and C(R₁₇ₐ)(R_{17b}), X₁₈ is selected from N, N(R₁₈ₐ), O, S, C(R₁₈ₐ), and C(R₁₈ₐ)(R_{18b}), and X₁₉ is selected from N, N(R₁₉ₐ), O, S, C(R₁₉ₐ), and C(R₁₉ₐ)(R_{19b}),
R₁₂ₐ, R_{12b}, R₁₃ₐ, R_{13b}, R₁₄ₐ, R_{14b}, R₁₅ₐ, R_{15b}, R₁₆ₐ, R_{16b}, R₁₇ₐ, R_{17b}, R₁₈ₐ, R_{18b}, R₁₉ₐ, and R_{19b} are each independently defined the same as R₁ in Formula 1A;
in Formulae 1A-1, * indicates a binding site to M₁₁ of Formula 1, and *' indicates a binding site to a neighboring atom, and
in Formulae 1A-2, *' indicates a binding site to M₁₁ of Formula 1, and * indicates a binding site to a neighboring atom.

4. The organometallic compound of claim 3, wherein
i) X₁₂ is selected from N and C(R₁₂ₐ), X₁₃ is selected from N and C(R₁₃ₐ), X₁₄ is selected from N and C(R₁₄ₐ), X₁₅ is selected from N and C(R₁₅ₐ), X₁₆ is selected from N and C(R₁₆ₐ), X₁₇ is selected from N and C(R₁₇ₐ), X₁₈ is selected from N and C(R₁₈ₐ), and X₁₉ is selected from N and C(R₁₉ₐ); and
ii) X₁₆ is N, X₁₇ is C(R₁₇ₐ), X₁₈ is C(R₁₈ₐ), and X₁₉ is C(R₁₉ₐ); X₁₆ is C(R₁₆ₐ), X₁₇ is N, X₁₈ is C(R₁₈ₐ), and X₁₉ is C(R₁₉ₐ); X₁₆ is C(R₁₆ₐ), X₁₇ is C(R₁₇ₐ), X₁₈ is N, and X₁₉ is C(R₁₉ₐ); X₁₆ is C(R₁₆ₐ), X₁₇ is C(R₁₇ₐ), X₁₈ is C(R₁₈ₐ), and X₁₉ is N; or X₁₆ is C(R₁₆ₐ), X₁₇ is C(R₁₇ₐ), X₁₈ is C(R₁₈ₐ), and X₁₉ is C(R₁₉ₐ).

5. The organometallic compound of any of claims 1-4, wherein
Y₁₁ is N, and Y₁₂ is C;
Y₁₁ is C, and Y₁₂ is N; or
Y₁₁ is N, and Y₁₂ is N.

6. The organometallic compound of any of claims 1-5, wherein
a moiety represented by 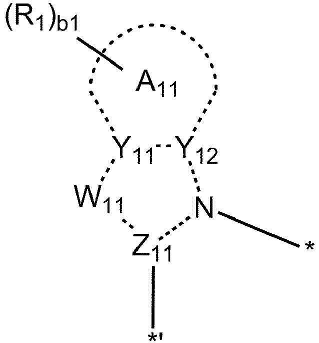 is represented by one selected from Formulae 2-1 to 2-15: 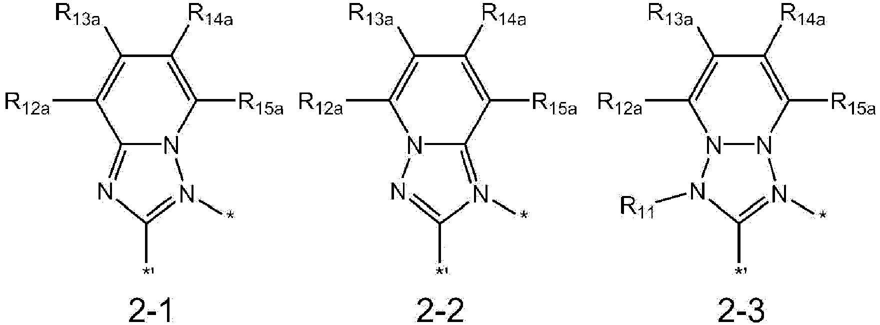 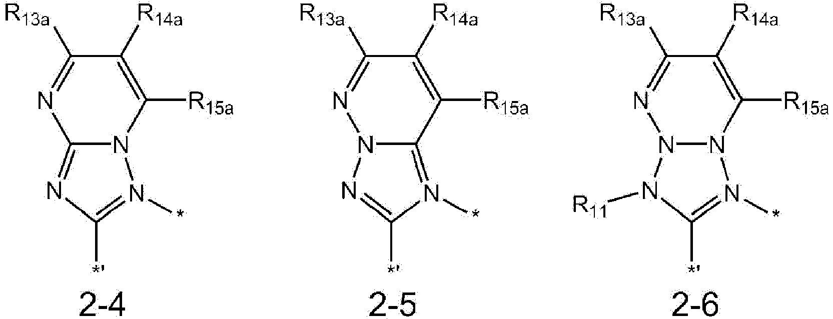 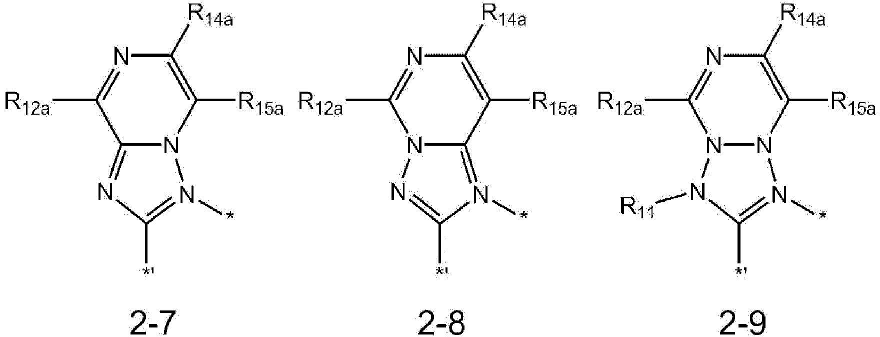 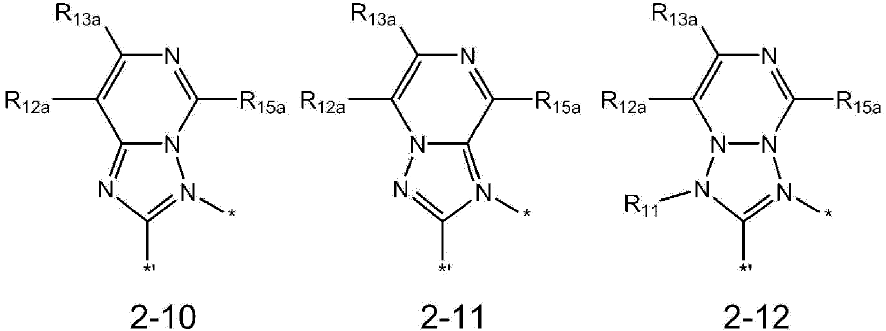 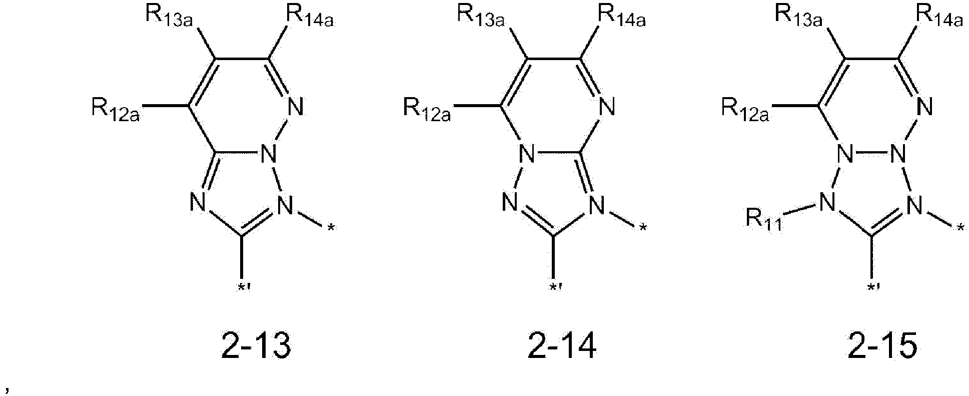 wherein, in Formulae 2-1 to 2-15,
R₁₁ is the same as described in Formula 1A,
R₁₂ₐ, R₁₃ₐ, R₁₄ₐ, and R₁₅ₐ are each independently defined the same as R₁ in Formula 1A; and
* and *' each indicate a binding site to a neighboring atom; and/or
wherein
a moiety represented by 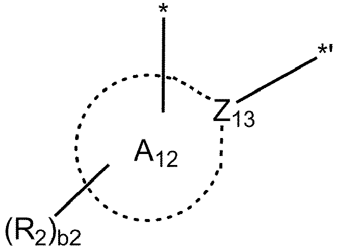 is represented by one selected from Formulae 3-1 to 3-8: 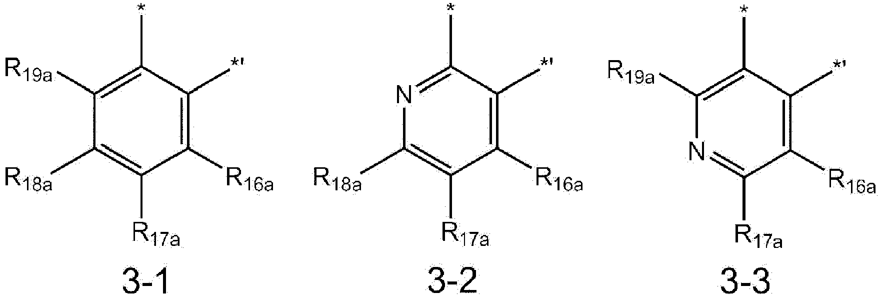 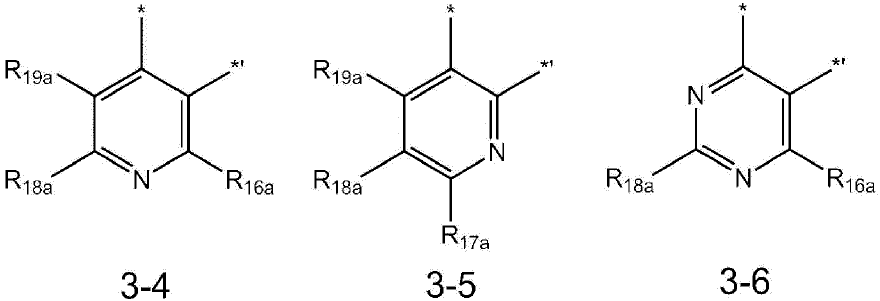 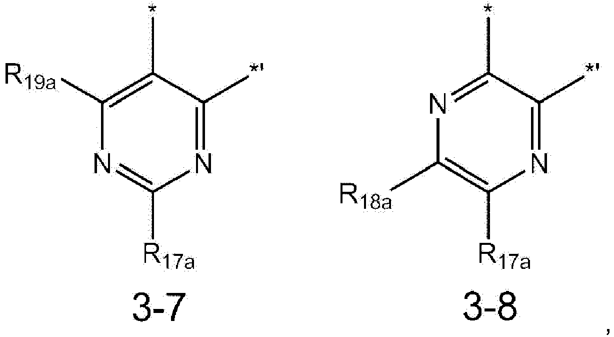
wherein, in Formulae 3-1 to 3-8,
R₁₆ₐ, R₁₇ₐ, R₁₈ₐ, and R₁₉ₐ are each independently defined the same as R₂ in Formula 1A;, and
* and *' each indicate a binding site to a neighboring atom.

7. The organometallic compound of any of claims 1-6, wherein
R₁, R₂, and R₁₁ are each independently selected from:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -CI, -Br, -I, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclopentyl group substituted with deuterium, a cyclohexyl group, a cyclohexyl group substituted with deuterium, a cycloheptyl group, a cycloheptyl group substituted with deuterium, a cycloctyl group, a cycloctyl group substituted with deuterium, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cycloctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cycloctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclopentyl group substituted with deuterium, a cyclohexyl group, a cyclohexyl group substituted with deuterium, a cycloheptyl group, a cycloheptyl group substituted with deuterium, a cycloctyl group, a cycloctyl group substituted with deuterium, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and -Si(Q₃₃)(Q₃₄)(Q₃₅); and
-N(Q₁)(Q₂), -Si(Q₃)(Q₄)(Q₅), -B(Q₆)(Q₇), and -P(=O)(Q₈)(Q₉), and
O₁ to Q₉ and Q₃₃ to Q₃₅ are each independently selected from:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group.

8. The organometallic compound of any of claims 1-7, wherein
R₁, R₂, and R₁₁ are each independently selected from:
hydrogen, deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cycloctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a fluorenyl group, a carbazolyl group, a dibenzofuranyl group, a dibenzothiophenyl group, and a dibenzosilolyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cycloctyl group, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a fluorenyl group, a carbazolyl group, a dibenzofuranyl group, a dibenzothiophenyl group, and a dibenzosilolyl group, each substituted with at least one selected from deuterium, -F, -CD₃, -CD₂H, -CDH₂, -CF₃, -CF₂H, -CFH₂, a cyano group, a nitro group, a C₁-C₁₀ alkyl group, a C₁-C₁₀ alkoxy group, a cyclopentyl group, a cyclopentyl group substituted with deuterium, a cyclohexyl group, a cyclohexyl group substituted with deuterium, a cycloheptyl group, a cycloheptyl group substituted with deuterium, a cycloctyl group, a cycloctyl group substituted with deuterium, a bicyclo[2.2.1]heptanyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a fluorenyl group, a carbazolyl group, a dibenzofuranyl group, a dibenzothiophenyl group, a dibenzosilolyl group, and - Si(Q₃₃)(Q₃₄)(Q₃₅); and
-N(Q₁)(Q₂), -Si(Q₃)(Q₄)(Q₅), -B(Q₆)(Q₇), and -P(=O)(Q₈)(Q₉), and
Q₁ to Q₉ and Q₃₃ to Q₃₅ are each independently selected from:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group.

9. The organometallic compound of any of claims 1-8, wherein
at least one selected from R₁, R₂, and R₁₁ is selected from deuterium, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and -P(=O)(Q₈)(Q₉).

10. The organometallic compound of any of claims 1-9, wherein
n11 is selected from 1, 2, and 3, and n12 is selected from 0, 1, and 2; preferably wherein
M₁₁ is Ir, n11 is selected from 2 and 3, and n12 is selected from 0, 1, and 2.

11. The organometallic compound of any of claims 1-10, wherein
L₁₂ is represented by one selected from Formulae 7-1 to 7-11: 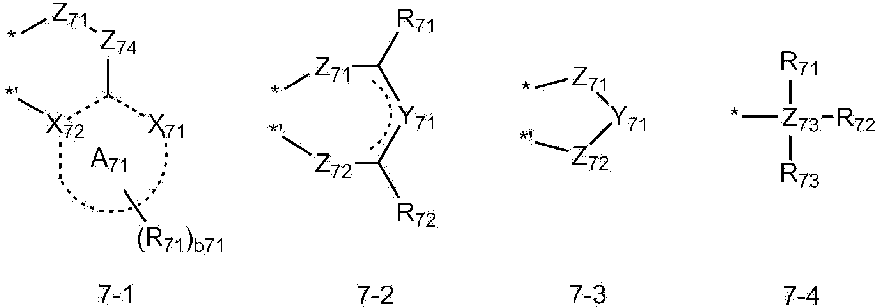 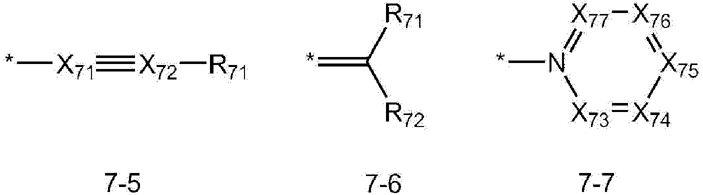 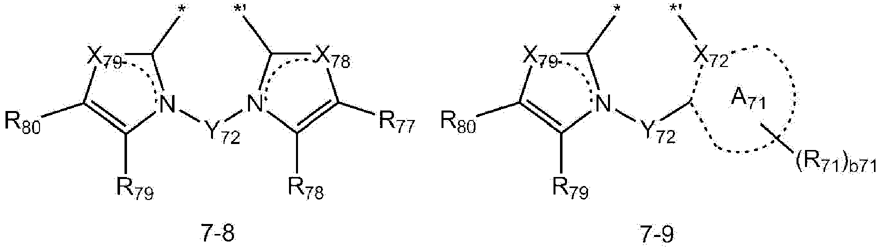 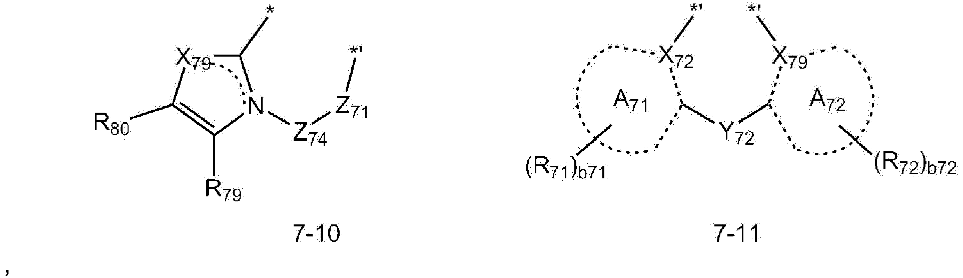 wherein, in Formulae 7-1 to 7-11,
A₇₁ and A₇₂ are each independently selected from a C₅-C₂₀ carbocyclic group and a C₁-C₂₀ heterocyclic group,
X₇₁ and X₇₂ are each independently selected from C and N,
X₇₃ is N or C(Q73); X₇₄ is N or C(Q74); X₇₅ is N or C(Q₇₅); X₇₆ is N or C(Q₇₆); and X₇₇ is N or C(Q77),
X₇₈ is O, S, or N(Q78); and X₇₉ is O, S, or N(Q79),
Y₇₁ and Y₇₂ are each independently selected from a single bond, a double bond, a substituted or unsubstituted C₁-C₅ alkylene group, a substituted or unsubstituted C₂-C₅ alkenylene group, and a substituted or unsubstituted C₆-C₁₀ arylene group,
Z₇₁ and Z₇₂ are each independently selected from N, O, N(R₇₅), P(R₇₅)(R₇₆), and As(R₇₅)(R₇₆),
Z₇₃ is selected from P and As,
Z₇₄ is selected from CO and CH₂,
R₇₁ to R₈₀ and Q₇₃ to Q₇₉ are each independently selected from hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group; R₇₁ and R₇₂ are optionally linked to each other to form a ring; R₇₇ and R₇₈ are optionally linked to each other to form a ring; R₇₈ and R₇₉ are optionally linked to each other to form a ring; and R₇₉ and R₈₀ are optionally linked to each other to form a ring,
b71 and b72 are each independently selected from 1, 2, and 3, and
* and *' each indicate a binding site to a neighboring atom.

12. The organometallic compound of any of claims 1-11, wherein
the organometallic compound represented by Formula 1 is represented by one selected from Formulae 1-1 and 1-2: 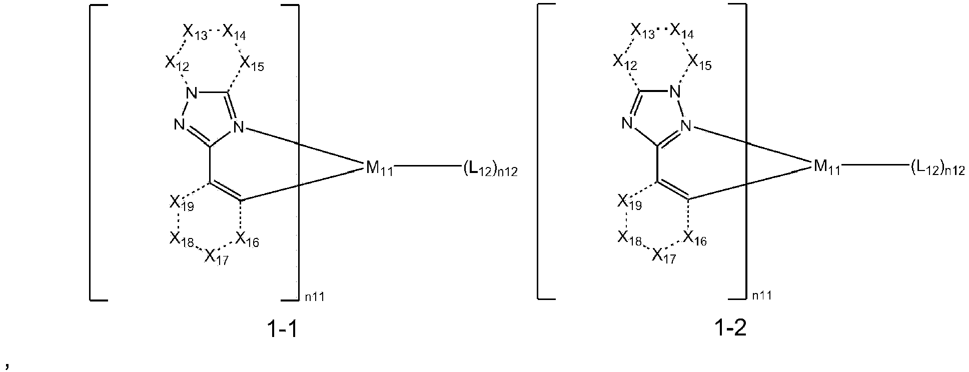 wherein, in Formulae 1-1 and 1-2,
M₁₁, n11, n12, and L₁₂ are each independently the same as described in Formula 1,
X₁₂ is selected from N, N(R₁₂ₐ), O, S, C(R₁₂ₐ), and C(R₁₂ₐ)(R_{12b}), X₁₃ is selected from N, N(R₁₃ₐ), O, S, C(R₁₃ₐ), and C(R₁₃ₐ)(R_{13b}), X₁₄ is selected from N, N(R₁₄ₐ), O, S, C(R₁₄ₐ), and C(R₁₄ₐ)(R_{14b}), X₁₅ is selected from N, N(R₁₅ₐ), O, S, C(R₁₅ₐ), and C(R₁₅ₐ)(R_{15b}), X₁₆ is selected from N, N(R₁₆ₐ), O, S, C(R₁₆ₐ), and C(R₁₆ₐ)(R_{16b}), X₁₇ is selected from N, N(R₁₇ₐ), O, S, C(R₁₇ₐ), and C(R₁₇ₐ)(R_{17b}), X₁₈ is selected from N, N(R₁₈ₐ), O, S, C(R₁₈ₐ), and C(R₁₈ₐ)(R_{18b}), and X₁₉ is selected from N, N(R₁₉ₐ), O, S, C(R₁₉ₐ), and C(R₁₉ₐ)(R_{19b}), and
R₁₂ₐ, R_{12b}, R₁₃ₐ, R_{13b}, R₁₄ₐ, R_{14b}, R₁₅ₐ, R_{15b}, R₁₆ₐ, R_{16b}, R₁₇ₐ, R_{17b}, R₁₈ₐ, R_{18b}, R₁₉ₐ, and R_{19b} are each independently defined the same as R₁ in Formula 1A.

13. The organometallic compound of claim 1, wherein
the organometallic compound represented by Formula 1 is selected from Compounds 1 to 16:

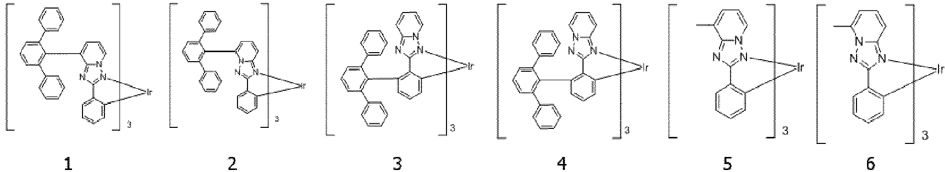

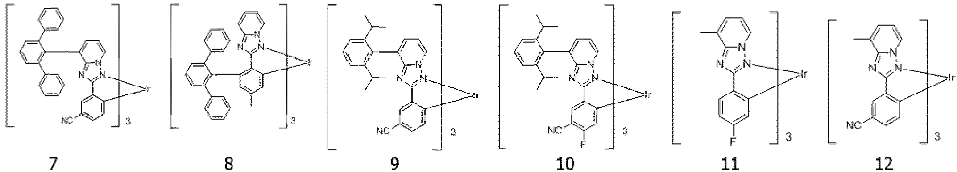

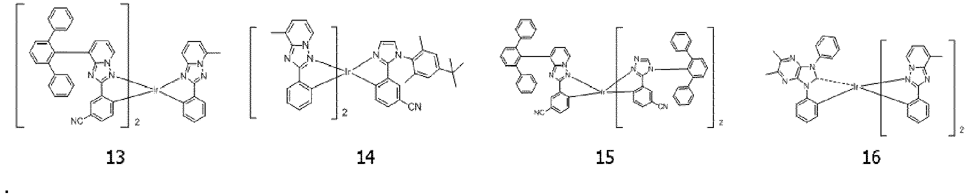

14. The organometallic compound of any of claims 1-13, wherein
the organometallic compound emits blue light having a maximum emission wavelength of 400 nm to 520 nm.

15. An organic light-emitting device comprising:
a first electrode,
a second electrode, and
an organic layer between the first electrode and the second electrode and comprising an emission layer,
wherein the organic layer comprises the organometallic compound of any of claims 1-14;
preferably wherein
the emission layer comprises the organometallic compound;
preferably wherein
the emission layer further comprises a host, and an amount of the host is larger than an amount of the organometallic compound.

## Patentansprüche

1. Organometallische Verbindung, dargestellt durch Formel 1:
<Formel 1> M₁₁(L₁₁)ₙ₁₁(L₁₂)ₙ₁₂,
wobei in Formel 1
M₁₁ ein Übergangsmetall ist,
L₁₁ aus einer Gruppe dargestellt durch Formel 1A ausgewählt ist,
n11 aus 1,2, 3 und 4 ausgewählt ist, wobei, wenn n11 2 oder mehr ist, 2 oder mehr L₁₁(s) gleich oder unterschiedlich zueinander sind,
L₁₂ aus einem Ein-Koordinaten-Liganden, einem Zwei-Koordinaten-Liganden und einem Drei-Koordinaten-Liganden ausgewählt ist,
n12 aus 0, 1,2, 3 und 4 ausgewählt ist, wobei, wenn n12 2 oder mehr ist, 2 oder mehr L₁₂(s) gleich oder unterschiedlich zueinander sind,
L₁₁ und L₁₂ unterschiedlich zueinander sind, 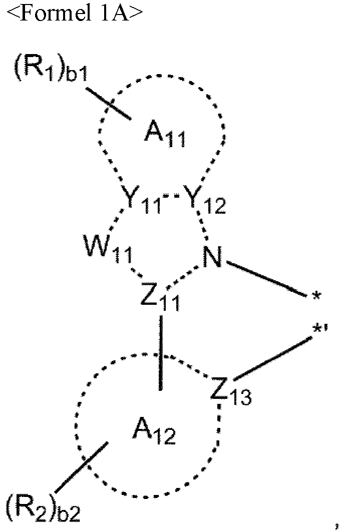
wobei in Formel 1A
An eine heterocyclische C₁-C₃₀-Gruppe ist, A₁₂ eine carbocyclische C₅-C₃₀-Gruppe oder eine heterocyclische C₁-C₃₀-Gruppe ist,
W₁₁ aus N und N(R₁₁) ausgewählt ist,
Y₁₁ und Y₁₂ jeweils unabhängig aus N und C ausgewählt sind, wobei zumindest eines ausgewählt aus Y₁₁ und Y₁₂ N ist,
Z₁₁ und Z₁₃ jeweils C sind,
R₁, R₂ und R₁₁ jeweils unabhängig ausgewählt sind aus Wasserstoff, Deuterium, -F, -Cl, - Br, -I, -SF₅, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer substituierten oder nicht substituierten Ci-C₆₀Alkylgruppe, einer substituierten oder nicht substituierten C₂-C₆₀Alkenylgruppe, einer substituierten oder nicht substituierten C₂-C₆₀Alkynylgruppe, einer substituierten oder nicht substituierten C₁-C₆₀Alkoxygruppe, einer substituierten oder nicht substituierten C₃-C₁₀Cycloalkylgruppe, einer substituierten oder nicht substituierten C₁-C₁₀Heterocycloalkylgruppe, einer substituierten oder nicht substituierten C₃-C₁₀Cycloalkenylgruppe, einer substituierten oder nicht substituierten C₁-C₁₀Heterocycloalkenylgruppe, einer substituierten oder nicht substituierten C₆-C₆₀Arylgruppe, einer substituierten oder nicht substituierten C₆-C₆₀Aryloxygruppe, einer substituierten oder nicht substituierten C₆-C₆₀Arylthiogruppe, einer substituierten oder nicht substituierten C₁-C₆₀Heteroarylgruppe, einer substituierten oder nicht substituierten monovalenten nichtaromatischen kondensierten polycyclischen Gruppe, einer substituierten oder nicht substituierten monovalenten nichtaromatischen kondensierten heteropolycyclischen Gruppe, - N(Q₁)(Q₂), -Si(Q₃)(Q₄)(Q₅), -B(Q₆)(Q₇) und -P(=O)(Q₈)(Q₉),
zwei oder mehr ausgewählt aus R₁, R₂ und R₁₁ optional miteinander verbunden sind, um einen Ring zu bilden,
zwei, drei oder vier ausgewählt aus einer Vielzahl von benachbarten R₁, R₂ und R₁₁ optional miteinander verbunden sind, um einen Vier-Koordinaten-Liganden, einen Sechs-Koordinaten-Liganden oder einen Acht-Koordinaten-Liganden zu bilden,
Q₁ bis Q₉ jeweils unabhängig ausgewählt sind aus Wasserstoff, Deuterium, -F, -Cl, -Br, - I, einer Hydroxylgruppe, einer Cyanogruppe, einer Nitrogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer C₁-C₆₀Alkylgruppe, einer C₁-C₆₀Alkylgruppe substituiert mit zumindest einem ausgewählt aus Deuterium, einer C₁-C₆₀Alkylgruppe und einer C₆-C₆₀Arylgruppe, einer C₂-C₆₀Alkenylgruppe, einer C₂-C₆₀Alkynylgruppe, einer C₁-C₆₀Alkoxygruppe, einer C₃-C₁₀Cycloalkylgruppe, einer C₁-C₁₀Heterocycloalkylgruppe, einer C₃-C₁₀Cycloalkenylgruppe, einer C₁-C₁₀Heterocycloalkenylgruppe, einer C₆-C₆₀Arylgruppe, einer C₆-C₆₀Arylgruppe substituiert mit zumindest einem ausgewählt aus Deuterium, einer C₁-C₆₀Alkylgruppe und einer C₆-C₆₀Arylgruppe, einer C₆-C₆₀Aryloxygruppe, einer C₆-C₆₀Arylthiogruppe, einer C₁-C₆₀Heteroarylgruppe, einer monovalenten nichtaromatischen kondensierten polycyclischen Gruppe und einer monovalenten nichtaromatischen kondensierten heteropolycyclischen Gruppe, und
die folgende Verbindung von der organometallischen Verbindung dargestellt durch Formel 1 ausgeschlossen ist:

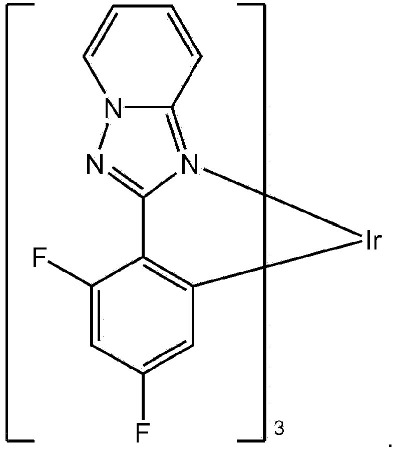

2. Organometallische Verbindung nach Anspruch 1, wobei
M₁₁ ausgewählt ist aus Platin (Pt), Palladium (Pd), Kupfer (Cu), Silber (Ag), Gold (Au), Rhodium (Rh), Iridium (Ir), Ruthenium (Ru), Osmium (Os), Titan (Ti), Zirkonium (Zr), Hafnium (Hf), Europium (Eu), Terbium (Tb) und Thulium (Tm);
wobei bevorzugt
M₁₁ ausgewählt ist aus Ir, Os und Pt.

3. Organometallische Verbindung nach Anspruch 1 oder 2, wobei
eine Einheit dargestellt durch 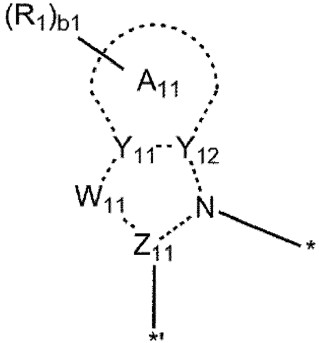 dargestellt ist durch Formel 1A-1, und eine Einheit dargestellt durch 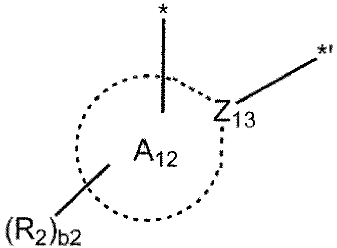 dargestellt ist durch Formel 1A-2: 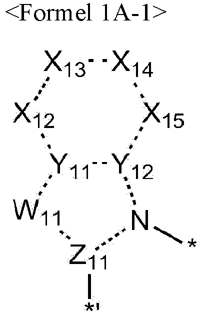 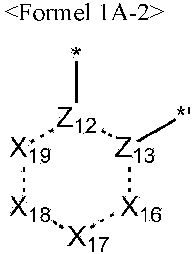 wobei in Formel 1A-1 und 1A-2
Y₁₁, Y₁₂, W₁₁, Z₁₁ und Z₁₃ jeweils unabhängig die gleichen wie in Formel 1A beschrieben sind;
X₁₂ ausgewählt ist aus N, N(R₁₂ₐ), O, S, C(R₁₂ₐ) und C(R₁₂ₐ)(R_{12b}), X₁₃ ausgewählt ist aus N, N(R₁₃ₐ), O, S, C(R₁₃ₐ) und C(R₁₃ₐ)(R_{13b}), X₁₄ ausgewählt ist aus N, N(R₁₄ₐ), O, S, C(R₁₄ₐ) und C(R₁₄ₐ)(R_{14b}), X₁₅ ausgewählt ist aus N, N(R₁₅ₐ), O, S, C(R₁₅ₐ) und C(R₁₅ₐ)(R_{15b}), X₁₆ ausgewählt ist aus N, N(R₁₆ₐ), O, S, C(R₁₆ₐ) und C(R₁₆ₐ)(R_{16b}), X₁₇ ausgewählt ist aus N, N(R₁₇ₐ), O, S, C(R₁₇ₐ) und C(R₁₇ₐ)(R_{17b}), X₁₈ ausgewählt ist aus N, N(R₁₈ₐ), O, S, C(R₁₈ₐ) und C(R₁₈ₐ)(R_{18b}), und X₁₉ ausgewählt ist aus N, N(R₁₉ₐ), O, S, C(R₁₉ₐ) und C(R₁₉ₐ)(R_{19b}),
R₁₂ₐ, R_{12b}, R₁₃ₐ, R_{13b}, R₁₄ₐ, R_{14b}, R₁₅ₐ, R_{15b}, R₁₆ₐ, R_{16b}, R₁₇ₐ, R_{17b}, R₁₈ₐ, R_{18b}, R₁₉ₐ und R_{19b} jeweils unabhängig definiert die gleichen wie R₁ in Formel 1A sind;
in Formel 1A-1 * eine Bindungsstelle zu M₁₁ der Formel 1 angibt, und *' eine Bindungsstelle zu einem benachbarten Atom angibt, und
in Formel 1A-2 *' eine Bindungsstelle zu M₁₁ der Formel 1 angibt, und * eine Bindungsstelle zu einem benachbarten Atom angibt.

4. Organometallische Verbindung nach Anspruch 3, wobei
i) X₁₂ ausgewählt ist aus N und C(R₁₂ₐ), X₁₃ ausgewählt ist aus N und C(R₁₃ₐ), X₁₄ ausgewählt ist aus N und C(R₁₄ₐ), X₁₅ ausgewählt ist aus N und C(R₁₅ₐ), X₁₆ ausgewählt ist aus N und C(R₁₆ₐ), X₁₇ ausgewählt ist aus N und C(R₁₇ₐ), X₁₈ ausgewählt ist aus N und C(R₁₈ₐ), und X₁₉ ausgewählt ist aus N und C(R₁₉ₐ); und
ii) X₁₆ N ist, X₁₇ C(R₁₇,) ist, X₁₈ C(R₁₈ₐ) ist, und X₁₉ C(R₁₉ₐ) ist; X₁₆ C(R₁₆ₐ) ist, X₁₇ N ist, X₁₈ C(R₁₈ₐ) ist, und X₁₉ C(R₁₉ₐ) ist; X₁₆ C(R₁₆ₐ) ist, X₁₇ C(R₁₇ₐ) ist, X₁₈ N ist, und X₁₉ C(R₁₉ₐ) ist; X₁₆ C(R₁₆ₐ) ist, X₁₇ C(R₁₇ₐ) ist, X₁₈ C(R₁₈ₐ) ist, und X₁₉ N ist; oder X₁₆ C(R₁₆ₐ) ist, X₁₇ C(R₁₇ₐ) ist, X₁₈ C(R₁₈ₐ) ist, und X₁₉ C(R₁₉ₐ) ist.

5. Organometallische Verbindung nach einem der Ansprüche 1-4, wobei
Y₁₁ N ist, und Y₁₂ C ist;
Y₁₁ C ist, und Y₁₂ N ist; oder
Y₁₁ N ist, und Y₁₂ N ist.

6. Organometallische Verbindung nach einem der Ansprüche 1-5, wobei
eine Einheit dargestellt durch 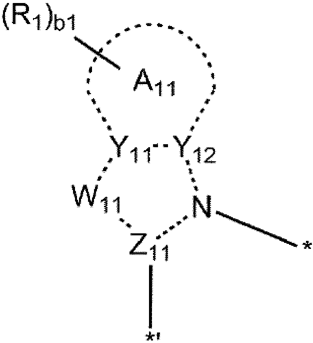 dargestellt ist durch eines ausgewählt aus Formel 2-1 bis 2-15: 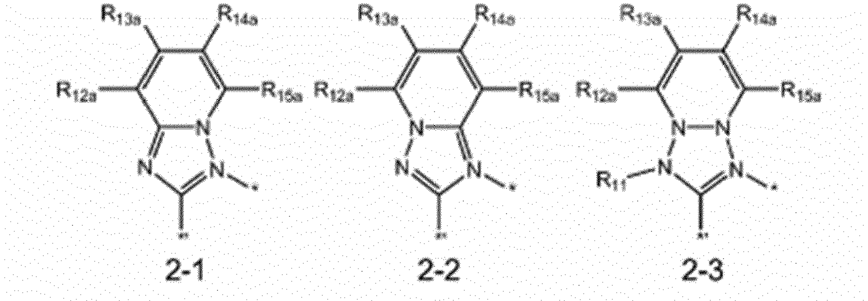 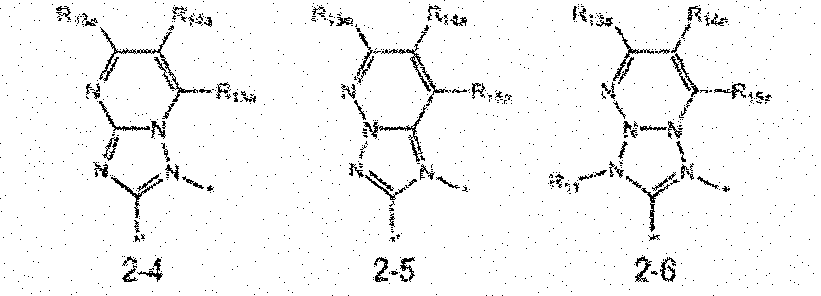 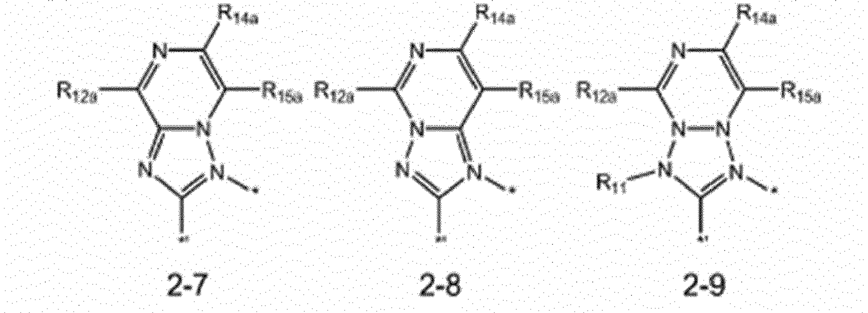 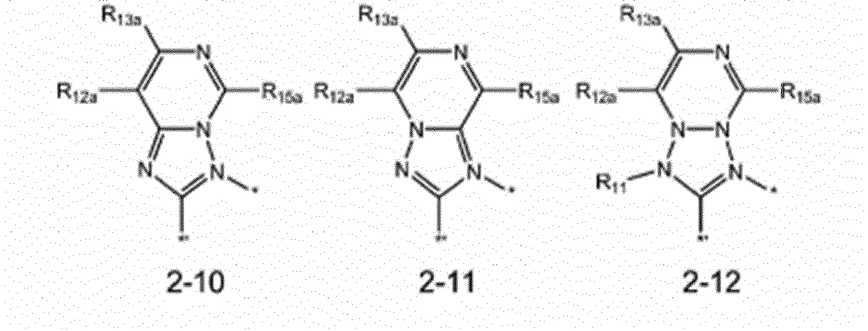 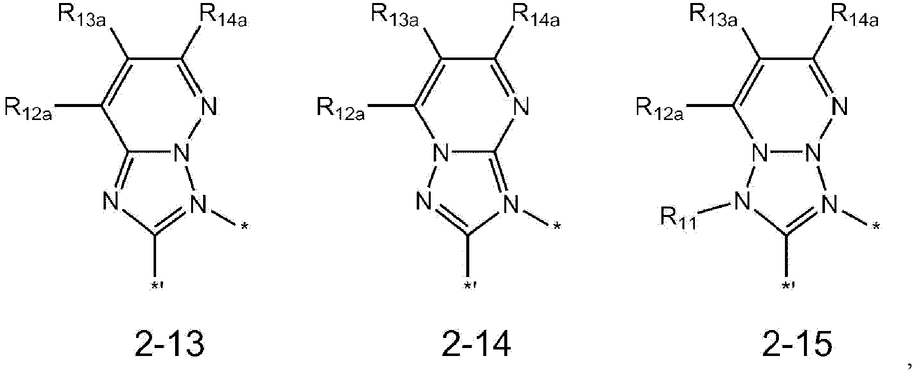 wobei in Formel 2-1 bis 2-15
R₁₁ das gleiche wie in Formel 1A beschrieben ist,
R₁₂ₐ, R₁₃ₐ, R₁₄ₐ und R₁₅ₐ jeweils unabhängig definiert die gleichen wie R₁ in Formel 1A sind; und
* und *'jeweils eine Bindungsstelle zu einem benachbarten Atom angeben; und/oder
wobei
eine Einheit dargestellt durch 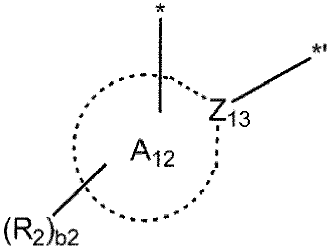 dargestellt ist durch eines ausgewählt aus Formel 3-1 bis 3-8: 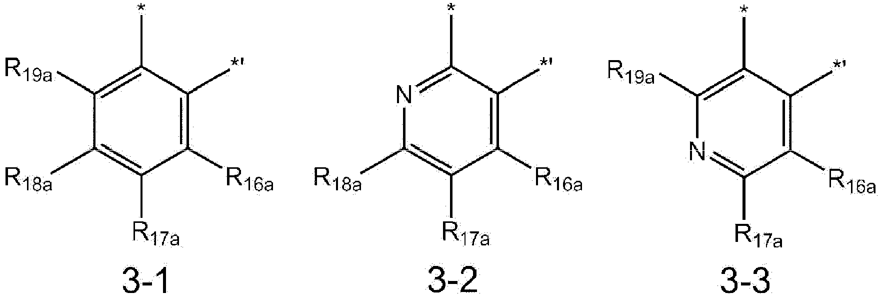 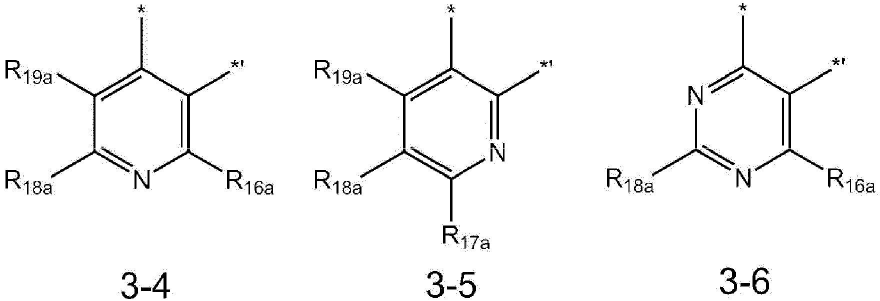 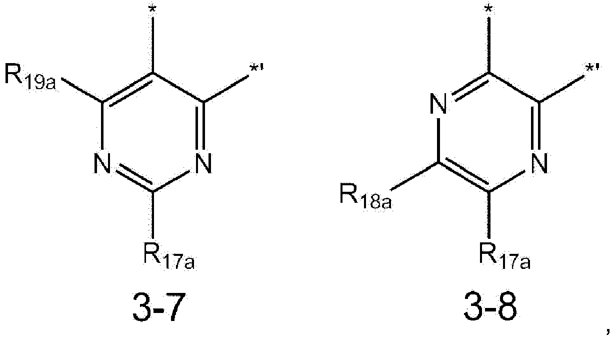
wobei in Formel 3-1 bis 3-8
R₁₆ₐ, R₁₇ₐ, R₁₈ₐ und R₁₉ₐ jeweils unabhängig definiert die gleichen wie R₂ in Formel 1A sind; und
* und *'jeweils eine Bindungsstelle zu einem benachbarten Atom angeben.

7. Organometallische Verbindung nach einem der Ansprüche 1-6, wobei R₁, R₂ und R₁₁ jeweils unabhängig ausgewählt sind aus: Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, -SF₅, einer C₁-C₂₀Alkylgruppe und einer C₁-C₂₀Alkoxygruppe;
einer C₁-C₂₀Alkylgruppe und einer C₁-C₂₀Alkoxygruppe, jeweils substituiert mit zumindest einem ausgewählt aus Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer C₁-C₁₀Alkylgruppe, einer Cyclopentylgruppe, einer Cyclopentylgruppe substituiert mit Deuterium, einer Cyclohexylgruppe, einer Cyclohexylgruppe substituiert mit Deuterium, einer Cycloheptylgruppe, einer Cycloheptylgruppe substituiert mit Deuterium, einer Cycloctylgruppe, einer Cycloctylgruppe substituiert mit Deuterium, einer Bicyclo[2.2.1]heptanylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Cyclopentylgruppe, einer Cyclohexylgruppe, einer Cycloheptylgruppe, einer Cycloctylgruppe, einer Bicyclo[2.2.1]heptanylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cycloctylgruppe, einer Bicyclo[2.2.1]heptanylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe und einer Imidazopyrimidinylgruppe, jeweils substituiert mit zumindest einem ausgewählt aus Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer C₁-C₂₀A1kylgruppe, einer C₁-C₂₀Alkoxygruppe, einer Cyclopentylgruppe, einer Cyclopentylgruppe substituiert mit Deuterium, einer Cyclohexylgruppe, einer Cyclohexylgruppe substituiert mit Deuterium, einer Cycloheptylgruppe, einer Cycloheptylgruppe substituiert mit Deuterium, einer Cycloctylgruppe, einer Cycloctylgruppe substituiert mit Deuterium, einer Bicyclo[2.2.1]heptanylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe, einer Imidazopyrimidinylgruppe und -Si(Q₃₃)(Q₃₄)(Q₃₅); und
-N(Q₁)(Q₂), -Si(Q₃)(Q₄)(Q₅), -B(Q₆)(Q₇) und -P(=O)(Q₈)(Q₉), und
Q₁ bis Q₉ und Q₃₃ bis Q₃₅ jeweils unabhängig ausgewählt sind aus:
-CH₃, -CD₃, -CD₂H, -CDH₂, -CH₂CH₃, -CH₂CD₃, -CH₂CD₂H, -CH₂CDH₂, - CHDCH₃, - CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer a sec-Pentylgruppe, einer tert-Pentylgruppe, einer Phenylgruppe und einer Naphthylgruppe; und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jeweils substituiert mit zumindest einem ausgewählt aus Deuterium, einer C₁-C₁₀Alkylgruppe und einer Phenylgruppe.

8. Organometallische Verbindung nach einem der Ansprüche 1-7, wobei
R₁, R₂ und R₁₁ jeweils unabhängig ausgewählt sind aus:
Wasserstoff, Deuterium, -F, einer Cyanogruppe, einer Nitrogruppe, -SF5, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer Isohexylgruppe, einer sec-Hexylgruppe, einer tert-Hexylgruppe, einer n-Heptylgruppe, einer Isoheptylgruppe, einer sec-Heptylgruppe, einer tert-Heptylgruppe, einer n-Octylgruppe, einer Isooctylgruppe, einer sec-Octylgruppe, einer tert-Octylgruppe, einer n-Nonylgruppe, einer Isononylgruppe, einer sec-Nonylgruppe, einer tert-Nonylgruppe, einer n-Decylgruppe, einer Isodecylgruppe, einer sec-Decylgruppe, einer tert-Decylgruppe, einer Methoxygruppe, einer Ethoxygruppe, einer Propoxygruppe, einer Butoxygruppe, einer Pentoxygruppe, einer Cyclopentylgruppe, einer Cyclohexylgruppe, einer Cycloheptylgruppe, einer Cycloctylgruppe, einer Bicyclo[2.2.1]heptanylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe, einer Fluorenylgruppe, einer Carbazolylgruppe, einer Dibenzofuranylgruppe, einer Dibenzothiophenylgruppe und einer Dibenzosilolylgruppe;
einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer Isohexylgruppe, einer sec-Hexylgruppe, einer tert-Hexylgruppe, einer n-Heptylgruppe, einer Isoheptylgruppe, einer sec-Heptylgruppe, einer tert-Heptylgruppe, einer n-Octylgruppe, einer Isooctylgruppe, einer sec-Octylgruppe, einer tert-Octylgruppe, einer n-Nonylgruppe, einer Isononylgruppe, einer sec-Nonylgruppe, einer tert-Nonylgruppe, einer n-Decylgruppe, einer Isodecylgruppe, einer sec-Decylgruppe, einer tert-Decylgruppe, einer Methoxygruppe, einer Ethoxygruppe, einer Propoxygruppe, einer Butoxygruppe, einer Pentoxygruppe, einer Cyclopentylgruppe, einer Cyclohexylgruppe, einer Cycloheptylgruppe, einer Cycloctylgruppe, einer Bicyclo[2.2.1]heptanylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe, einer Fluorenylgruppe, einer Carbazolylgruppe, einer Dibenzofuranylgruppe, einer Dibenzothiophenylgruppe und einer Dibenzosilolylgruppe, jeweils substituiert mit zumindest einem ausgewählt aus Deuterium, -F, -CD₃, -CD₂H, -CDH₂, - CF₃, -CF₂H, -CFH₂, einer Cyanogruppe, einer Nitrogruppe, einer C₁-C₁₀Alkylgruppe, einer C₁-C₁₀Alkoxygruppe, einer Cyclopentylgruppe, einer Cyclopentylgruppe substituiert mit Deuterium, einer Cyclohexylgruppe, einer Cyclohexylgruppe substituiert mit Deuterium, einer Cycloheptylgruppe, einer Cycloheptylgruppe substituiert mit Deuterium, einer Cycloctylgruppe, einer Cycloctylgruppe substituiert mit Deuterium, einer Bicyclo[2.2.1]heptanylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe, einer Fluorenylgruppe, einer Carbazolylgruppe, einer Dibenzofuranylgruppe, einer Dibenzothiophenylgruppe, einer Dibenzosilolylgruppe und -Si(Q₃₃)(Q₃₄)(Q₃₅); und
-N(Q₁)(Q₂), -Si(Q₃)(Q₄)(Q₅), -B(Q₆)(Q₇), und -P(=O)(Q₈)(Q₉), und
Q₁ bis Q₉ und Q₃₃ bis Q₃₅ jeweils unabhängig ausgewählt sind aus:
-CH₃, -CD₃, -CD₂H, -CDH₂, -CH₂CH₃, -CH₂CD₃, -CH₂CD₂H, -CH₂CDH₂, - CHDCH₃, - CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe; und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jeweils substituiert mit zumindest einem ausgewählt aus Deuterium, einer C₁-C₁₀Alkylgruppe und einer Phenylgruppe.

9. Organometallische Verbindung nach einem der Ansprüche 1-8, wobei
zumindest eines ausgewählt aus R₁, R₂ und R₁₁ ausgewählt ist aus Deuterium, einer substituierten oder nicht substituierten C₁-C₆₀Alkylgruppe, einer substituierten oder nicht substituierten C₂-C₆₀Alkenylgruppe, einer substituierten oder nicht substituierten C₂-C₆₀Alkynylgruppe, einer substituierten oder nicht substituierten C₁-C₆₀Alkoxygruppe, einer substituierten oder nicht substituierten C₃-C₁₀Cycloalkylgruppe, einer substituierten oder nicht substituierten C₁-C₁₀Heterocycloalkylgruppe, einer substituierten oder nicht substituierten C₃-C₁₀Cycloalkenylgruppe, einer substituierten oder nicht substituierten C₁-C₁₀Heterocycloalkenylgruppe, einer substituierten oder nicht substituierten C₆-C₆₀-Arylgruppe, einer substituierten oder nicht substituierten C₆-C₆₀-Aryloxygruppe, einer substituierten oder nicht substituierten C₆-C₆₀Arylthiogruppe, einer substituierten oder nicht substituierten C₁-C₆₀Heteroarylgruppe, einer substituierten oder nicht substituierten monovalenten nichtaromatischen kondensierten polycyclischen Gruppe, einer substituierten oder nicht substituierten monovalenten nichtaromatischen kondensierten heteropolycyclischen Gruppe, - N(Q₁)(Q₂), -Si(Q₃)(Q₄)(Q₅), -B(Q₆)(Q₇) und -P(=O)(Q₈)(Q₉).

10. Organometallische Verbindung nach einem der Ansprüche 1-9, wobei
n11 ausgewählt ist aus 1, 2 und 3, und n12 ausgewählt ist aus 0, 1 und 2;
wobei bevorzugt
M₁₁ Ir ist, n11 ausgewählt ist aus 2 und 3, und n12 ausgewählt ist aus 0, 1 und 2.

11. Organometallische Verbindung nach einem der Ansprüche 1-10, wobei
L₁₂ dargestellt ist durch eines ausgewählt aus Formel 7-1 bis 7-11: 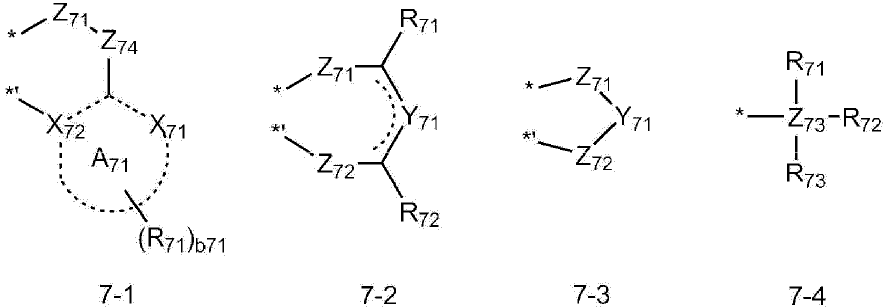 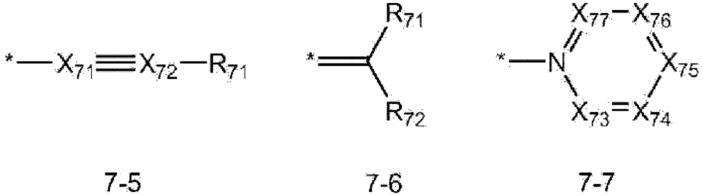 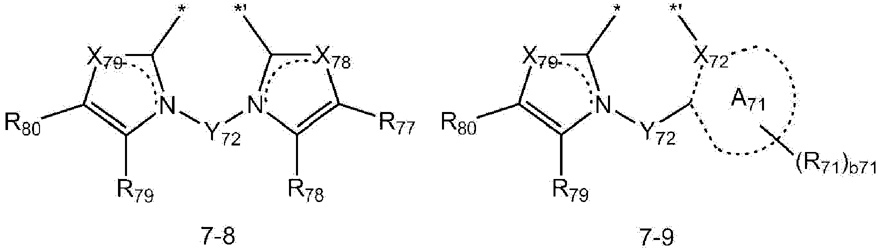 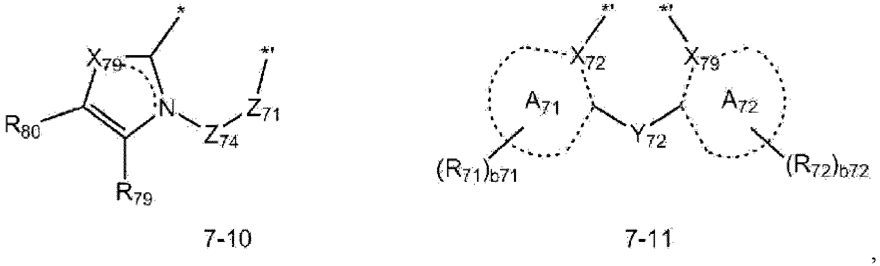 wobei in Formel 7-1 bis 7-11
A₇₁ und A₇₂ jeweils unabhängig ausgewählt sind aus einer carbocyclischen C₅-C₂₀-Gruppe und einer heterocyclischen C₁-C₂₀-Gruppe,
X₇₁ und X₇₂ jeweils unabhängig ausgewählt sind aus C und N,
X₇₃ N oder C(Q₇₃) ist; X₇₄ N oder C(Q₇₄) ist; X₇₅ N oder C(Q₇₅) ist; X₇₆ N oder C(Q₇₆) ist; und X₇₇ N oder C(Q₇₇) ist,
X₇₈ O, S oder N(Q₇₈) ist; und X₇₉ O, S oder N(Q₇₉) ist,
Y₇₁ und Y₇₂ jeweils unabhängig ausgewählt sind aus einer Einzelbindung, einer Doppelbindung, einer substituierten oder nicht substituierten C₁-C₅Alkylengruppe, einer substituierten oder nicht substituierten C₂-C₅Alkenylengruppe und einer substituierten oder nicht substituierten C₆-C₁₀Arylengruppe,
Z₇₁ und Z₇₂ jeweils unabhängig ausgewählt sind aus N, O, N(R₇₅), P(R₇₅)(R₇₆) und AS(R₇₅)(R₇₆),
Z₇₃ ausgewählt ist aus P und As,
Z₇₄ ausgewählt ist aus CO und CH₂,
R₇₁ bis R₈₀ und Q₇₃ bis Q₇₉ jeweils unabhängig ausgewählt sind aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer substituierten oder nicht substituierten C₁-C₆₀Alkylgruppe, einer substituierten oder nicht substituierten C₂-C₆₀Alkenylgruppe, einer substituierten oder nicht substituierten C₂-C₆₀Alkynylgruppe, einer substituierten oder nicht substituierten C₁-C₆₀Alkoxygruppe, einer substituierten oder nicht substituierten C₃-C₁₀Cycloalkylgruppe, einer substituierten oder nicht substituierten C₁-C₁₀Heterocycloalkylgruppe, einer substituierten oder nicht substituierten C₃-C₁₀Cycloalkenylgruppe, einer substituierten oder nicht substituierten C₁-C₁₀Heterocycloalkenylgruppe, einer substituierten oder nicht substituierten C₆-C₆₀Arylgruppe, einer substituierten oder nicht substituierten C₆-C₆₀Aryloxygruppe, einer substituierten oder nicht substituierten C₆-C₆₀Arylthiogruppe, einer substituierten oder nicht substituierten C₁-C₆₀Heteroarylgruppe, einer substituierten oder nicht substituierten monovalenten nichtaromatischen kondensierten polycyclischen Gruppe und einer substituierten oder nicht substituierten monovalenten nichtaromatischen kondensierten heteropolycyclischen Gruppe; R₇₁ und R₇₂ optional miteinander verbunden sind, um einen Ring zu bilden; R₇₇ und R₇₈ optional miteinander verbunden sind, um einen Ring zu bilden; R₇₈ und R₇₉ optional miteinander verbunden sind, um einen Ring zu bilden; und R₇₉ und R₈₀ optional miteinander verbunden sind, um einen Ring zu bilden,
b71 und b72 jeweils unabhängig ausgewählt sind aus 1,2 und 3, und
* und *'jeweils eine Bindungsstelle zu einem benachbarten Atom angeben.

12. Organometallische Verbindung nach einem der Ansprüche 1-11, wobei
die organometallische Verbindung dargestellt durch Formel 1 dargestellt ist durch eines ausgewählt aus Formel 1-1 und 1-2: 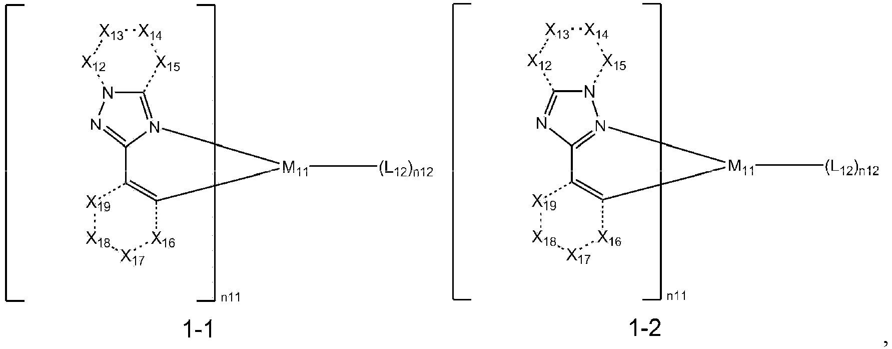 wobei in Formel 1-1 und 1-2
M₁₁, n11, n12 und L₁₂ jeweils unabhängig die gleichen wie in Formel 1 beschrieben sind,
X₁₂ ausgewählt ist aus N, N(R₁₂ₐ), O, S, C(R₁₂ₐ) und C(R₁₂ₐ)(R_{12b}), X₁₃ ausgewählt ist aus N, N(R₁₃ₐ), O, S, C(R₁₃ₐ) und C(R₁₃ₐ)(R_{13b}), X₁₄ ausgewählt ist aus N, N(R₁₄ₐ), O, S, C(R₁₄ₐ) und C(R₁₄ₐ)(R_{14b}), X₁₅ ausgewählt ist aus N, N(R₁₅ₐ), O, S, C(R₁₅ₐ) und C(R₁₅ₐ)(R_{15b}), X₁₆ ausgewählt ist aus N, N(R₁₆ₐ), O, S, C(R₁₆ₐ) und C(R₁₆ₐ)(R_{16b}), X₁₇ ausgewählt ist aus N, N(R₁₇ₐ), O, S, C(R₁₇ₐ) und C(R₁₇ₐ)(R_{17b}), X₁₈ ausgewählt ist aus N, N(R₁₈ₐ), O, S, C(R₁₈ₐ) und C(R₁₈ₐ)(R_{18b}), und X₁₉ ausgewählt ist aus N, N(R₁₉ₐ), O, S, C(R₁₉ₐ) und C(R₁₉ₐ)(R_{19b}), und
R₁₂ₐ, R_{12b}, R₁₃ₐ, R_{13b}, R₁₄ₐ, R_{14b}, R₁₅ₐ, R_{15b}, R₁₆ₐ, R_{16b}, R₁₇ₐ, R_{17b}, R₁₈ₐ, R_{18b}, R₁₉ₐ und R_{19b} jeweils unabhängig definiert die gleichen wie R₁ in Formel 1A sind.

13. Organometallische Verbindung nach Anspruch 1, wobei
die organometallische Verbindung dargestellt durch Formel 1 ausgewählt ist aus den Verbindungen 1 bis 16:

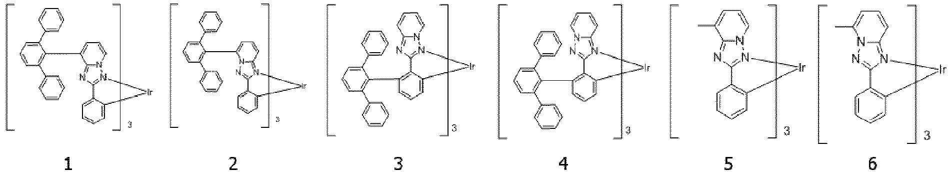

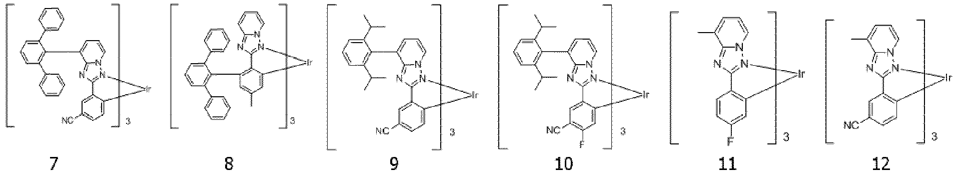

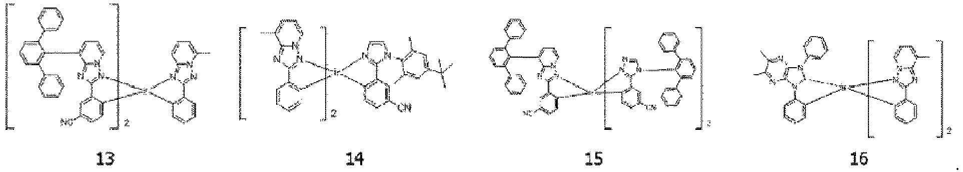

14. Organometallische Verbindung nach einem der Ansprüche 1-13, wobei
die organometallische Verbindung Blaulicht emittiert, das eine maximale Emissionswellenlänge von 400 nm bis 520 nm aufweist.

15. Organische lichtemittierende Vorrichtung, umfassend:
eine erste Elektrode,
eine zweite Elektrode, und
eine organische Schicht zwischen der ersten Elektrode und der zweiten Elektrode und eine Emissionsschicht umfassend,
wobei die organische Schicht die organometallische Verbindung nach einem der Ansprüche 1-14 umfasst;
wobei bevorzugt
die Emissionsschicht die organometallische Verbindung umfasst;
wobei bevorzugt
die Emissionsschicht ferner einen Wirt umfasst, und eine Menge des Wirts größer als eine Menge der organometallischen Verbindung ist.

## Revendications

1. Composé organométallique représenté par la Formule 1 :
<Formule 1> M₁₁(L₁₁)ₙ₁₁(L₁₂)ₙ₁₂,
où, dans la Formule 1,
M₁₁ est un métal de transition,
L₁₁ est sélectionné dans un groupe représenté par la Formule 1A,
n11 est sélectionné entre 1,2, 3 et 4, où, quand n11 est 2 ou plus, 2 L₁₁(s) ou plus sont identiques ou différents entre eux,
L₁₂ est sélectionné entre un ligand à une coordonnée, un ligand à deux coordonnées et un ligand à trois coordonnées,
n12 est sélectionné entre 0, 1, 2, 3 et 4, où, quand n12 est 2 ou plus, 2 L₁₂(s) ou plus sont identiques ou différents entre eux,
L₁₁ et L₁₂ sont différents l'un de l'autre 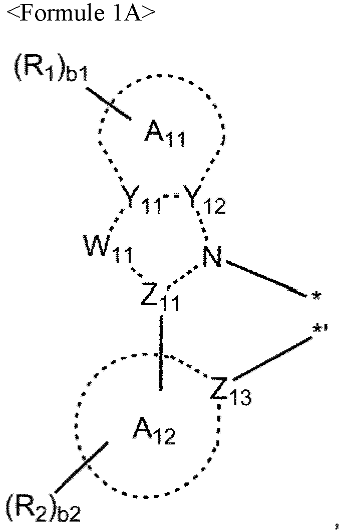
où, dans la Formule 1A,
A₁₁ est un groupe hétérocyclique C₁-C₃₀, A₁₂ est un groupe carbocyclique C₅-C₃₀ ou un groupe hétérocyclique C₁- C₃₀,
W₁₁ est sélectionné entre N et N(R₁₁),
Y₁₁ et Y₁₂ sont chacun indépendamment sélectionnés entre N et C, où au moins un élément sélectionné entre Y₁₁ et Y₁₂ est N,
Z₁₁ et Z₁₃ sont chacun C,
R₁, R₂, et R₁₁ sont chacun indépendamment sélectionnés entre : hydrogène, deutérium, - F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₆₀ substitué ou non substitué, un groupe alkényle C₂-C₆₀ substitué ou non substitué, un groupe alkynyle C₂-C₆₀ substitué ou non substitué, un groupe alkoxy C₁-C₆₀ substitué ou non substitué, un groupe cycloalkyle C₃-C₁₀ substitué ou non substitué, un groupe hétérocycloalkyle C₁-C₁₀ substitué ou non substitué, un groupe cycloalkényle C₃-C₁₀ substitué ou non substitué, un groupe hétérocycloalkényle C₁-C₁₀ substitué ou non substitué, un groupe aryle C₆-C₆₀ substitué ou non substitué, un groupe aryloxy C₆-C₆₀ substitué ou non substitué, un groupe arylthio C₆-C₆₀ substitué ou non substitué, un groupe hétéroaryle C₁-C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -B(Q₆)(Q₇), et - P(=O)(Q₈)(Q₉),
deux éléments ou plus sélectionnés entre R₁, R₂ et R₁₁ sont optionnellement liés entre eux pour former un anneau,
deux, trois ou quatre éléments sélectionnés dans une pluralité de R₁, R₂, et R₁₁ voisins sont optionnellement liés entre eux pour former un ligand à quatre coordonnées, un ligand à six coordonnées ou un ligand à huit coordonnées,
Q₁ à Q₉ sont chacun indépendamment sélectionnés entre : hydrogène, deutérium, -F, -Cl, - Br, -I, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₆₀, un groupe alkyle C₁-C₆₀ substitué avec au moins un élément sélectionné entre : deutérium, un groupe alkyle C₁-C₆₀, et un groupe aryle C₆-C₆₀, un groupe alkényle C₂-C₆₀, un groupe alkynyle C₂-C₆₀, un groupe alkoxy C₁-C₆₀, un groupe cycloalkyle C₃-C₁₀, un groupe hétérocycloalkyle C₁-C₁₀, un groupe cycloalkényle C₃-C₁₀, un groupe hétérocycloalkényle C₁-C₁₀, un groupe aryle C₆-C₆₀, un groupe aryle C₆-C₆₀ substitué avec au moins un élément sélectionné entre : deutérium, un groupe alkyle C₁-C₆₀ et un groupe aryle C₆-C₆₀, un groupe aryloxy C₆-C₆₀, un groupe arylthio C₆-C₆₀, un groupe hétéroaryle C₁-C₆₀, un groupe polycyclique condensé non aromatique monovalent, et un groupe hétéropolycyclique condensé non aromatique monovalent, et
le composé suivant est exclu du composé organométallique représenté par la Formule 1 :

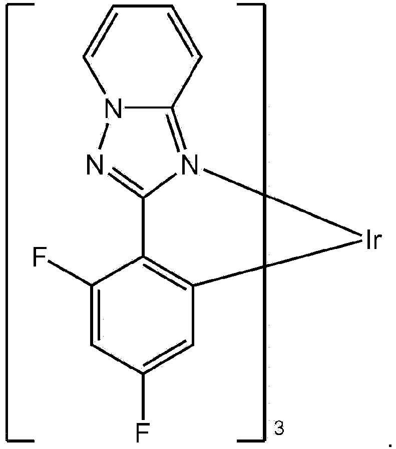

2. Composé organométallique selon la revendication 1, dans lequel
M₁₁ est sélectionné entre : platine (Pt), palladium (Pd), cuivre (Cu), argent (Ag), or (Au), rhodium (Rh), iridium (Ir), ruthénium (Ru), osmium (Os), titane (Ti), zirconium (Zr), hafnium (Hf), europium (Eu), terbium (Tb) et thulium (Tm) ;
de préférence dans lequel
M₁₁ est sélectionné entre Ir, Os et Pt.

3. Composé organométallique selon les revendications 1 ou 2, où
un groupement représenté par 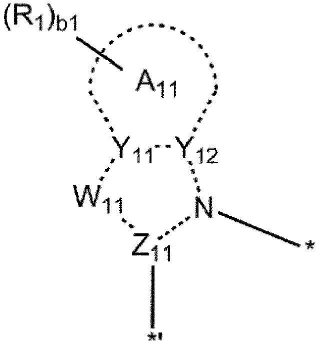 est représenté par la Formule 1A-1, et un groupement représenté par 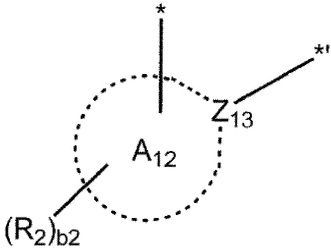 est représenté par la Formule 1A-2 : 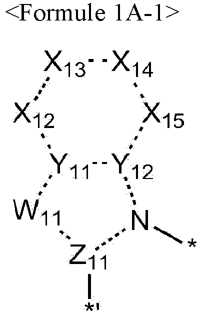 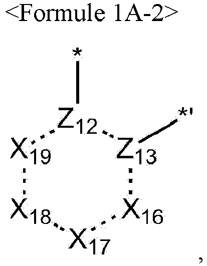 où, dans les Formules 1A-1 et 1A-2,
Y₁₁, Y₁₂, W₁₁, Z₁₁ et Z₁₃ sont chacun indépendamment identiques à la description de la Formule 1A ;
X₁₂ est sélectionné entre N, N(R₁₂ₐ), O, S, C(R₁₂ₐ) et C(R₁₂ₐ)(R_{12b}), X₁₃ est sélectionné entre N, N(R₁₃ₐ), O, S, C(R₁₃ₐ) et C(R₁₃ₐ)(R_{13b}), X₁₄ est sélectionné entre N, N(R₁₄ₐ), O, S, C(R₁₄ₐ) et C(R₁₄ₐ)(R_{14b}), X₁₅ est sélectionné entre N, N(R₁₅ₐ), O, S, C(R₁₅ₐ) et C(R₁₅ₐ)(R_{15b}), X₁₆ est sélectionné entre N, N(R₁₆ₐ), O, S, C(R₁₆ₐ) et C(R₁₆ₐ)(R_{16b}), X₁₇ est sélectionné entre N, N(R₁₇ₐ), O, S, C(R₁₇ₐ) et C(R₁₇ₐ)(R_{17b}), X₁₈ est sélectionné entre N, N(R₁₈ₐ), O, S, C(R₁₈ₐ) et C(R₁₈ₐ)(R_{18b}), et X₁₉ est sélectionné entre N, N(R₁₉ₐ), O, S, C(R₁₉ₐ) et C(R₁₉ₐ)(R_{19b}),
R₁₂ₐ, R_{12b}, R₁₃ₐ, R_{13b}, R₁₄ₐ, R_{14b}, R₁₅ₐ, R_{15b}, R₁₆ₐ, R_{16b}, R₁₇ₐ, R_{17b}, R₁₈ₐ, R_{18b}, R₁₉ₐ, et R_{19b} sont chacun indépendamment définis comme R₁ dans la Formule 1A ;
dans les Formules 1A-1, * indique un site de liaison à M₁₁ de la Formule 1, et *' indique un site de liaison à un atome voisin, et
dans les Formules 1A-2, *' indique un site de liaison à M₁₁ de la Formule 1, et * indique un site de liaison à un atome voisin.

4. Composé organométallique selon la revendication 3, dans lequel
i) X₁₂ est sélectionné entre N et C(R₁₂ₐ), X₁₃ est sélectionné entre N et C(R₁₃ₐ), X₁₄ est sélectionné entre N et C(R₁₄ₐ), X₁₅ est sélectionné entre N et C(R₁₅ₐ), X₁₆ est sélectionné entre N et C(R₁₆ₐ), X₁₇ est sélectionné entre N et C(R₁₇ₐ), X₁₈ est sélectionné entre N et C(R₁₈ₐ), et X₁₉ est sélectionné entre N et C(R₁₉ₐ) ; et
ii) X₁₆ est N, X₁₇ est C(R₁₇ₐ), X₁₈ est C(R₁₈ₐ) et X₁₉ est C(R₁₉ₐ) ; X₁₆ est C(R₁₆ₐ), X₁₇ est N, X₁₈ est C(R₁₈ₐ) et X₁₉ est C(R₁₉ₐ) ; X₁₆ est C(R₁₆ₐ), X₁₇ est C(R₁₇ₐ), X₁₈ est N et X₁₉ est C(R₁₉ₐ) ; X₁₆ est C(R₁₆ₐ), X₁₇ est C(R₁₇ₐ), X₁₈ est C(R₁₈ₐ) et X₁₉ est N ; ou X₁₆ est C(R₁₆ₐ), X₁₇ est C(R₁₇ₐ), X₁₈ est C(R₁₈ₐ), et X₁₉ est C(R₁₉ₐ).

5. Composé organométallique selon l'une quelconque des revendications 1-4, dans lequel
Y₁₁ est N, et Y₁₂ est C ;
Y₁₁ est C, et Y₁₂ est N ; ou
Y₁₁ est N, et Y₁₂ est N.

6. Composé organométallique selon l'une quelconque des revendications 1-5, dans lequel
un groupement représenté par 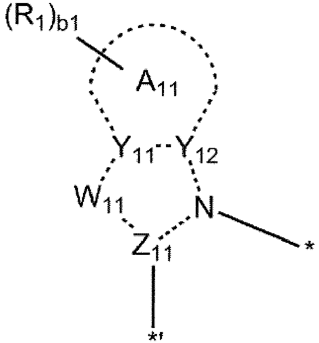 est représenté par une formule sélectionnée entre les Formules 2-1 à 2-15 : 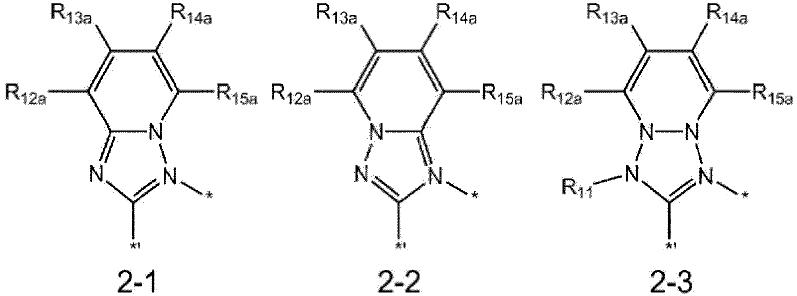 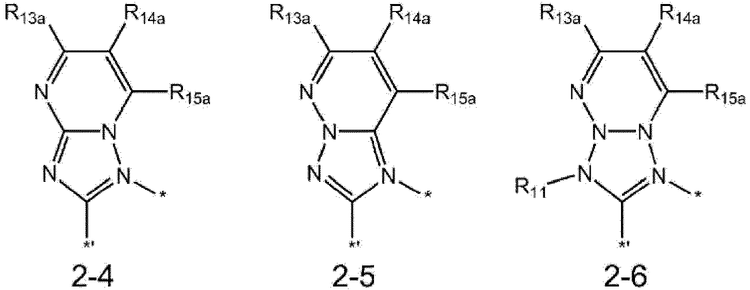 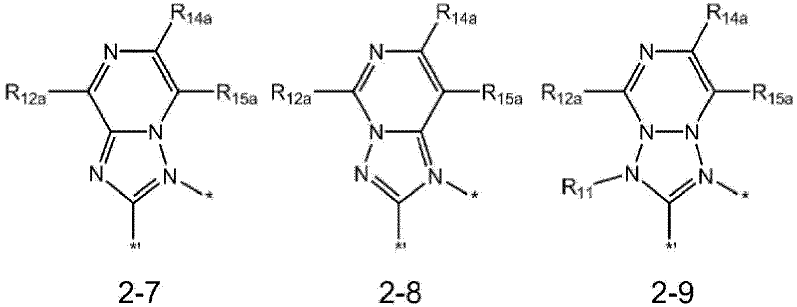 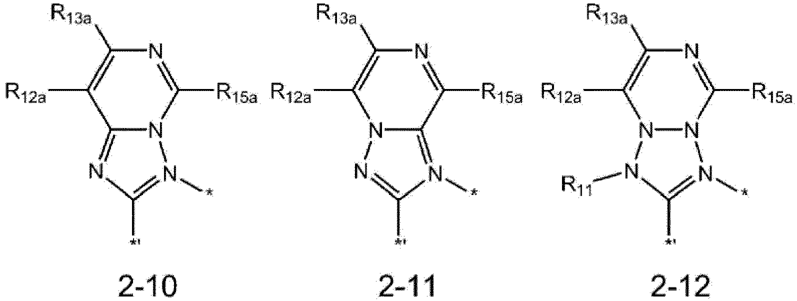 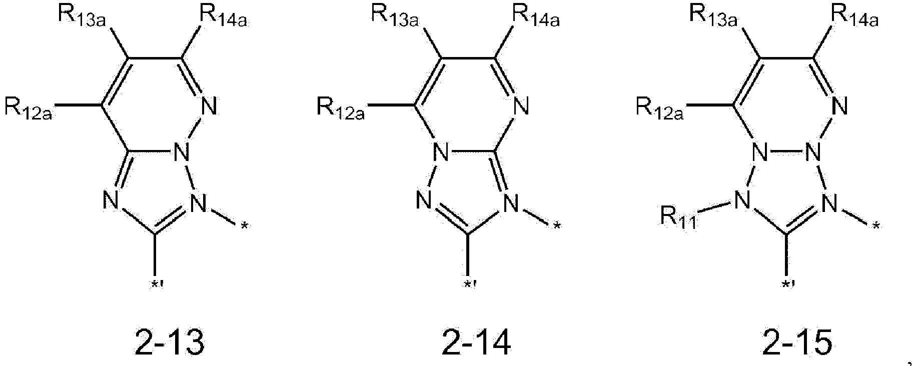 où, dans les Formules 2-1 à 2-15,
R₁₁ est identique à la description de la Formule 1A,
R₁₂ₐ, R₁₃ₐ, R₁₄ₐ, et R₁₅ₐ sont chacun indépendamment définis comme R₁ dans la Formule 1A ; et
* et *' indiquent chacun un site de liaison à un atome voisin ; et/ou
où
un groupement représenté par 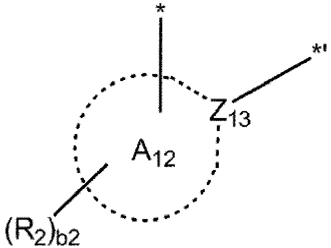 est représenté par une formule sélectionnée entre les Formules 3-1 à 3-8 : 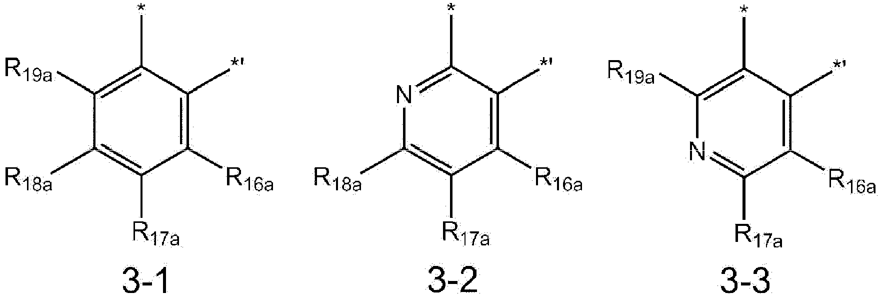 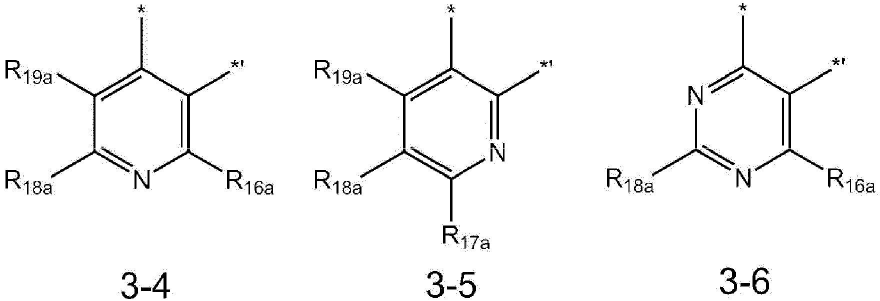 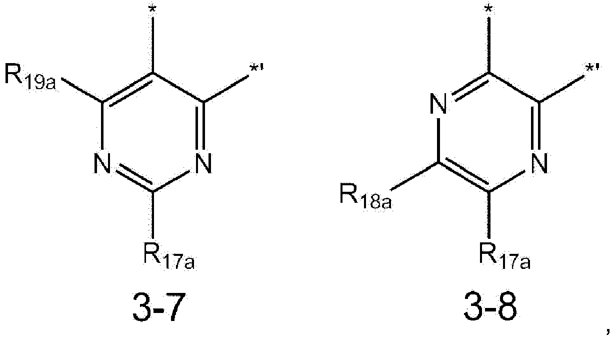
où, dans les Formules 3-1 à 3-8,
R₁₆ₐ, R₁₇ₐ, R₁₈ₐ, et R₁₉ₐ sont chacun indépendamment définis comme R₂ dans la Formule 1A ; et
* et *' indiquent chacun un site de liaison à un atome voisin.

7. Composé organométallique selon l'une quelconque des revendications 1-6, où
R₁, R₂, et R₁₁ sont chacun indépendamment sélectionnés entre :
hydrogène, deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, -SF₅, un groupe alkyle C₁-C₂₀, et un groupe alkoxy C₁-C₂₀ ;
un groupe alkyle C₁-C₂₀ et un groupe alkoxy C₁-C₂₀, chacun substitué avec au moins un élément sélectionné entre : deutérium, -F, -Cl, -Br, -I, -CD₃, -CD₂H, -CDH₂, -CF₃, -CF₂H, - CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₁₀, un groupe cyclopentyle, un groupe cyclopentyle substitué avec : deutérium, un groupe cyclohexyle, un groupe cyclohexyle substitué avec : deutérium, un groupe cycloheptyle, un groupe cycloheptyle substitué avec : deutérium, un groupe cyclooctyle, un groupe cyclooctyle substitué avec : deutérium, un groupe bicyclo[2.2.1]heptanyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle et un groupe pyrimidinyle ;
un groupe cyclopentyle, un groupe cyclohexyle, un groupe cycloheptyle, un groupe cyclooctyle, un groupe bicyclo[2.2.1]heptanyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, et un groupe imidazopyrimidinyle ;
un groupe cyclopentyle, un groupe cyclohexyle, un groupe cycloheptyle, un groupe cyclooctyle, un groupe bicyclo[2.2.1]heptanyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle et un groupe imidazopyrimidinyle, chacun substitué avec au moins un élément sélectionné entre : deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₂₀, un groupe alkoxy C₁-C₂₀, un groupe cyclopentyle, un groupe cyclopentyle substitué avec : deutérium, un groupe cyclohexyle, un groupe cyclohexyle substitué avec : deutérium, un groupe cycloheptyle, un groupe cycloheptyle substitué avec : deutérium, un groupe cyclooctyle, un groupe cyclooctyle substitué avec : deutérium, un groupe bicyclo[2.2.1]heptanyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, un groupe imidazopyrimidinyle et -Si(Q₃₃)(Q₃₄)(Q₃₅) ; et
-N(Q₁)(Q₂), -Si(Q₃)(Q₄)(Q₅), -B(Q₆)(Q₇), et -P(=O)(Q₈)(Q₉), et
Q₁ à Q₉ et Q₃₃ à Q₃₅ sont chacun indépendamment sélectionnés entre :
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle, chacun substitué avec au moins un élément sélectionné entre deutérium, un groupe alkyle C₁-C₁₀ et un groupe phényle.

8. Composé organométallique selon l'une quelconque des revendications 1-7, dans lequel
R₁, R₂, et R₁₁ sont chacun indépendamment sélectionnés entre :
hydrogène, deutérium, -F, un groupe cyano, un groupe nitro, -SF₅, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tert-nonyle, un groupe n-décyle, un groupe isodécyle, un groupe sec-décyle, un groupe tert-décyle, un groupe méthoxy, un groupe éthoxy, un groupe propoxy, un groupe butoxy, un groupe pentoxy, un groupe cyclopentyle, un groupe cyclohexyle, un groupe cycloheptyle, un groupe cyclooctyle, un groupe bicyclo[2.2.1]heptanyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle, un groupe pyrimidinyle, un groupe fluorényle, un groupe carbazolyle, un groupe dibenzofuranyle, un groupe dibenzothiophényle et un groupe dibenzosilolyle ;
un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tert-nonyle, un groupe n-décyle, un groupe isodécyle, un groupe sec-décyle, un groupe tert-décyle, un groupe méthoxy, un groupe éthoxy, un groupe propoxy, un groupe butoxy, un groupe pentoxy, un groupe cyclopentyle, un groupe cyclohexyle, un groupe cycloheptyle, un groupe cyclooctyle, un groupe bicyclo[2.2.1]heptanyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle, un groupe pyrimidinyle, un groupe fluorényle, un groupe carbazolyle, un groupe dibenzofuranyle, un groupe dibenzothiophényle, et un groupe dibenzosilolyle, chacun substitué avec au moins un élément sélectionné entre : deutérium, -F, -CD₃, -CD₂H, -CDH₂, -CF₃, -CF₂H, -CFH₂, un groupe cyano, un groupe nitro, un groupe alkyle C₁-C₁₀, un groupe alkoxy C₁-C₁₀, un groupe cyclopentyle, un groupe cyclopentyle substitué avec : deutérium, un groupe cyclohexyle, un groupe cyclohexyle substitué avec : deutérium, un groupe cycloheptyle, un groupe cycloheptyle substitué avec : deutérium, un groupe cyclooctyle, un groupe cyclooctyle substitué avec: deutérium, un groupe bicyclo[2.2.1]heptanyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle, un groupe pyrimidinyle, un groupe fluorényle, un groupe carbazolyle, un groupe dibenzofuranyle, un groupe dibenzothiophényle, un groupe dibenzosilolyle et - Si(Q₃₃)(Q₃₄)(Q₃₅); et
-N(Q₁)(Q₂), -Si(Q₃)(Q₄)(Q₅), -B(Q₆)(Q₇), et -P(=O)(Q₈)(Q₉), et
Q₁ à Q₉ et Q₃₃ à Q₃₅ sont chacun indépendamment sélectionnés entre :
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle et un groupe naphthyle, chacun substitué avec au moins un élément sélectionné entre : deutérium, un groupe alkyle C₁-C₁₀ et un groupe phényle.

9. Composé organométallique selon l'une quelconque des revendications 1-8, dans lequel
au moins un élément sélectionné entre R₁, R₂, et R₁₁ est sélectionné entre : deutérium, un groupe alkyle C₁-C₆₀ substitué ou non substitué, un groupe alkényle C₂-C₆₀ substitué ou non substitué, un groupe alkynyle C₂-C₆₀ substitué ou non substitué, un groupe alkoxy C₁-C₆₀ substitué ou non substitué, un groupe cycloalkyle C₃-C₁₀ substitué ou non substitué, un groupe hétérocycloalkyle C₁-C₁₀ substitué ou non substitué, un groupe cycloalkényle C₃-C₁₀ substitué ou non substitué, un groupe hétérocycloalkényle C₁-C₁₀ substitué ou non substitué, un groupe aryle C₆-C₆₀ substitué ou non substitué, un groupe aryloxy C₆-C₆₀ substitué ou non substitué, un groupe arylthio C₆-C₆₀ substitué ou non substitué, un groupe hétéroaryle C₁-C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -B(Q₆)(Q₇) et -P(=O)(Q₈)(Q₉).

10. Composé organométallique selon l'une quelconque des revendications 1-9, dans lequel
n11 est sélectionné entre 1, 2 et 3, et n12 est sélectionné entre 0, 1 et 2 ;
de préférence dans lequel
M₁₁ est Ir, n11 est sélectionné entre 2 et 3, et n12 est sélectionné entre 0, 1 et 2.

11. Composé organométallique selon l'une quelconque des revendications 1-10, dans lequel
L₁₂ est représenté par une formule sélectionnée entre les Formules 7-1 à 7-11 : 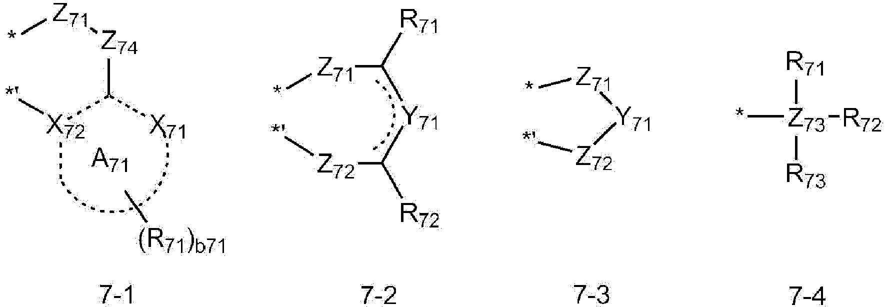 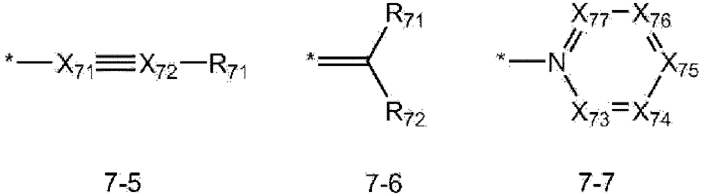 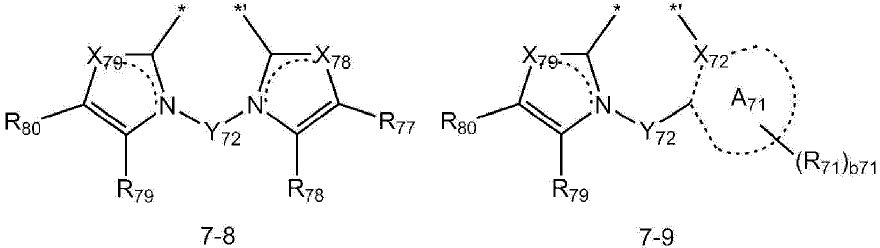 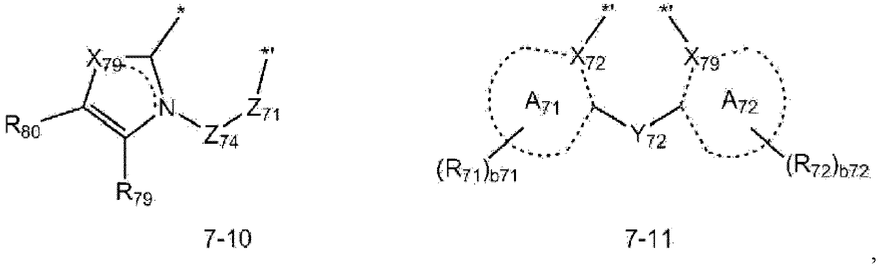 où, dans les Formules 7-1 à 7-11,
A₇₁ et A₇₂ sont chacun indépendamment sélectionnés entre un groupe carbocyclique C₅-C₂₀ et un groupe hétérocyclique C₁-C₂₀,
X₇₁ et X₇₂ sont chacun indépendamment sélectionnés entre C et N,
X₇₃ est N ou C(Q₇₃) ; X₇₄ est N ou C(Q₇₄) ; X₇₅ est N ou C(Q₇₅) ; X₇₆ est N ou C(Q₇₆) ; et X₇₇ est N ou C(Q₇₇),
X₇₈ est O, S ou N(Q₇₈) ; et X₇₉ est O, S ou N(Q₇₉),
Y₇₁ et Y₇₂ sont chacun indépendamment sélectionnés entre une liaison simple, une liaison double, un groupe alkylène C₁-C₅ substitué ou non substitué, un groupe alkénylène C₂-C₅ substitué ou non substitué, et un groupe arylène C₆-C₁₀ substitué ou non substitué,
Z₇₁ et Z₇₂ sont chacun indépendamment sélectionnés entre N, O, N(R₇₅), P(R₇₅)(R₇₆) et As(R₇₅)(R₇₆),
Z₇₃ est sélectionné entre P et As,
Z₇₄ est sélectionné entre CO et CH₂,
R₇₁ à R₈₀ et Q₇₃ à Q₇₉ sont chacun indépendamment sélectionnés entre : hydrogène, deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₆₀ substitué ou non substitué, un groupe alkényle C₂-C₆₀ substitué ou non substitué, un groupe alkynyle C₂-C₆₀ substitué ou non substitué, un groupe alkoxy C₁-C₆₀ substitué ou non substitué, un groupe cycloalkyle C₃-C₁₀ substitué ou non substitué, un groupe hétérocycloalkyle C₁-C₁₀ substitué ou non substitué, un groupe cycloalkényle C₃-C₁₀ substitué ou non substitué, un groupe hétérocycloalkényle C₁-C₁₀ substitué ou non substitué, un groupe aryle C₆-C₆₀ substitué ou non substitué, un groupe aryloxy C₆-C₆₀ substitué ou non substitué, un groupe arylthio C₆-C₆₀ substitué ou non substitué, un groupe hétéroaryle C₁-C₆₀ substitué ou non substitué, un groupe polycyclique condensé non aromatique monovalent substitué ou non substitué, et un groupe hétéropolycyclique condensé non aromatique monovalent substitué ou non substitué ; R₇₁ et R₇₂ sont optionnellement liés l'un à l'autre pour former un anneau ; R₇₇ et R₇₈ sont optionnellement liés l'un à l'autre pour former un anneau ; R₇₈ et R₇₉ sont optionnellement liés l'un à l'autre pour former un anneau ; et R₇₉ et R₈₀ sont optionnellement liés l'un à l'autre pour former un anneau,
b71 et b72 sont chacun indépendamment sélectionnés entre 1,2 et 3, et
* et *' indiquent chacun un site de liaison à un atome voisin.

12. Composé organométallique selon l'une quelconque des revendications 1-11, où
le composé organométallique représenté par la Formule 1 est représenté par une formule sélectionnée entre les Formules 1-1 et 1-2 : 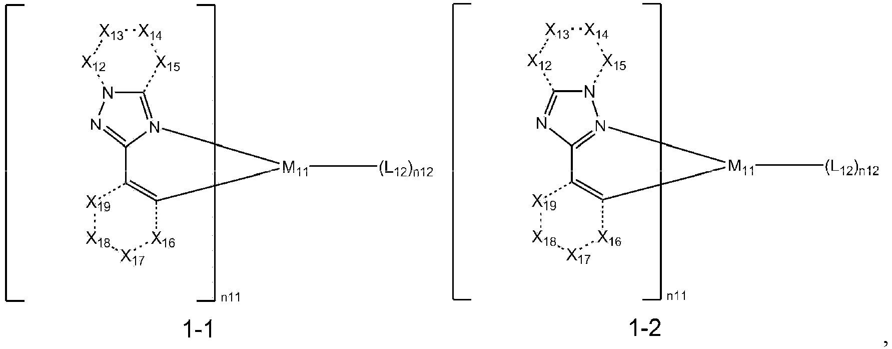 où, dans les Formules 1-1 et 1-2,
M₁₁, n11, n12, et L₁₂ sont chacun indépendamment identiques à la description de la Formule 1,
X₁₂ est sélectionné entre N, N(R₁₂ₐ), O, S, C(R₁₂ₐ) et C(R₁₂ₐ)(R_{12b}), X₁₃ est sélectionné entre N, N(R₁₃ₐ), O, S, C(R₁₃ₐ) et C(R₁₃ₐ)(R_{13b}), X₁₄ est sélectionné entre N, N(R₁₄ₐ), O, S, C(R₁₄ₐ) et C(R₁₄ₐ)(R_{14b}), X₁₅ est sélectionné entre N, N(R₁₅ₐ), O, S, C(R₁₅ₐ) et C(R₁₅ₐ)(R_{15b}), X₁₆ est sélectionné entre N, N(R₁₆ₐ), O, S, C(R₁₆ₐ) et C(R₁₆ₐ)(R_{16b}), X₁₇ est sélectionné entre N, N(R₁₇ₐ), O, S, C(R₁₇ₐ) et C(R₁₇ₐ)(R_{17b}), X₁₈ est sélectionné entre N, N(R₁₈ₐ), O, S, C(R₁₈ₐ) et C(R₁₈ₐ)(R_{18b}), et X₁₉ est sélectionné entre N, N(R₁₉ₐ), O, S, C(R₁₉ₐ) et C(R₁₉ₐ)(R_{19b}), et
R₁₂ₐ, R_{12b}, R₁₃ₐ, R_{13b}, R₁₄ₐ, R_{14b}, R₁₅ₐ, R_{15b}, R₁₆ₐ, R_{16b}, R₁₇ₐ, R_{17b}, R₁₈ₐ, R_{18b}, R₁₉ₐ, et R_{19b} sont chacun indépendamment définis comme Ri dans la Formule 1A.

13. Composé organométallique selon la revendication 1, où
le composé organométallique représenté par la Formule 1 est sélectionné entre les Composés 1 à 16 :

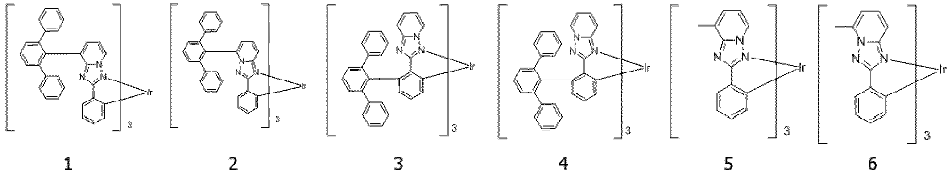

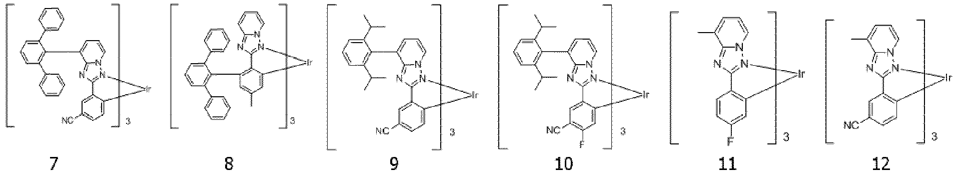

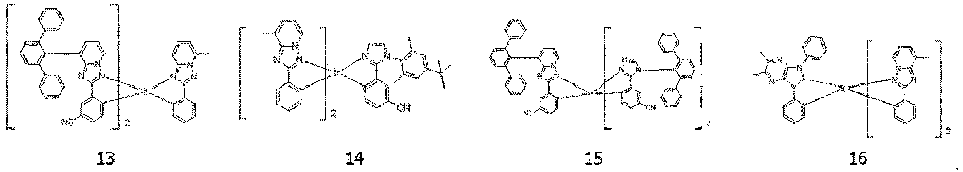

14. Composé organométallique selon l'une quelconque des revendications 1-13, où
le composé organométallique émet une lumière bleue ayant une longueur d'onde d'émission maximale de 400 nm à 520 nm.

15. Dispositif photoémetteur organique comprenant :
une première électrode,
une deuxième électrode, et
une couche organique entre la première électrode et la deuxième électrode et comprenant une couche d'émission,
dans lequel la couche organique comprend le composé organométallique selon l'une quelconque des revendications 1-14 ;
de préférence dans lequel
la couche d'émission comprend le composé organométallique ;
de préférence dans lequel
la couche d'émission comprend en outre un hôte, et une quantité de l'hôte est plus grande qu'une quantité du composé organométallique.
